(19) Europäisches Patentamt
European Patent Office
Office européen des brevets

(11) EP 1 667 493 B1

(12) **EUROPEAN PATENT SPECIFICATION**

(45) Date of publication and mention of the grant of the patent:
**15.10.2014 Bulletin 2014/42**

(21) Application number: **05251107.8**

(22) Date of filing: **24.02.2005**

(51) Int Cl.:
*H05B 33/14* (2006.01) *C09K 11/06* (2006.01)
*C07F 15/00* (2006.01) *H01L 51/00* (2006.01)
*H01L 51/50* (2006.01) *H01L 27/32* (2006.01)

(54) **Organometallic complex, light-emitting solid, organic electroluminescent element and organic electroluminescent display**

Organometallkomplex, leuchtendes Material, organisches EL Element und organische EL Anzeigevorrichtung

Complexe organométallique, solide lumineux, élément EL organique et écran EL organique

(84) Designated Contracting States:
**AT BE BG CH CY CZ DE DK EE ES FI FR GB GR HU IE IS IT LI LT LU MC NL PL PT RO SE SI SK TR**

(30) Priority: **04.11.2004 JP 2004321295**

(43) Date of publication of application:
**07.06.2006 Bulletin 2006/23**

(73) Proprietor: **UDC Ireland Limited**
**Dublin 4 (IE)**

(72) Inventors:
- **Sotoyama, Wataru,**
  **c/o Fujitsu Limited**
  **Kawasaki-shi, Kanagawa 211-8588 (JP)**
- **Satoh, Tasuku,**
  **c/o Fujitsu Limited**
  **Kawasaki-shi, Kanagawa 211-8588 (JP)**
- **Sawatari, Norio,**
  **c/o Fujitsu Limited**
  **Kawasaki-shi, Kanagawa 211-8588 (JP)**

(74) Representative: **Maiwald Patentanwalts GmbH**
**Elisenhof**
**Elisenstrasse 3**
**80335 München (DE)**

(56) References cited:
**WO-A-2005/105746 US-A1- 2002 179 885**

- **SOTOYAMA W ET AL: "Efficient organic light-emitting diodes with phosphorescent platinum complexes containing N^C^N-coordinating tridentate ligand" APPLIED PHYSICS LETTERS, vol. 86, no. 15, 6 April 2005 (2005-04-06), pages 153505-153505, XP012065061 ISSN: 0003-6951**
- **NAGANAGOWDA G A ET AL: "Unidentate coordination of 2,2'-bipyridine and 1,10-phenanthroline in a cyclometallated rhodium(III) complex. Evidence from 1H and 13C NMR spectra" MAGNETIC RESONANCE IN CHEMISTRY, vol. 38, no. 4, 2000, pages 223-228, XP009064258 ISSN: 0749-1581**
- **GAYATHRI V ET AL: "Cyclometallation of bis-benzimidazole derivatives with rhodium(III) halides" POLYHEDRON, vol. 18, no. 18, 1999, pages 2351-2360, XP009064263 ISSN: 0277-5387**
- **ALSTERS P L ET AL: "Palladium and platinum diphenoxide and aryl phenoxide complexes with amine donors: effect of hydrogen bonding on structure and properties" ORGANOMETALLICS, vol. 11, no. 12, 1992, pages 4124-4135, XP009064260 ISSN: 0276-7333**
- **WILLIAMS J A G ET AL: "An Alternative Route to Highly Luminescent Platinum(II) Complexes: Cyclometalation with N^C^N-Coordinating Dipyridylbenzene Ligands" INORGANIC CHEMISTRY COMMUNICATIONS, vol. 42, no. 26, 2003, pages 8609-8611, XP002980828 ISSN: 1387-7003**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 667 493 B1

## Description

BACKGROUND OF THE INVENTION

Field of the Invention

This application shows phosphorescence light emission and relates to an organic electroluminescent (EL) element that utilizes the organometallic complex or light-emitting solid suitable as light-emitting materials, color-transformation materials, and the like, in organic EL elements and illuminators, and the like, and to an organic EL display that utilizes the organic EL element.

Description of the Related Art

An organic EL element comprises one or several layers of thin organic layer between a positive electrode and a negative electrode, and when a positive hole from the positive electrode and an electron from the negative electrode are injected respectively to the aforementioned organic layer, the recombination energy during the recombination of the positive hole and the negative hole in the aforementioned organic layer excites the luminescent center of the light-emitting material in the organic layer, and when this light-emitting material deactivates from the excited state to the ground state, the emitted light is utilized by this light-emitting element. This organic EL element has properties such as spontaneous light emission, high-speed response, and the like, and good visibility, extra-thin model, light, high-speed responsibility and good picture display properties, thus they are expected to be applied to flat panel displays of full-color displays and the like, especially since a two-layer (laminated) organic EL element with laminated positive hole transporting properties organic thin film (positive hole transporting layer) and electron transporting properties organic thin film (electron transporting layer) has been reported (C. W. Tang and S. A. VanSlyke, Applied Physics Letters vol.51, p. 913 (1987)), this organic EL element has recently been attracting attention as a large area light-emitting element which can emit light at a low voltage of 10V or less.

From the point of view to upgrade the light-emitting efficiency in the aforementioned organic EL element, a small amount of a pigment molecule with high fluorescence light-emitting properties is doped as a guest material into a fluorescence light-emitting host material which is the main component, and the light-emitting layer showing high light-emitting efficiency is formed, as proposed in (C. W. Tang, S. A. VanSlyke, and C. H. Chen, Journal of Applied Physics vol.65, p. 3610 (1989)).

In recent years, replacing the aforementioned fluorescent materials as light-emitting materials of organic EL elements are phosphorescent materials utilizing emission from the lowest excited triplet state of a molecule and due to this, the light-emitting efficiency of the aforementioned organic EL elements is shown to be able to be upgraded, and this has been attracting attention (M. A. Baldo, et al., Nature vol.395, p. 151 (1998), M. A. Baldo, et al., Applied Physics Letters vol.75, p. 4 (1999)). Light emission from organic materials is classified to fluorescence and phosphorescence by the property of the excited state that causes the emission. Until now, as common organic materials do not emit phosphorescence at room temperature, fluorescent materials have been utilized in organic EL elements. From EL emission mechanism, phosphorescence state is expected to be generated four times the probability of fluorescence state, and because of this, the application of heavy metal complex that causes phosphorescence light at room temperature in light-emitting materials as a way to upgrade the efficiency of EL elements has recently been attracting attention. However, in the case of phosphorescent materials, there are problems such as the materials that emit strong phosphorescence at room temperature are very few and the selection range for these materials is narrow.

A known example of an organic EL element utilizing an organometallic complex that emits phosphorescence at room temperature is a metal complex comprises a terdentate ligand having two coordinate bonds by a platinum element and two nitrogen atoms, and a direct coupling by a platinum element and a carbon atom and a coordinated N^ N^ C model by the two adjoining nitrogen atoms from the aforementioned coordinate bond (Japanese Patent Application Laid-Open (JP-A) No.2002-363552).

However, the phosphorescence efficiency (the quantum yield of photoluminescence) of this metal complex at room temperature is not sufficient, and in the case of the organic EL element that utilizes this metal complex, there is a problem that the phosphorescence efficiency is low. On the other hand, it is reported (J. A. G. Williams et al., Inorganic Chemistry Vol. 42, p. 8609 (2003)) that the platinum complex comprises a platinum atom, a terdentate ligand having two nitrogen atoms and a carbon atom that form an N^ $C^-$ N coordination mode by the carbon atom in-between the two nitrogen atoms, and a Cl atom bonded to the platinum, and such platinum complex showed a higher phosphorescence efficiency than the N^ N^ C model platinum complex in solution.

The articles Naganagowda G A et al: "Unidentate coordination of 2,2'-bipyridine and 1,10-phenanthroline in a cyclometallated rhodium (III) complex. Evidence from 1H and 13C NMR spectra", Magnetic Resonance In Chemistry, vol. 38, no. 4, 2000, pages 223-228, Gayathri V et al: "Cyclometallation of bis-benzimidazole derivatives with rhodium

(III) halides" Polyhedron, vol. 18, no. 18, 1999, pages 2351-2360, and Alsters P L et al; "Palladium and platinum diphenoxide and aryl phenoxide complexes with amine donors: effect of hydrogen bonding on structure and properties" Organometallics, vol. 11, no. 12, 1992, pages 4124-4135, disclose organometallic complexes of rhodium, palladium and platinum.

It is therefore an object of the present invention to provide suitable organometallic complex and light-emitting solid as light-emitting materials and color transformation materials, and the like in organic EL elements and illuminators, and the like, that show high phosphorescence efficiency and high durability. The object of the present invention is to provide an organic EL element utilizing the aforementioned organometallic complex or light-emitting solid that has excellent light-emitting efficiency, thermal and electrical stability, and a very long drive lifetime. Also, the object is to provide an organic EL display suitable in full-color displays, and the like, that uses the aforementioned organic EL element, high performance and has excellent color balance without changing the luminescent area, and an average drive current that may be constant and not depending on the luminescent pixel, and a very long drive lifetime.

SUMMARY OF THE INVENTION

To solve the problem, the inventors, after earnest discussion, obtained the knowledge as following. That is, the organometallic complex having a metal atom, and two nitrogen atoms and one carbon atom coordinate bonding to the metal atom, and a terdentate ligand with a coordinated N^ C^ N model by the carbon atom in-between the two nitrogen atoms aforementioned, and a monodentate ligand that contains a ring structure having a substituent group at the position excluding the bonding position that is the furthest from the metal atom or substituted by a halogen atom, shows high phosphorescence efficiency and high durability, excellent sublimation property suitable for organic EL elements, and also able to form excellent neat film and doped film from vacuum vapor deposition, suitable as light-emitting material in organic EL elements, illuminators, and the like, and the light-emitting solid containing the organometallic complex and the organic EL elements and organic EL displays utilizing the organometallic complex have excellent light-emitting efficiency, thermal and electrical stability, a very long drive life-time and high performance. The present invention is based on the inventors' knowledge and the invention that solved the problem that was mentioned earlier is as following.

The organometallic complex of the present invention has a chemical structure in accordance with Claim 1 or Claim 2.

Emission from organic materials is classified by the property of excited state that yields the emission. Until now, as common organic materials do not emit phosphorescence light at room temperature, fluorescence light emission properties materials have been utilized in organic EL elements. However, from EL emission mechanism, phosphorescence emitting state is expected to be generated four times than fluorescence emitting state, and because of this, application of heavy metal complex that causes phosphoresence in light-emitting materials in room temperature as a way to upgrade the efficiency of EL elements has recently been attracting attention. As the present invention from the above mentioned organometallic complex that has phosphorescence efficiency and high durability, internal quantum efficiency of EL elements that utilize fluorescent materials that is maximum 25% whereas in theory, maximum 100% high light-emitting efficiency can be achieved. Therefore, organometallic complex showing high phosphorescence efficiency and high durability is suitable for light-emitting materials in organic EL elements and the like. The present invention organometallic complex can change luminescent color by changing types and numbers of a substituent group and skeleton texture of specific terdentate ligand (N^ C^ N model) or monodentate ligand.

The light-emitting solid of the present invention contains the aforementioned organometallic complex of the present invention. The light-emitting solid of the present invention, containing the organometallic complex of the present invention, has very long drive lifetime and excellent light-emitting efficiency, and the like, and may be suitability utilized in illuminators and displays, and the like.

The organic EL element of the present invention comprises an organic thin film layer interposed between a positive electrode and a negative electrode and this organic thin film layer contains the aforementioned organometallic complex. The organic EL element of the present invention that contains the organometallic complex of the present invention has very long drive lifetime and excellent light-emitting efficiency, and the like, and may be suitability utilized in illuminators and displays and the like.

The organic EL display of the present invention utilizes the aforementioned organic EL element of the present invention. This organic EL display of the present invention, utilizing the organic EL element of the present invention, has very long drive lifetime and excellent light-emitting efficiency, and the like.

BRIEF DESCRIPTION OF THE DRAWINGS

Fig. 1 is a schematic explanatory view describing an example of the layer composition in an organic EL element

according to the present invention.

Fig. 2 is a schematic explanatory view describing an example of an organic EL display comprises color transformation layer.

Fig. 3 is a schematic explanatory view describing an example of an organic EL display comprises color transformation layer.

Fig. 4 is a schematic explanatory view describing an example of an organic EL display comprises color transformation layer.

Fig. 5 is a schematic explanatory view describing an example of the construction of an organic EL display (passive matrix panel) of a passive matrix method.

Fig. 6 is a schematic explanatory view describing an example of the circuit in an organic EL display (passive matrix panel) of the passive matrix method shown in Fig. 5.

Fig. 7 is a schematic explanatory view describing an example of the construction of an organic EL display (active matrix panel) of an active matrix method.

Fig. 8 is a schematic explanatory view describing an example of the circuit in an organic EL display (active matrix panel) of the active matrix method shown in Fig. 7.

Fig. 9 is a schematic view describing the experiment outline to calculate phosphorescence light quantum yield

DESCRIPTION OF THE PREFERRED EMBODIMENTS

(Organometallic complex and light-emitting solid)

The organometallic complex of the present invention comprises a metal atom, and a specific terdentate ligand that is terdentate-bonded towards the metal atom, and a specific monodentate ligand that is monodentate-bonded towards the metal atom.

The light-emitting solid of the present invention comprises the organometallic complex of the present invention and further comprises other components suitability selected according to the purpose. The state of the light-emitting solid has no particular limitation and may be suitability selected according to the purpose, for example, a crystal, a thin film, and the like. The organometallic complex content in the light-emitting solid has no particular limitation and may be suitability selected according to the purpose, generally 0.1 % to 50 % by mass, and preferable to be 0.5 % to 20 % by mass, high efficiency and able to obtain long-lived phosphorescence light.

-Metal atom-

The metal atom acts as the center metal in the aforementioned organometallic complex and is selected from Fe, Co, Ni, Ru, Rh, Pd, Os, Ir, Pt. One atom of these are contained in a molecule of the aforementioned organometallic complex and each metal atom in two or more molecules of the aforementioned organometallic complex, may be alone or two or more than two types. Among the aforementioned metal atoms, Pt is particularly preferable (In this case, the aforementioned organometallic complex is a platinum complex).

-Terdentate ligand-

The aforementioned terdentate ligand is terdentate-bonded towards the metal atom through two nitrogen atoms and a carbon atom, wherein the carbon atom is situated in-between the two nitrogen atoms (N^ C^ N model).

The preferable specific examples of terdentate ligand are shown in the structures in the following Table 1.

Table 1

| N^C^N ligand | dpt (for reference) | dpb | dlqt (for reference) | tp | dpzb |
|---|---|---|---|---|---|
| Structure | 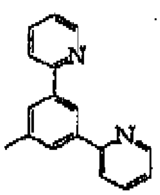 | 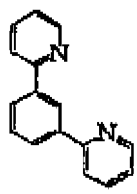 | 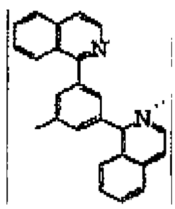 | 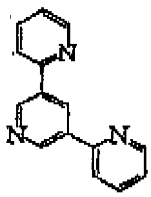 | 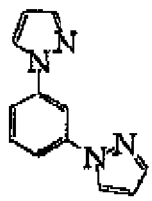 |

In Table 1, for the structure expressed as "dpt", the two pyridine ring structures are the ring structures containing

the first nitrogen and second nitrogen, respectively, and the toluene ring structure situated at the middle of the two pyridine ring structures correspond to the ring structure containing the carbon atom. For the two pyridine ring structures, the carbon atom which adjoins the nitrogen atom in the pyridine ring structure as well as toluene ring structure is the first nitrogen adjoining atom and second nitrogen adjoining atom. For the toluene ring structure, the carbon atom bonding to the atom adjoining to the first nitrogen (carbon atom) in pyridine ring structure, and the carbon atom bonding to the atom adjoining to the second nitrogen (carbon atom) in pyridine ring structure correspond to the atom adjoining the first and second carbon atom, respectively. For the structure shown as "dpt", the three atoms that are the two nitrogen atoms for the two pyridine ring structure and the carbon atom situated in-between the two nitrogen atoms and also this is in-between the atom adjoining to the first carbon atom (carbon atom) and the atom adjoining to the second carbon atom (carbon atom) for the toluene ring structure, are terdentate-bonded to the metal atom.

For the structure shown as "dpb", the two pyridine ring structure are the ring structures containing first nitrogen and second nitrogen, respectively, and the benzene ring structure situated at the middle of the two pyridine ring structures correspond to the ring structure containing carbon atom. For the two pyridine ring structures, the carbon atom which adjoins the nitrogen atom in the pyridine ring structure as well as toluene ring structure is the first nitrogen adjoining atom and second nitrogen adjoining atom. For the benzene ring structure, the carbon atom bonding to the atom adjoining to the first nitrogen (carbon atom) in the pyridine ring structure, and the carbon atom bonding to the atom adjoining to the second nitrogen (carbon atom) in pyridine ring structure correspond to the atom adjoining the first and second carbon atom, respectively. For the structure shown as "dpb", the three atoms that are the two nitrogen atoms for the two pyridine ring structure and the carbon atom situated in-between the two nitrogen atoms and also this is in-between the atom adjoining to the first carbon atom (carbon atom) and the atom adjoining to the second carbon atom (carbon atom) for the toluene ring structure, are terdentate-bonded to the metal atom.

For the structure shown as "diqt", the two isoquinolyl ring structures are the ring structures containing the first nitrogen and second nitrogen, respectively, and the toluene ring structure positioned at the middle of the two isoquinolyl ring structures correspond to the ring structure containing carbon atom. For the two isoquinolyl ring structures, the carbon atom which adjoins the nitrogen atom in the isoquinolyl ring structure as well as toluene ring structure is the first nitrogen adjoining atom and second nitrogen adjoining atom. For the toluene ring structure, the carbon atom bonding to the atom adjoining to the first nitrogen (carbon atom) in isoquinolyl ring structure, and the carbon atom bonding to the atom adjoining to the second nitrogen (carbon atom) in isoquinolyl ring structure correspond to the atom adjoining the first and second carbon atom, respectively. For the structure shown as "diqt", the three atoms that are the two nitrogen atoms for the two isoquinolyl ring structures and the carbon atom situated in-between the two nitrogen atoms and also this is in-between the atom adjoining to the first carbon atom (carbon atom) and the atom adjoining to the second carbon atom (carbon atom) for the toluene ring structure, are terdentate-bonded to the metal atom.

For the structure shown as "tp", the two pyridine ring structures situated at both ends of the three pyridine ring structures are the ring structures containing the first nitrogen and second nitrogen, respectively, and the pyridine ring structure situated at the middle of the two pyridine ring structures correspond to the ring structure containing carbon atom. For the two pyridine ring structures that are situated at both ends, the carbon atom which adjoins the nitrogen atom in the pyridine ring structure as well as the pyridine ring structure and also situated at the center is the first nitrogen adjoining atom and second nitrogen adjoining atom. For the pyridine ring structure that is situated at the center, the carbon atom bonding to the atom adjoining to the first nitrogen (carbon atom), and the carbon atom bonding to the atom adjoining to the second nitrogen (carbon atom) correspond to the atom adjoining the first and second carbon atom, respectively. For the structure shown as "tp", the three atoms that are the two nitrogen atoms for the two pyridine ring structures and the carbon atom positioned in-between the two nitrogen atoms and also this is in-between the atom adjoining to the first carbon atom (carbon atom) and the atom adjoining to the second carbon atom (carbon atom) for the pyridine ring structure, are terdentate-bonded to the metal atom.

For the structure shown as "dpzb", the two (N-pyrazolyl) ring structures are the ring structures containing the first nitrogen and second nitrogen, respectively, and the benzene ring structure positioned at the middle of the two (N-pyrazolyl) ring structures correspond to the ring structure containing carbon atom. For the two (N-pyrazolyl) ring structures, the carbon atom which adjoins the nitrogen atom in the (N-pyrazolyl) ring structure as well as benzene ring structure is the first nitrogen adjoining atom and second nitrogen adjoining atom. For the benzene ring structure, the carbon atom bonding to the atom adjoining to the first nitrogen (carbon atom), and the carbon atom bonding to the atom adjoining to the second nitrogen (carbon atom) correspond to the atom adjoining the first and second carbon atom, respectively. For the structure shown as "dpzb", the three atoms that are the two nitrogen atoms that are not bonded to the benzene ring structure for the two (N-pyrazolyl) ring structures and the carbon atom situated in-between the two nitrogen atoms and also this is in-between the atom adjoining to the first carbon atom (carbon atom) and the atom adjoining to the second carbon atom (carbon atom) for the benzene ring structure, are terdentate-bonded to the metal atom.

-Monodentate ligand-

The aforementioned monodentate ligand is monodentate ligand (first form) containing ring structure comprising a substituent group at the position, excluding the position furthest from the bonding position as compared with the metal atom that is monodentate-bonded towards the metal atom through one of the chosen atoms from a N atom, an O atom and a S atom, and comprising monodentate ligand (second form) containing ring structure substituted by a halogen atom that is monodentate-bonded towards the metal atom through one of the chosen atoms from a N atom, an O atom and a S atom, and the like.

In the case of the first form monodentate ligand, the substituent group is an alkyl group or an aryl group.

The aforementioned alkyl group is a methyl group, an ethyl group, a propyl group, a butyl group or an isopropyl group. Among these groups, the methyl group is particularly preferable.

The aforementioned aryl group is a phenyl group or a toluyl group. Among these groups, the phenyl group is preferable.

For the case of the first form monodentate ligand, the ring structure is as described herein, and may be suitably selected according to the purpose, for example, a six-membered ring, a five-membered ring, and the like, and these ring may or may not contain hetero atom. If the ring structure is a six-membered ring, the aforementioned monodentate ligand, for example, is a monodentate ligand containing ring structure comprising a substituent group at the position excluding *p*-position as compared with the aforementioned metal atom.

In the case of the second form monodentate ligand, the halogen atom, for example, is a fluorine atom, a chlorine atom, a bromine atom, and the like. Among these atoms, the fluorine atom that has low reactivity and excellent durability is preferable.

The preferable specific examples of monodentate ligand are expressed in structures in the following Table 2.

Table 2

| Ligand | o2Fph | odmp | o2pph | 26dpph | dmpr | mbtmz |
|---|---|---|---|---|---|---|
| Structure | 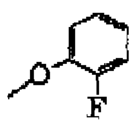 | 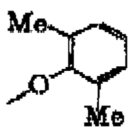 | 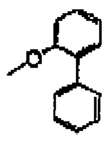 | 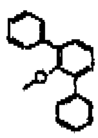 | 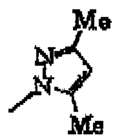 | 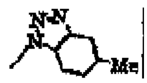 |

In Table 2, the structure shown as "o2Fph", corresponding to the second form monodentate ligand, is monodentate-bonded to the metal atom through an O atom and comprises a benzene ring that is substituted by a fluorine atom at the *o*-position as compared with the metal atom.

The structure shown as "odmp", corresponding to the first form monodentate ligand, is monodentate-bonded to the metal atom through an O atom and comprises a benzene ring that is substituted by two methyl groups at the o-position as compared with the metal atom.

The structure shown as "o2pph", corresponding to the first form monodentate ligand, is monodentate-bonded to the metal atom through an O atom and comprises a benzene ring that is substituted by a phenyl group at the o-position as compared with the metal atom.

The structure shown as "o26dpph", corresponding to the first form monodentate ligand, is monodentate-bonded to the metal atom through an O atom and comprises a benzene ring that is substituted by two phenyl groups at the *o*-position as compared with the metal atom.

The structure shown as "dmpr", corresponding to the first form monodentate ligand, is monodentate-bonded to the metal atom through a N atom in a pyrazole ring and comprises a structure where a carbon atom adjoining a N atom that is further adjoined to the aforementioned N atom is methyl-substituted.

The structure expressed as "mbtaz", corresponding to the aforementioned first form monodentate ligand, is a monodentate ligand comprising a structure where a carbon atom, one part of the benzene structure in a isoquinorile ring and situated the furthest from the N atom that is bonded to the metal atom, is methyl-substituted.

Among the aforementioned monodentate ligands, those that can neutralize the overall charges of the aforementioned organometallic complex and give sublimation properties to this organometallic complex are preferable.

-Organometallic complex structure examples-

The structure is of the organometallic complex are represented by the following general formula (1) or general formula (2), as described herein, and as compared with the metal atom, the terdentate ligand shown by any of the aforementioned "dpb", "tp" and "dpzb" and the organometallic complex bonded to the monodentate ligand represented

by any of the aforementioned "o2Fph", "odmp", "o2pph", "o26dpph", "dmpr" and "mbtaz" are more suitable.

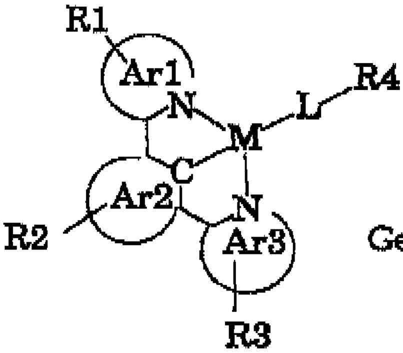

General Formula(1)

For general formula (1), M represents a metal atom selected from Fe, Co, Ni, Ru, Rh, Pd, Os, Ir and Pt. Ar1, Ar2 and Ar3 represent ring structures as described herein and all are bonded to M, Ar1 and Ar2 are bonded, Ar2 and Ar3 are bonded and on the whole, terdentate ligand terdentate-bonded to M is formed. N in Ar1 represents a nitrogen atom that comprises a ring structure shown in Ar1 as described herein. C in Ar2 represents a carbon atom that comprises a ring structure shown in Ar2 as described herein. N in Ar3 represents a nitrogen atom that comprises a ring structure shown in Ar3 as described herein. R1, R2 and R3 each represents a hydrogen atom. L represents a monodentate ligand, containing a ring structure that is monodentate-bonded towards the metal atom through one of the selected atoms from a N atom, an O atom and a S atoms. R4 represents a substituent group, as described herein, substituting at the position excluding the p-position as compared with M in L

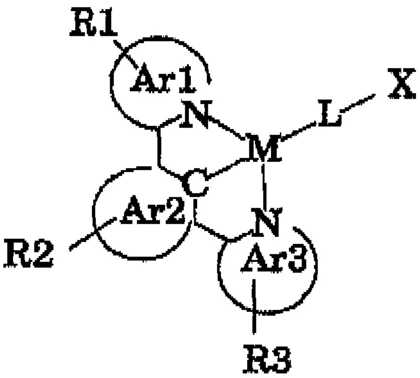

General Formula (2)

For general formula (2), M represents a metal atom selected from Fe, Co, Ni, Ru, Rh, Pd, Os and Pt. Ar1, Ar2 and Ar3 represent ring structures and all are bonded to M, Ar1 and Ar2 are bonded, Ar2 and Ar3 are bonded and on the whole, a terdentate ligand terdentate-bonded to M is formed. N in Ar1 represents a nitrogen atom that comprises a ring structure shown in Ar1 as described herein. C in Ar2 represents a carbon atom that comprises a ring structure shown in Ar2 as described herein. N in Ar3 represents a nitrogen atom that comprises a ring structure shown in Ar3 as described herein. R1, R2 and R3 each represents a hydrogen atom. L represents a monodentate ligand as described herein containing a ring structure that is monodentate-bonded towards the metal atom through one of the selected atoms from a N atom, an O atom and a S atom. X represents a halogen atom.

For general formula (1) and general formula (2), M is the aforementioned metal atom and Pt is preferable (in the case where the metal atom is Pt, the organometallic complex is platinum complex).

For Ar2, the following structures are appropriate:

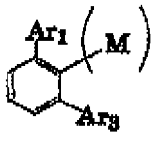 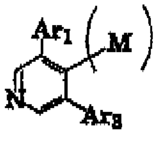 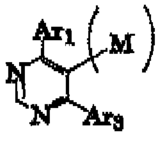 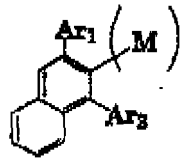 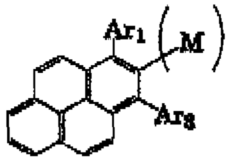

However, in these formulas, M represents the aforementioned metal atom bonded with Ar2 and not one part of the aforementioned Ar2 structure. Ar1 and Ar3 form the aforementioned terdentate ligand with Ar2 and they are not one part of thisAr2 structure.

Ar1 and Ar3 is either a homocyclic conjugate aromatic group or a polycyclic conjugated aromatic group in accordance with the following structures Ar1 and Ar2 may be identical or different with each other; however, it is preferable that they are identical R, in these structures, represents a hydrogen atom.

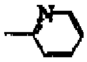 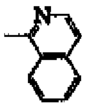 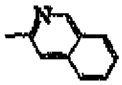 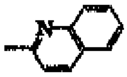 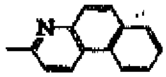 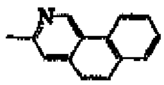 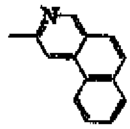

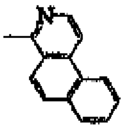 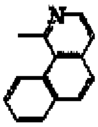 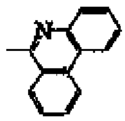 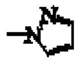 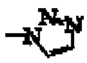 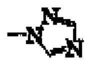 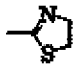 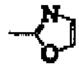 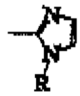

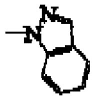 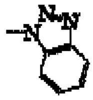 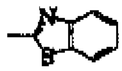 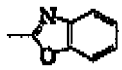 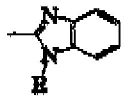

For general formula (1) and general formula (2), R1, R2 and R3 represent a hydrogen atom.

L shows monodentate ligand, as described herein, containing ring structure that is monodentate-bonded towards the metal atom through one of the selected atoms from N atom, O atom and S atom.

The specific examples of -L-R4 in general fonnula (1) or -L-X in general formula (2) are groups in following structures. R means R4 in -L-R4 or X in -L-X in following specific examples.

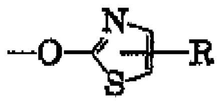 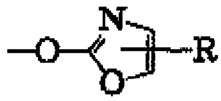 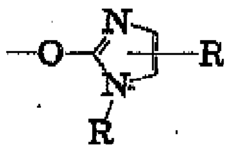 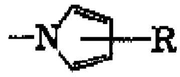

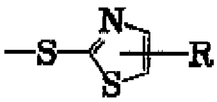 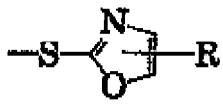 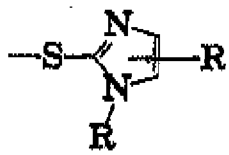 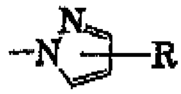

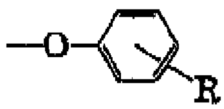

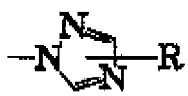 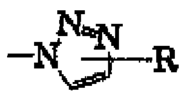

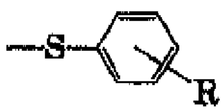

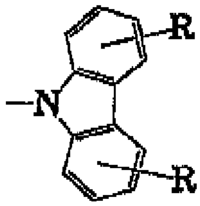

The organometallic complex shown in general formula (1) or in general formula (2) is electrically neutral and shows sublimation property in vacuum, thus advantageous when it forms thin film, not only publicly known coating method, vacuum vapor deposition and the like may also be suitably applied.

In the organometallic complex shown in general formula (1), for example, the structure where Ar2 is benzene ring is as following.

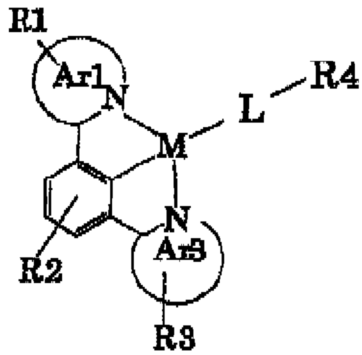

In the organometallic complex aforementioned, for example, the structure where Ar1 and Ar3 are benzene ring is as following.

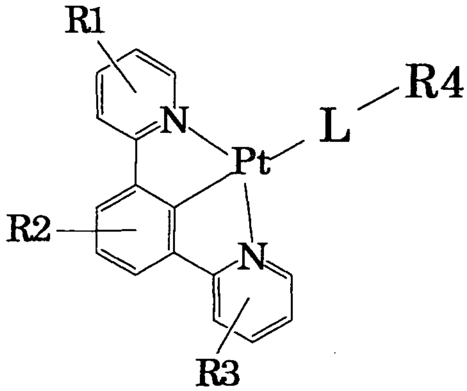

In the organometallic complex shown in general formula (2), for example, the structure where Ar2 is benzene ring is as following.

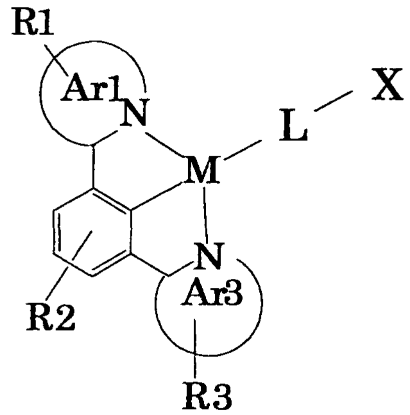

In the organometallic complex aforementioned, for example, the structure where Ar1 and Ar3 are benzene ring is as following.

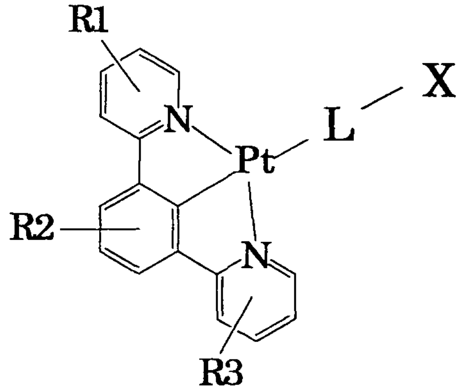

The quantum yield of photoluminescence (P.L. :abbreviated as "PL" below) for organometallic complex of the present invention is the value calculated by thin film (PL quantum yield =22%) of formed tris(8-hydroxyquinoline)aluminum ($Alq_3$) with the same thickness as the reference when it is thin-filmed and it is preferable to be more than 70% and more preferable to be more than 90%.

The PL quantum yield, for example, can be measured and calculated by the following. That is, an excitation light 100 (365 nm constant light) from light source was illuminated slantingly on the thin film sample 102 on a transparent substrate as shown in Fig. 9, and the PL photon number [P(sample)] was calculated by conversion from the PL spectrum of the thin film measured by spectroradiometer (Minolta, CS-1000) 104. At the same time of light emission measurement, the total intensity [*I*(sample)] of the absorbed excited light by mirror 106 that was transmitted and reflected from the sample was detected. Subsequently, the same measurement was also carried out on the reference, $Alq_3$ thin film (PL quantum yield 22%), and the PL photon number [P(ref)] of the reference and the total intensity [I(ref)] of the transmitted and reflected excited light were calculated. Next, the total intensity [*I*(substract)] of the transmission and reflection of the excited light on the transparent substrate only were calculated. The PL quantum yield of thin film sample can be calculated from the following formula.

$$(PL\ quantum\ efficiency) = \frac{P(sample)/\left[I(substrate) - I(sample)\right]}{P(ref.)/\left[I(substrate) - I(ref.)\right]} \times 22\%$$

-Synthesis method-

The synthesis method of organometalic complex of present invention has no particular limitation and may be suitably selected according to the purpose , for example, terdentate ligand (N^ C^ N model) and organometallic complex (precursor), comprising metal atom and halogen atom (chlorine atom), are reacted with halogen substituent or alkali metal of monodentate ligand according to suitable selected condition, and the like.

The above reaction may be carried out suitably under the existence of catalyst that has no particular limitation and may be suitably selected according to the purpose, for example, copper salt-organic amine catalyst and the like. These may be utilized one kind independently or more than two kinds together.

The synthesis method for organometallic complex (precursor) containing terdentate ligand, monodentate ligand and halogen atom (chlorine atom) has no particular limitation and may be suitability selected according to the purpose, for example, the method written in D. J. Cardenas and A. M. Echavarren, Organometallics Vol. 18, p. 3337 (1999) and the like.

-Application-

The organometallic complex and light-emitting solid containing this organometallic complex of the present invention have excellent PL quantum yield and show high luminous efficiency as mentioned above, they could be suitably utilized in every fields, the point where preferred luminescent color that is high luminance and long lifetime may be obtained, they may be utilized suitably, particularly either in organic EL elements, or illuminators. For organic EL display utilizing the organic EL, for the purpose of obtaining full color display, the combined organic EL element of each color of red, green and blue is used as one pixel, but in this case, three-color organic EL element is necessary. The luminescent color of the organometallic complex of the present invention may be controlled or altered by changing the molecule structure of the terdentate ligand suitably, and from the point where emission from each color of red, green and blue can be obtained, it is advantageous to apply this organometalic complex to the organic EL element.

(Organic EL element)

The organic EL element of the present invention comprises an organic thin film layer interposed between a positive electrode and a negative electrode, and the organic thin film layer contains aforementioned organometallic complex of present invention, and furthermore containing suitably selected other layers to materials.

The organic thin film layer has no particular limitation and may be suitably selected according to the purpose, for example, comprises at least the aforementioned light-emitting layer, and may also have a positive hole injecting layer, a positive hole transporting layer, a positive hole blocking layer, an electron transporting layer or an electron injecting layer as necessary. The aforementioned light-emitting layer may be formed single-function as light-emitting layer and also multiple-function such as light-emitting layer at the same time transporting layer or light-emitting layer at the same time positive hole transporting layer.

-Light-emitting layer-

The light-emitting layer has no particular limitation and may be suitably selected according to the purpose, for example, containing the organicmetallic complex of present inventions as luminescent materials is preferable. In this case, the light-emitting layer may be formed independently as a neat film of the organicmetallic complex of present inventions, or a doped film which comprises, preferably, the organometallic complex as the guest material and other materials as host materials having emission wavelength near to the absorption wavelength of the guest materials. The host material is preferable to be contained in the light-emitting layer or positive hole transporting layer or electron transporting layer.

In the case of the organometallic complex of the present invention that is the aforementioned guest material used in combination, when the EL emission is produced, firstly the host material would be excited. Then, the emission wavelength of the host material overlaps with the absorption wavelength of the guest material (aforementioned organometallic complex), thus the excitation energy moves efficiently from the aforementioned host material to the aforementioned guest material, and the host material returns to its ground state without emitting light, and only the excited guest material emits excitation energy as light. Therefore, this material excels in luminous efficiency, color purity and the like.

In the case of luminescence molecule in thin film generally exists individually or in high concentration, by approaching one another, luminescence molecules produce interaction among their molecules, and the luminous efficiency reducing phenomenon called "concentration quenching" takes place. In the case of using the aforementioned guest material and the aforementioned host material in combination, the aforementioned organometallic complex that is the guest compound is dispersed in the host material at relatively low concentration, so the above "concentration quenching" is effectively suppressed, and the luminous efficiency is excellent. Furthermore, in the case of the guest material and the host material used in combination in the light-emitting layer, the host material has excellent film-forming properties generally so while maintaining its emission properties, the point where it is excellent in film-forming properties is advantageous.

The aforementioned host material has no particular limitation and may be suitably selected according to the purpose, however, the emission wavelength near to the optical absorption wavelength of the guest material is preferable,

for example, the aromatic amine derivatives expressed in the following structural formula (1), carbazole derivatives expressed in the following structural formula (2), oxine complex expressed in the following structural formula (3), 1, 3, 6, 8-tetraphenylpyrene compound expressed in the following structural formula (4), 4,4'-bis(2,2'-diphenylvinyl)-1,1'-biphenyl (DPVBi) (main emission wavelength=470 nm) expressed in the following structural formula (5), p-sexiphenyl expressed in the following structural formula (6), 9,9'-bianthryl (main emission wavelength=400 nm) expressed in the following structural formula (7), and polymer materials mentioned later, are suitable.

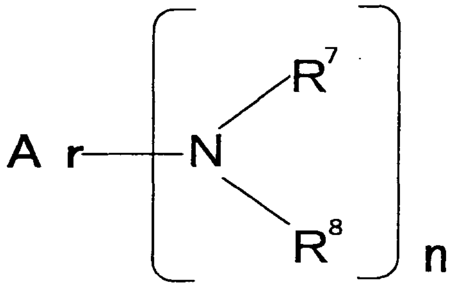

Structural formula (1)

In the aforementioned structural formula (1), n represents an integer, 2 or 3. Ar represents a divalent or a trivalent aromatic group or heterocyclic aromatic group. $R^7$ and $R^8$ may be identical or different and represent a monovalent aromatic group or a heterocyclic aromatic group. The aforementioned monovalent aromatic group or heterocyclic aromatic group has no particular limitation and may be suitably selected according to the purpose.

Among the aromatic amine derivatives represented in the aforementioned structural formula (1), N, N'-dinaphthyl-N, N'-diphenyl-[1, 1'-biphenyl]-4, 4'-diamine (NPD) (main emission wavelength=430nm) and its derivatives expressed by the following structural formula (1) -1 are preferable.

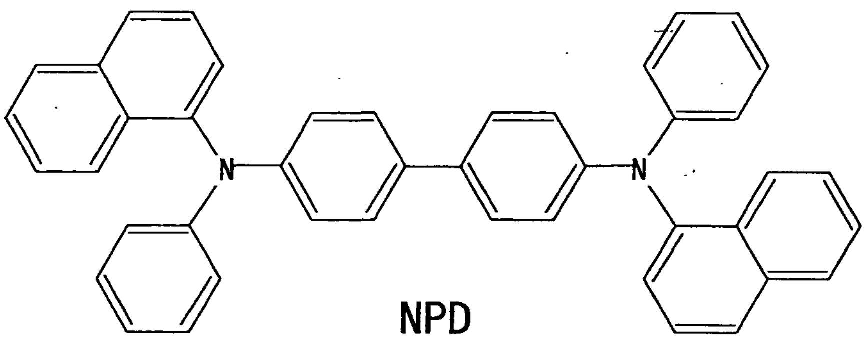

NPD

Structural formula (1) -1

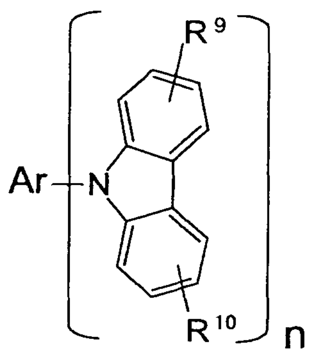

Structural formula (2)

In the aforementioned structural formula (2), Ar represents a divalent or a trivalent group containing an aromatic ring, or a divalent or a trivalent group containing a heterocyclic aromatic ring.

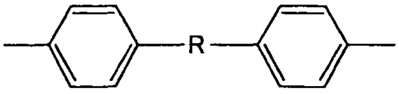
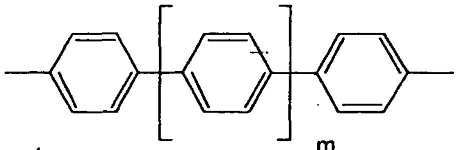

$m = 0 \sim 4$

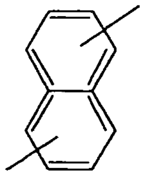
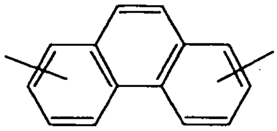
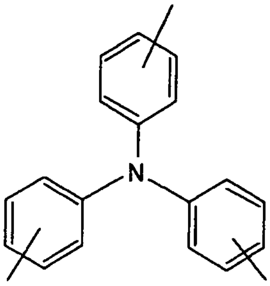
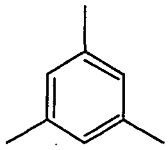
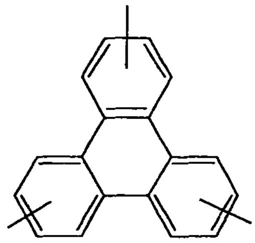
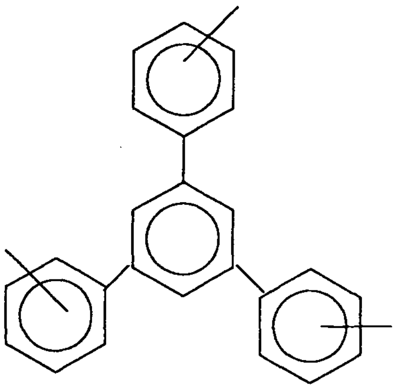

These may be substituted by non-conjugated groups. R represents a linking group, for example the following groups are suitable.

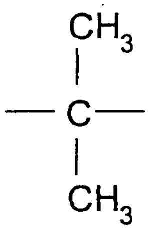
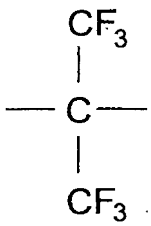
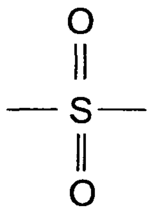
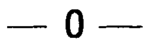

In the aforementioned structural formula (2), $R^9$ and $R^{10}$ are independent and represent a hydrogen atom, a halogen atom, an alkyl group, an aralkyl group, an alkenyl group, n aryl group, a cyano group, an amino group, an acyl group, an alkoxycarbonyl group, a carboxyl group, n alkoxy group, an alkylsulfonyl group, a hydroxyl group, an amide group, an aryloxy group, an aromatic hydrocarbon or an aromatic heterocyclic group, and these may be further substituted by a substituent group.

In the aforementioned structural formula (2), N represents an integer, 2 or 3 being particularly suitable. Among the carbazole derivatives represented in the aforementioned structural formula (2), Ar is an aromatic group in which two benzene rings are joined via a single bond, $R^9$ and $R^{10}$ are hydrogen atoms, and n=2. The structures selected from 4,4'-bis (9-carbazolyl)-biphenyl (CBP) (main emission wavelength=380nm) and its derivatives which is expressed by the following structural formula (2) -1 is preferred due to its excellent light-emitting efficiency and the like.

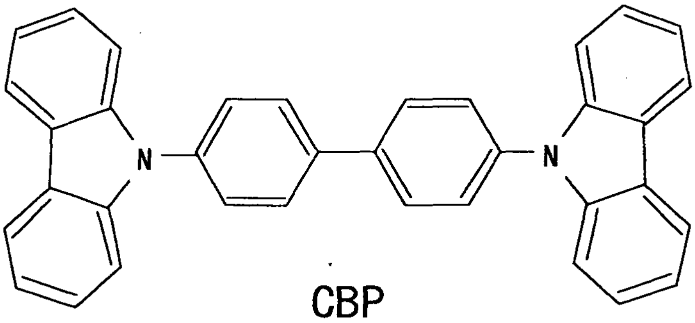

CBP

Structural formula (2) -1

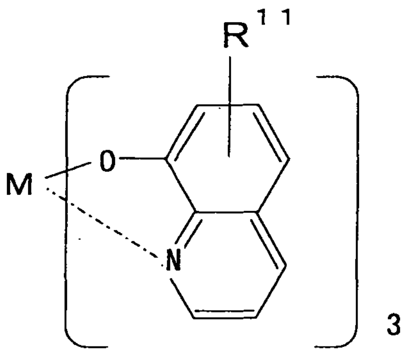

Structural formula (3)

In the aforementioned structural formula (3), $R^{11}$ represents hydrogen atom, halogen atom, alkyl group, aralkyl group, alkenyl group, aryl group, a cyano group, an amino group, acyl group, alkoxycarbonyl group, carboxyl group, alkoxy group, alkylsulfonyl group, hydroxyl group, amide group, aryloxy group, aromatic hydrocarbon or aromatic heterocyclic group. These may be further substituted by a substituent.

Among the oxine complex expressed in the aforementioned structural formula (3), tris(8-hydroxyquinoline) aluminium ($Alq_3$) (main emission wavelength=530nm) represented by the following structural formula (3) is preferable.

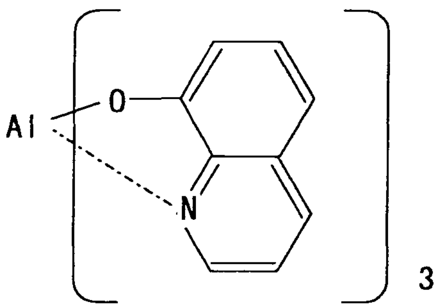

Alq

Structural formula (3) -1

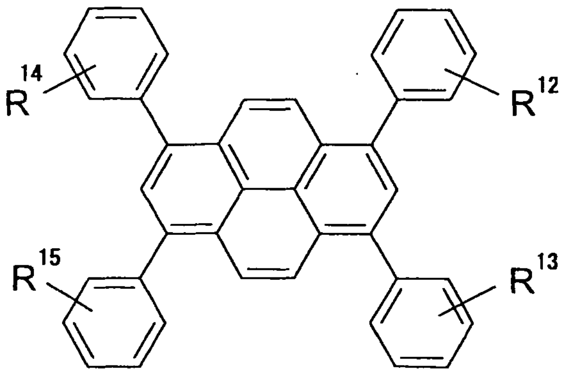

Structural formula (4)

In the structural formula (4), $R^{12}$ to $R^{15}$ may be identical or different, and represent a hydrogen atom or a substituent. As the substituent group, an alkyl group, cycloalkyl group or aryl group may suitably be mentioned, and these may be further replaced by substituents.

For 1, 3, 6, 8-tetraphenylpyrene compound expressed in the structural formula (4), $R^{12}$ to $R^{15}$ represent hydrogen atom. The 1, 3, 6, 8-tetraphenylpyrene compound (main emission wavelength=440nm) expressed in the following structural formula (4)-1 is preferred due to its excellent light-emitting efficiency and the like.

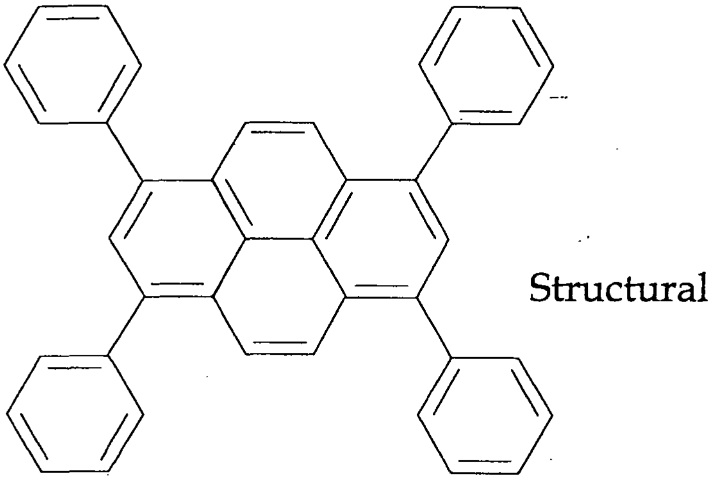

Structural formula (4) - 1

1, 3, 6, 8 —tetraphenylpyrene

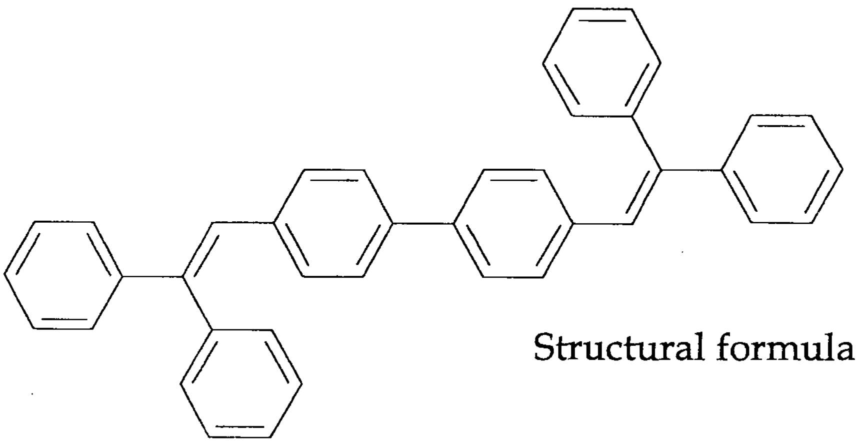

Structural formula (5)

DPVBi

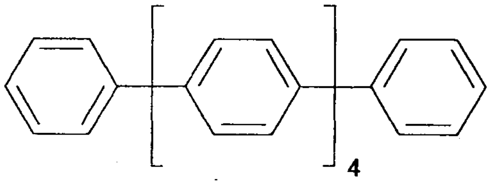

p-sexiphenyl

Structural formula (6)

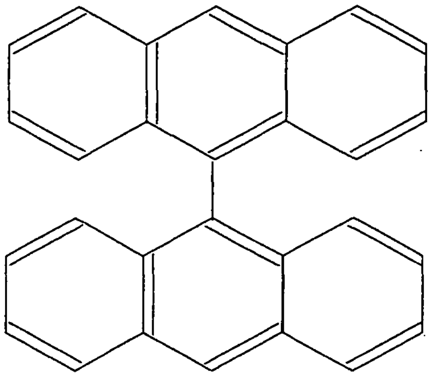

9, 9'-bianthryl

Structural formula (7)

There is no particular limitation of the host material that is polymer which may be suitably selected according to the purpose, for example, poly(p-phenylene vinylene) (PPV), polythiophene (PAT), poly(p-phenylene) (PPP), poly(vinyl carbazole) (PVCz), polyfluorene (PF), polyacetylene (PA) and their derivatives expressed in the following structural formulas, are preferred.

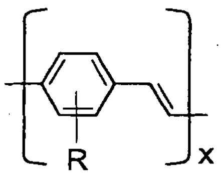

PPV derivatives

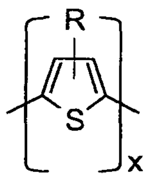

PAT derivatives

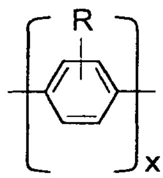

PPP derivatives

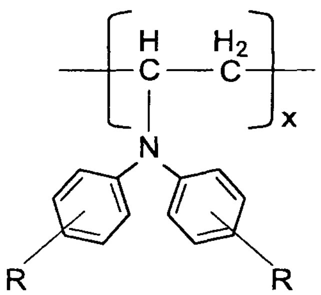

PVCz derivatives

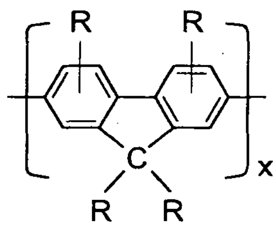

PF derivatives

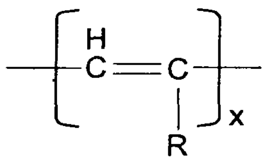

PA derivatives

Among the aforementioned structural formulas, R represents a hydrogen atom, a halogen atom, an alkoxy group, an amino group, an alkyl group, a cycloalkyl group, an aryl group that may contain a nitrogen atom or a sulfur atom, or an aryloxy group, each of which may be substituted by a substituent group. X represents an integer.

Among the host materials that are polymer materials, poly(vinyl carbazole) (PVCz) that is expressed in the following structural formula (8) where the energy transferring from host to guest is carried out efficiently, is preferred.

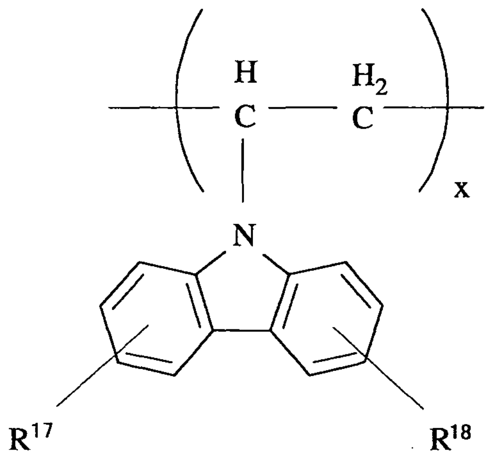

Structural formula (8)

$R^{17}$ and $R^{18}$ in the aforementioned structural formula (8) represent several substituent groups at any position of the ring structures, respectively, and also represent a hydrogen atom, a halogen atom, an alkoxy group, an amino group, an alkyl group, a cycloalkyl group, an aryl group that may contain a nitrogen atom or a sulfur atom, or an aryloxy group, each of which may be substituted by a substituent group. X represents an integer.

In the case of using host material that is the aforementioned polymer material, the host material is dissolved in the solvent, blended with the guest material that is the aforementioned organometallic complex and after preparing the coating liquid, this coating liquid may be coated by wet film forming method such as spin coat method, ink-jet method, dip coat method, braid coat method. At this time, for the purpose of enhancing the charge-transporting property of the layer that is formed by coating, positive hole transporting layer material and electron transporting layer material is blended simultaneously on this layer may be film formed. These wet film forming methods are suitable for forming, especially aforementioned multifunction light-emitting layer to one layer (positive hole transporting layer and electron transporting layer, and light-emitting layer).

The amount of layer containing the organometallic complex in the aforementioned light-emitting layer, for example, is preferably 0.1% to 50 % by mass, and more preferably 5% to 30 % by mass.
If this content is less than 0.1 % by mass, the lifetime and luminous efficiency may not be sufficient, and if the content exceeds 50% by mass, the color purity may deteriorate. On the other hand, if the content is within the above preferred range, lifetime and luminous efficiency are excellent.

The ratio of the organometallic complex that is the guest material and the host material in the aforementioned light-emitting layer (molar ratio, guest material : host material) is preferably 1 : 99 to 50 : 50, and more preferably 1 : 99 to 10 : 90.

In the case where the light-emitting layer is multifunctional formed like light-emitting layer and electron transporting layer or light-emitting layer and positive hole transporting layer, the content of organometallic complex in these layers may be similar to the aforementioned.

In the aforementioned light-emitting layer, a positive hole can be introduced from the positive electrode, positive hole injecting layer or positive hole transporting layer, or electrons introduced from the negative electrode, electron implantation layer or electron transporting layer while applying an electric field. An area may be provided for recombination between holes and electrons, and the organometallic complex (light-emitting molecule, light-emitting material) made to emit light due to the recombination energy produced at this time. In addition to the organometallic complex, other light-emitting materials may be added to the extent that they do not interfere with the light emission.

The aforementioned light-emitting layer can be formed according to the known methods, for example, the vapor deposition method, wet film forming method, MBE (molecular beam epitaxy) method, cluster ion beam method, molecule laminating method, LB method, printing method, transfer method, and the like.

Of these, vapor deposition is preferred from the viewpoint that an organic solvent is not used so there is no problem of waste fluid treatment, and manufacture is low cost, simple and efficient. In designing the light-emitting layer as a single layer structure, when for example forming this light-emitting layer as a positive hole transporting layer/light-emitting layer/electron transporting layer, the wet film forming method is preferred.

There is no particular limitation on the vapor deposition method, which can be suitably selected from known methods according to the purpose, for example vacuum vapor deposition, resistance heating vapor deposition, chemical vapor deposition, physical vapor deposition, and the like. Examples of chemical vapor deposition are plasma CVD, laser CVD, heat CVD and gas source CV. The organometallic complex may suitably be formed by vacuum vapor deposition, or in the case where this light-emitting layer contains the aforementioned host material in addition to the above organometallic complex, the organometallic complex and this host material can be formed simultaneously by vacuum vapor

deposition. For the former, as coevaporation is not necessary, it is easy to be formed.

There is no particular limitation on the aforementioned wet film forming method which can be suitably selected from known methods according to the purpose, for example the ink-jet method, spin coat method, kneader coat method, bar coat method, braid coat method, cast method, dip method, curtain coat method, and the like.

In the aforementioned wet film forming method, a solution may be used (coated) in which the material of the light-emitting layer is dissolved or dispersed together with a resin component. Examples of this resin component are polyvinyl carbazole, polycarbonate, polyvinyl chloride, polystyrene, polymethyl methacrylate, polyester, polysulfone, polyphenylene oxide, polybutadiene, hydrocarbon resins, ketone resin, phenoxy resin, polyamide, ethyl cellulose, vinyl acetate, ABS resin, polyurethane, melamine resin, unsaturated polyester resin, alkyde resin, epoxy resin, silicone resin, and the like.

The light-emitting layer obtained by the wet film forming method may be formed for example by using (coating and drying) a solution (coating liquid) in which the organometallic complex, and a resin material if necessary, are dissolved in a solvent, or if this light-emitting layer contains the aforementioned host material in addition to the organometallic complex, by using (coating and drying) a solution (coating liquid) in which this organometallic complex, the host material and a resin material if necessary are dissolved in a solvent.

The thickness of the aforementioned light-emitting layer has no particular limitation and may be suitably selected according to the purpose, for example, preferably 1nm to 50 nm, but more preferably 3nm to 20 nm.

If the thickness of the light-emitting layer is within the above preferred numerical range, light-emitting efficiency, light-emitting luminance and color purity of the blue light emitted by this organic EL element are sufficient, and if it is within the more preferred numerical range, these effects are more pronounced.

-Positive electrode-

There is no particular limitation on the positive electrode, which can be suitably selected according to the purpose. Specifically, when this organic thin film layer comprises only the light-emitting layer, it is preferred to supply positive holes (carrier) to this light-emitting layer; when this organic thin film layer further comprises a positive hole transporting layer, it is preferred to supply positive holes (carrier) to this positive hole transporting layer; and when this organic thin film layer further comprises a positive hole injecting layer, it is preferred to supply positive holes (carrier) to this positive hole injecting layer.

There is no particular limitation on the material of the positive electrode. It can be suitably selected according to the purpose, for example metals, alloys, metal oxides, electrically conducting compounds, mixtures thereof, and the like. Materials having a work function of 4eV or more are preferred.

Specific examples of the material of the positive electrode are electrically conducting metal oxides such as tin oxide, zinc oxide, indium oxide, indium tin oxide (ITO), and the like, metals such as gold, silver, chromium, nickel, and the like, mixtures or laminates of these metals and electrically conducting metal oxides, inorganic electrically conducting substances such as copper iodide, copper sulfide, and the like, organic electrically conducting materials such as polyaniline, polythiophene, polypyrrole, and the like, and laminates of these with ITO, and the like. These may be used either alone or in combination of two or more. Of these, electrically conducting metal oxides are preferred, and ITO is particularly preferred from the viewpoints of productivity, high conductivity and transparency.

There is no particular restriction on the thickness of the positive electrode which may be selected according to the material, but 1 nm to 5000 nm is preferred and 20 nm to 200 nm is more preferred.

The positive electrode is normally formed on a substrate such as a glass like soda lime glass or non-alkali glass, or a transparent resin.

When using the above-mentioned glass as the substrate, non-alkali glass or soda lime glass with a barrier coat of silica or the like, are preferred from the viewpoint that they lessen elution ions from the glass.

There is no particular limitation on the thickness of the substrate provided that it is sufficient to maintain mechanical strength, but when using glass as the substrate, it is normally 0.2 mm or more, and 0.7 mm or more is preferred.

The positive electrode can be suitably formed by any of the methods mentioned above, such as the method of applying a dispersion of ITO by the vapor deposition method, the wet film forming method, the electron beam method, the sputtering method, the reactant sputtering method, the MBE (molecular beam epitaxy) method, the cluster ion beam method, the ion plating method, the plasma polymerization method (high frequency excitation ion plating method), the molecule laminating method, the LB method, the printing method, the transfer method, the chemical reaction methods (sol gel process, for example.), and the like.

By washing the positive electrode and performing other treatment, the drive voltage of this organic EL element can be reduced, and the light-emitting efficiency can also be increased. As examples of other treatment, when the material of the positive electrode is ITO, UV ozonization and plasma processing, and the like, may be mentioned.

-Negative electrode-

There is no particular limitation on the negative electrode, which can be suitably selected according to the purpose. Specifically, when this organic thin film layer comprises only the light-emitting layer, it is preferred to supply electrons to this light-emitting layer; when this organic thin film layer further comprises an electron transporting layer, it is preferred to supply electrons to this electron transporting layer; and when there is an electron implantation layer between this organic thin film layer and the negative electrode, it is preferred to supply electrons to this electron implantation layer.

There is no particular limitation on the material of the negative electrode which can be suitably selected according to adhesion properties with the layers or molecules adjoining this negative electrode, such as the electron transporting layer and light-emitting layer, and according to ionization potential, and stability. Examples are metals, alloys, metal oxides, electrically conducting compounds, mixtures thereof, and the like.

Examples of the material of the negative electrode are alkali metals (e.g., Li, Na, K, Cs, and the like), alkaline earth metals (e.g., Mg, Ca, and the like), gold, silver, lead, aluminum, sodium-potassium alloys or their mixtures, lithium-aluminium alloys or their mixtures, magnesium-silver alloys or their mixtures, rare earth metals such as indium, ytterbium and the like, and their alloys, and the like.

One of these may be used alone, or two or more may be used in combination. Of these, materials having a work function of 4eV or less are preferred. Aluminum, lithium-aluminium alloys or their mixtures, or magnesium-silver alloys or their mixtures, and the like are more preferred.

There is no particular limitation on the thickness of the negative electrode which may be selected according to the material of the negative electrode, but 1 nm to 10000 nm is preferred and 20 nm to 200nm is more preferred.

The negative electrode can be suitably formed by any of the methods mentioned above, such as the vapor deposition method, the wet film forming method, the electron beam method, the sputtering method, the reactant sputtering method, the MBE (molecular beam epitaxy) method, the cluster ion beam method, the ion plating method, the plasma polymerization method (high frequency excitation ion plating method), the molecule laminating method, the LB method, the printing method, the transfer method, and the like.

When two or more of these are used together as the material of the negative electrode, two or more materials may be vapor-deposited simultaneously to form an alloy electrode, or a pre-prepared alloy may be made to vapor-deposit so as to form an alloy electrode.

The resistances of the positive electrode and negative electrode are preferably low, and it is preferred that they are several hundreds of Ω/□ or less.

-Positive hole injecting layer-

There is no particular restriction on the positive hole injecting layer which can be selected according to the purpose, but it is preferred that it has the function of, for example, implanting positive holes from the positive electrode when an electric field is applied.

There is no particular limitation on the material of the positive hole injecting layer which can be suitably selected according to the purpose, e.g. a starburst amine (4, 4', 4"-tris[2-naphthylphenylamino] triphenylamine : abbreviated as 2-TNATA as following) expressed by the following formula, copper phthalocyanin, polyaniline, and the like.

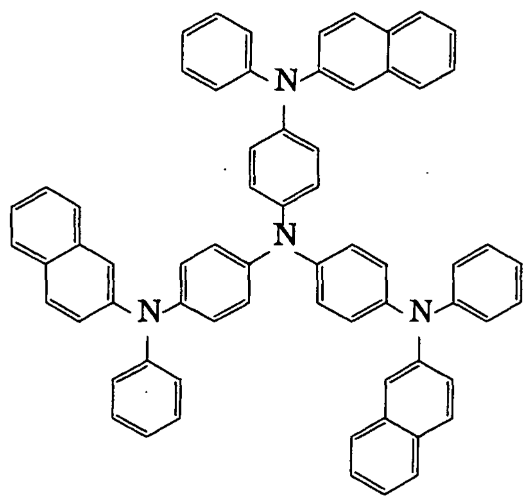

There is no particular limitation on the thickness of the positive hole injecting layer which can be selected according to the purpose. For example, about 1 nm to 100 nm is preferred, and 5 nm to 50 nm is more preferred.

The positive hole injecting layer can be suitably formed by any of the methods mentioned above, such as the vapor deposition method, the wet film forming method, the electron beam method, the sputtering method, the reactant sputtering method, the MBE (molecular beam epitaxy) method, the cluster ion beam method, the ion plating method, the plasma polymerization method (high frequency excitation ion plating method), the molecule laminating method, the LB method, the printing method, the transfer method, and the like.

-Positive hole transporting layer-

There is no particular limitation on the positive hole transporting layer which can be selected according to the purpose, but for example, a layer having the function to convey positive holes from the positive electrode when an electric field is applied, is preferred.

There is no particular limitation on the material of the positive hole transporting layer which can suitably be selected according to the purpose. Examples are aromatic amine compounds, carbazole, imidazole, triazole, oxazole, oxadiazole, polyarylalkane, pyrrazoline, pyrrazolone, phenylene diamine, arylamine, amine-substituted calcone, stylyl anthracene, fluorenone, hydrazone, stylbene, silazane, stylyl amine, aromatic dimethylidene compounds, porphyrine compounds, polisilane compounds, poly(N-vinyl carbazole), aniline copolymers, electrically conducting oligomers and polymers such as thiophene oligomers and polymers, polythiophene and carbon film. When the material of the positive hole transporting layer is combined with the material of the light-emitting then to form a positive hole transporting layer, the resulting layer may also perform as a light-emitting layer.

These may be used alone, or two or more may be used in combination. Of these, aromatic amine compounds are preferred. Specifically, TPD (N, N'-diphenyl-N, N'-bis (3-methylphenyl)-[1, 1'-biphenyl]-4, 4'-diamine) expressed by the following structural formula, and NPD (N, N'-dinaphthyl-N, N'-diphenyl-[1,1'-biphenyl]-4, 4'-diamine) expressed by the following structural formula (67), are more preferred.

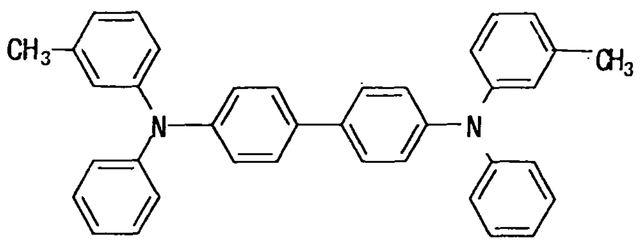

TPD

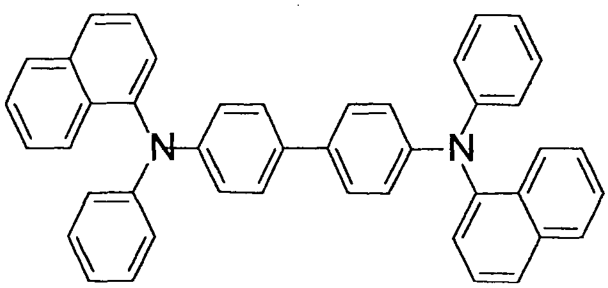

NPD

Structural formula (67)

There is no particular limitation on the thickness of the positive hole transporting layer which may be selected according to the purpose, but normally 1 nm to 500 nm is preferred, and 10 nm to 100 nm is more preferred.

The positive hole transporting layer can be suitably formed by any of the methods mentioned above, such as the vapor deposition method, the wet film forming method, the electron beam method, the sputtering method, the reactant

sputtering method, the MBE (molecular beam epitaxy) method, the cluster ion beam method, the ion plating method, the plasma polymerization method (high frequency excitation ion plating method), the molecule laminating method, the LB method, the printing method, the transfer method, and the like.

-Positive hole blocking layer-

There is no particular limitation on the positive hole blocking layer which may be selected according to the purpose, but a layer having for example the function of a barrier to positive holes implanted from the positive electrode, is preferred.

There is no particular limitation on the material of the positive hole blocking layer which can be suitably selected according to the purpose.

If the aforementioned organic EL element comprises a positive hole blocking layer, positive holes conveyed from the positive electrode side are blocked by this positive hole blocking layer, and electrons conveyed from the negative electrode are transmitted through this positive hole blocking layer to reach the aforementioned light-emitting layer. Hence, recombination of electrons and positive holes occurs efficiently in this light-emitting layer, and recombination of positive holes and electrons in organic thin film layers other than this light-emitting layer can be prevented. Thus, the luminescence from the target luminescent material is obtained efficiently, and this is advantageous in respect of color purity.

The positive hole blocking layer is preferably disposed between the light-emitting layer and the electron transporting layer.

There is no particular limitation on the thickness of the positive hole blocking layer which can be suitably selected according to the purpose, for example it is usually about 1 nm to 500 nm, but 10 nm to 50 nm is preferred.

The positive hole blocking layer may be a single layer structure, or may be a laminated structure.

The positive hole blocking layer can be suitably formed by any of the methods mentioned above such as the vapor deposition method, the wet film forming method, the electron beam method, the sputtering method, the reactant sputtering method, the MBE (molecular beam epitaxy) method, the cluster ion beam method, the ion plating method, the plasma polymerization method (high frequency excitation ion plating method), the molecule laminating method, the LB method, printing method, the transfer method, and the like.

-Electron transporting layer-

There is no particular limitation on the electron transporting layer which may suitably be selected according to the purpose, but for example a layer having the function to convey electrons from the negative electrode, or the function to act as a barrier to positive holes implanted from the positive electrode, is preferred.

Examples of the material of the electron transporting layer are quinoline derivatives, for example aforementioned tris(8-hydroxyquinoline) aluminium ($Alq_3$), oxadiazole derivative, triazole derivative, phenanthroline derivative, perylene derivative, pyridine derivative, pyrimidine derivative, quinoxaline derivative, diphenylquinone derivative, nitrosubstituted fluorophene derivative, and the like. These electron transporting layer material are blended with the aforementioned light-emitting layer material and film formed, the electron transporting layer and light-emitting layer may be formed and, furthermore, the aforementioned positive hole transporting material is also blended and film formed, the electron transporting layer and positive hole transporting layer and light-emitting layer may be formed, and at this time, polymer such as poly(vinyl carbazole), polycarbonate and the like may be utilized.

There is no particular limitation on the thickness of the electron transporting layer which can be suitably selected according to the purpose, for example it is usually about 1 nm to 500 nm, but preferably 10 nm to 50 nm.

The electron transporting layer may be a single layer structure, or may be a laminated structure. In this case, for electron transporting material used in this electron transporting layer that is adjoined to the aforementioned light-emitting layer, using the electron transporting material where the light absorption edge is shorter wavelength than the aforementioned organometallic complex, is preferable from the point of view that the light-emitting region in organic EL element is restricted to the aforementioned light-emitting layer and the excessive light emission from the electron transporting layer can be prevented. For electron transporting material where the light absorption edge is shorter wavelength than the aforementioned organometallic complex, for example, phenanthroline derivatives, oxadiazole derivatives, triazole derivatives, and the like, 2,9-dimethyl-4,7-dephenyl-1,10-phenanthroline expressed in the following structural formula (68) and the compounds expressed as following are suitable.

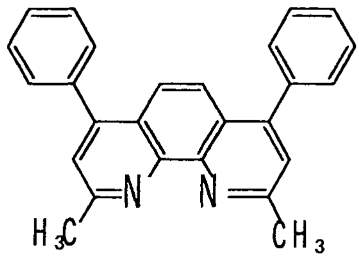

Structural formula (68)

2,9-dimethyl-4,7-diphenyl-1,10-phenanthroline

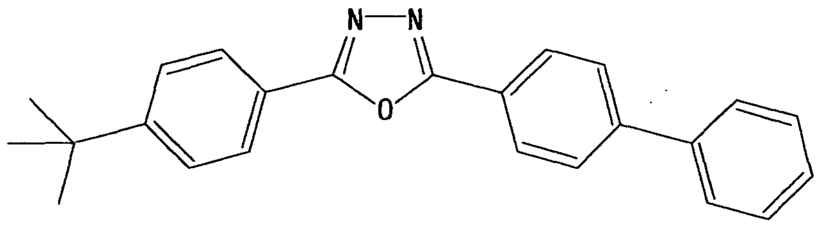

2-(4-tert-butylphenyl)-5-(4-biphenylyl)
-1,3,4-oxadiazole

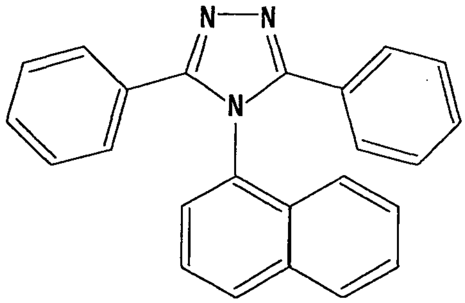

3-phenyl-4-(1-naphthyl)
-5-phenyl-1,2,4-triazole

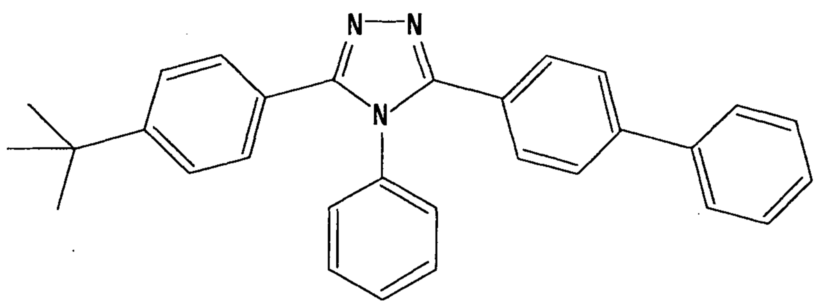

3-(4-tert-butylphenyl)-4-phenyl
-5-(4'-biphenylyl)-1,2,4-triazole

The electron transporting layer can be suitably formed by any of the methods mentioned above, such as the vapor deposition method, the wet film forming method, the electron beam method, the sputtering method, the reactant

sputtering method, the MBE (molecular beam epitaxy) method, the cluster ion beam method, the ion plating method, the plasma polymerization method (high frequency excitation ion plating method), the molecule laminating method, the LB method, the printing method, the transfer method, and the like.

-Electron implantation layer-

There is no particular limitation on the electron implantation layer which may suitably be selected according to the purpose, for example alkali metal fluoride such as lithium fluoride, alkali earth metal fluoride such as strontium fluoride, may be suitably used. There is no particular limitation on the thickness of the electron implantation layer which can be suitably selected according to the purpose, for example it is usually about 0.1 nm to 10 nm, but preferably 0.5 nm to 2 nm.

The electron implantation layer can be suitably formed by, for example vapor deposition method, electron beam method, sputtering method and the like.

-Other layers-

An organic EL element of the present invention may have other layers which are suitably selected according to the purpose, for example, a color transformation layer, a protective layer, and the like.

-Color transformation layer-

The aforementioned color transformation layer is preferable to contain phosphorescent material and more preferable to contain the aforementioned organometallic complex of the present invention. The color transformation layer may be formed by this organometallic complex only, or may be further formed by other materials.

The aforementioned organometallic complex in this color transformation layer may be used alone, or two or more may be used in combination.

However, generally, an organic molecule excited by a light with certain wavelength loses one part of the excitation energy as a form of thermal energy before emitting light from the emitting state, therefore the wavelength of the excitation light and the emission light are not consistent. The energy difference of the excitation light and emission light is called Stokes shift. So far, for color transformation material used in the aforementioned color transformation layer, from the wide material-selecting range, fluorescent materials that emit fluorescence from the singlet excited state only have been used, and these fluorescent materials have small Stokes shift (<100 nm), due to the emission light that is observed in the long wavelength range as compared with the strongest absorption band existing in the visible light range, for example, light emission of blue system may not be efficiently absorbed and transformed to red system light. On the other hand, the aforementioned organometallic complex of the present invention is a phosphorescent material, therefore if it is excited by a light with certain wavelength to a singlet excited state, it can transit rapidly to lower energy state, triplet excited state and emit phosphorescence. Therefore, Stokes shift becomes bigger as compared with fluorescent materials (in the case of common organic substances, it is known that the energy of triplet excited state is 0.1 eV to 2 eV lower than that of singlet excited state). For example, in the application of transforming the emission of blue light system that is the excitation source to red light, due to the higher blue light absorption ratio of the color transformation layer utilizing phosphorescent material as compared to the case where fluorescent materials are used, the color transformation ratio per one molecule becomes higher. In other words, as the color transformation layer utilizing the aforementioned fluorescent material does not absorb blue light, more blue light transmits through the color transformation layer. In order to make up for this, the rate of blue light absorption becomes bigger and the red light may be enhanced by thickening the color transformation layer without changing the dispersion concentration, however, due to the exudates from the color transformation when making organic EL elements, for example, moisture and residue product of organic solvent, the material comprising organic EL element deteriorates and non-emission region occurred, which become big problem, therefore as much as possible, it is good that color transformation layer is made thin. By using host that absorbs blue light together in color transformation layer that utilizes fluorescent material, the low absorption ratio of the guest is made up for, however, in the case where the aforementioned phosphorescent material is used, as it is not always necessary to use host material in combination and even in the case where it is used individually, high color transformation efficiency may be obtained, it is advantageous that many problems such as the concerned light emission from the host molecule, or deteriorating forming property of color transformation layer, or cost for making the plate in the color transformation layer formed by combination of host, may be solved simultaneously. Furthermore, if the case using the host is considered, for fluorescent material, concentration quenching occurs when the concentration is very high as aforementioned, a large number of cases where light emission become remarkably weak, however, for the aforementioned phosphorescent material, it is known that concentration quenching hardly occurs and there is no limitation to the dispersion concentration as compared with the fluorescent material. For example, for the aforementioned phosphorescent materials, even if they

are powder state, those emit light are more than fluorescent materials, conversely, when dispersion concentration is very low, due to the optical quenching effect of oxygen molecule, light emission is weaken. In powder state, the effectiveness of the case utilizing phosphorescent materials is the point where suppressed deterioration of color transformation layer can be achieved. Color transformation layer is always exposed to light during the plate-forming state such as photolithography or ITO patterning process where color transformation is carried out as an element, therefore, the declining color transformation efficiency by photo-deterioration becomes a problem. In the case of using luminous material dispersed in color transformation layer, as luminous material per unit is exposed to light, the deterioration is very fast and it is very difficult to prevent it. As compared with this, as color transformation layer using powder state phosphorescent material is exposed to light in bulk, color transformation layer of suppressed deterioration, long lifetime and unchangeable transformation efficiency may be obtained.

The arranged position of aforementioned color transformation layer has no particular limitation and may be suitability chosen satisfying the objective, for example, in the case of carrying out full color display, it is preferable to arrange on the panels.

The aforementioned color transformation layer in the aforementioned organic EL element of the present invention is preferable to be able to convert the incident light to wavelength 100 nm or more long wavelength light than this light, and more preferable to be able to convert the incident light to wavelength 150 nm or more long wavelength light than this light.

The aforementioned color transformation layer is preferable to be able to convert the light of wavelength range of ultraviolet light to blue light to red light.

The method of forming the color transformation layer have no particular limitation and may be suitably selected according to the purpose, for example, vapor deposition method, coating method and the like are suitable.

The color transformation layer of the present invention may use publicly known color filter and the like.

-Protection layer-

There is no particular limitation on the aforementioned protection layer which may be suitably selected according to the purpose, but for example a layer which can prevent molecules or substances which promote deterioration of the organic EL element, such as moisture and oxygen, from penetrating the organic EL element, is preferred.

Examples of the material of the aforementioned protection layer are metals such as In, Sn, Pb, Au, Cu, Ag, Al, Ti, Ni, and the like, metal oxides such as MgO, SiO, $SiO_2$, $Al_2O_3$, GeO, NiO, CaO, BaO, $Fe_2O_3$, $Y_2O_3$, $TiO_2$, and the like, nitrides such as SiN, $SiN_xO_y$, and the like, metal fluorides such as $MgF_2$, LiF, $AlF_3$, $CaF_2$, polyethylene, polypropylene, polymethyl methacrylate, polyimide, polyurea, polytetrafluoroethylene, polychlorotrifluoroethylene, polydichlorodifluoroethylene, the copolymer of chlorotrifluoroethylene and dichlorodifluoroethylene, copolymers obtained by copolymerizing a monomer mixture comprising tetrafluoroethylene and at least one comonomer, fluorine-containing copolymers having a ring structure in the copolymer main chain, water-absorbing substances having a water absorption rate of 1% or more, and dampproof substances having a water absorption rate of 0.1% or less.

The aforementioned protection layer can be suitably formed by any of the methods mentioned above such as the vapor deposition method, the wet film forming method, the sputtering method, the reactant sputtering method, the MBE (molecular beam epitaxy) method, the cluster ion beam method, the ion plating method, the plasma polymerization method (high frequency excitation ion plating method), the printing method, the transfer method, and the like.

-Layer composition-

There is no particular limitation on the structure of the organic EL element of the present invention which may be selected according to the purpose, i.e., the following layer compositions (1)-(13):

(1) Positive electrode/positive hole injecting layer/positive hole transporting layer/light-emitting layer/electron transporting layer/electron implantation layer/negative electrode;
(2) Positive electrode/positive hole injecting layer/positive hole transporting layer/light-emitting layer/electron transporting layer/negative electrode;
(3) Positive electrode/positive hole transporting layer/light-emitting layer/electron transporting layer/electron implantation layer/negative electrode;
(4) Positive electrode/positive hole transporting layer/light-emitting layer/electron transporting layer/negative electrode;
(5) Positive electrode/positive hole injecting layer/positive hole transporting layer/light-emitting and layer-electron transporting layer/electron implantation layer/negative electrode;
(6) Positive electrode/positive hole injecting layer/positive hole transporting layer/light-emitting layer-electron transporting layer/negative electrode;

(7) Positive electrode/positive hole transporting layer/light-emitting and layer-electron transporting layer/electron implantation layer/negative electrode;

(8) Positive electrode/positive hole transporting layer/light-emitting and layer-electron transporting layer/negative electrode;

(9) Positive electrode/positive hole injecting layer/positive hole transport and light-emitting layer/ electron transporting layer/electron implantation layer/negative electrode;

(10) Positive electrode/positive hole injecting layer/positive hole transport and light-emitting layer/ electron transporting layer/negative electrode;

(11) Positive electrode/positive hole transport and light-emitting layer/electron transporting layer/electron implantation layer/negative electrode;

(12) Positive electrode/positive hole transport and light-emitting layer/electron transporting layer/negative electrode; and

(13) Positive electrode/positive hole transport and light-emitting and electron transporting layer/negative electrode, and the like.

When the organic EL element has a positive hole blocking layer, a layer configuration in which the positive hole blocking layer is interposed between the light-emitting layer and electron transporting layer in the configuration (1) to (13) presented above may also be suitable.

Of these layer compositions, the aspect (4), positive electrode/positive hole transporting layer/light-emitting layer/electron transporting layer/negative electrode, is shown in Fig.1. An organic EL element 10 has a layer composition comprising an positive electrode 14 (for example, ITO electrode) formed on a glass substrate 12, a positive hole transporting layer 16, a light-emitting layer 18, an electron transporting layer 20, and a negative electrode 22 (for example, Al-Li electrode) laminated in this order. The positive electrode 14 (for example, ITO electrode) and the negative electrode 22 (for example, Al-Li electrode) are interconnected through the power supply. An organic thin film layer 24 is formed by the positive hole transporting layer 16, light-emitting layer 18 and electron transporting layer 20.

It is preferred that, the luminance half-life of the organic EL element of the present invention is long, for example at a continuous drive of current density of 50 $A/m^2$ is 5 hours or more, more preferred that it is 20 hours or more, and still more preferred that it is 40 hours or more, and particularly preferred that it is 60 hours or more.

As a color emission peak wavelength of the organic EL element of the present invention, there is no particular limitation and it may be suitably selected from the visible light range, for example 600 nm to 650 nm is preferable.

From the viewpoint of light-emitting voltage of the organic EL element of the present invention, it is preferred that it emits light at a voltage of 10V or less, more preferred that it emits light at a voltage of 8V or less, and still more preferred that it emits light at a voltage of 7V or less.

It is preferred that, at a current density of 5 $A/m^2$, the current efficiency of the organic EL element of the present invention is 10 cd/A or more, more preferred that it is 30 cd/A or more, and particularly preferred that it is 40 cd/A or more.

-Applications-

The organic EL element of the present invention is especially useful in various fields such as computers, display devices for vehicle mounting, field display devices, home apparatuses, industrial apparatus, household electric appliances, traffic display devices, clock display devices, calendar display units, luminescent screens and audio equipment, and is particularly suitable for the organic EL display of the present invention described hereinafter.

(Organic EL display)

Other than utilizing the organic EL element of the present invention, the organic EL display of the present invention is not particularly limited, and may be selected from the known compositions.

The organic EL display may emit monochrome light, multi-color light, or a full color type.

The organic EL display may be formed as a full color type as disclosed in Japan Display Monthly, September 2000, pages 33 to 37, i.e., a method for emitting lights in three colors in which the light emitting organic EL elements respectively corresponds to the three primary colors (blue (B), green (G), red (R)) are disposed on a substrate, the white method wherein the white light from an organic EL element for white light emission is divided into the three primary colors by color filters, and the color conversion method wherein a blue light emitted by an organic EL element which emits blue light is converted into red (R) and green (G) by a fluorescent pigment layer. In the present invention, as the organic EL element of the invention emits blue light, the three color light emitting method and color conversion method can be used, the three color light emitting method being particularly suitable.

In the case of using the aforementioned organometallic complex of the present invention as color transformation material, the aforementioned color transformation method and the like can be particularly used suitably.

The specific examples of organic EL display of the present invention by this color transformation method, for example, the organic EL display as shown in Fig. 2, have an organic thin film layer 30 for blue light emission arranged on the whole surface of an electrode 25 situated corresponding to the pixel, and further on this layer, a transparent electrode 20. And on the transparent electrode 20, color transformation layer 60 for red light emission and laminate of red color filter 65, and color transformation layer 70 for green light emission and laminate of green color filter 80 are situated through a protecting layer (flattened layer) 15. And on these, a glass plate 10 is arranged.

If a voltage is applied between the electrode 25 and the transparent electrode 20 in this organic EL display, the organic thin film layer 30 for blue light emission shows blue light emission. One part of this blue light emission transmits through the transparent electrode 20, transmits through the protecting layer 15 and the glass plate 10 as it is and emitted to the exterior. On the other hand, in the area where the color transformation layer 60 for red light emission and the color transformation layer 70 for green light emission exist, the aforementioned blue light emission is converted to red light and green light, respectively, in these color transformation layers and further by transmitting through red color filter 65 and green color filter 80, they become red light emission and green light emission, respectively, and transmit through the glass plate 10. As a result, full color display is possible in this organic EL display.

In the case of color transformation layer 60 and 70, formed by organometallic complex (phosphorescent material) of the present invention, particularly, even without combination with host material and the like in color transformation layer for red light emission, a single film of the organometallic complex is able to be made and besides easy manufacturing, they are excellent in color transformation efficiency. Fig. 3 shows a structure of organic EL display by the three colors light-emitting method, and Fig. 4 shows a structure of organic EL display by the white method. The codes in Fig. 3 and Fig. 4 mean the identical ones with the codes in Fig. 2.

In manufacturing the full color organic EL display by the aforementioned three color light emitting method, for example, in the case of using the aforementioned organic EL element of the present invention for red light emission (the aforementioned organic EL element of the present invention may be used for light emission of other colors and all the colors may be formed by the aforementioned organic EL element of the present invention), an organic EL element for green light emission and organic EL element for blue light emission are further required in addition.

The organic EL element for the aforementioned blue light emission have no particular limitation which may be suitably selected from the publicly known layer composition such as ITO (positive electrode)/NPD/Al-Li (negative electrode), and the like.

There is no particular limitation on the organic EL element for green light emission which can be selected from those known in the art, and for example the layer composition may be expressed by ITO (positive electrode)/NPD/$Alq_3$/AL-Li (negative electrode).

There is no particular limitation on the organic EL display which may be selected according to the purpose, but the passive matrix panel and active matrix panel disclosed by Nikkei Electronics, No. 765, March 13, 2000, pages 55 to 62 are suitable.

The aforementioned passive matrix panel for example has belt-like positive electrodes 14 (for example, ITO electrodes) arranged parallel to each other on a glass substrate 12. A belt-like organic thin film layer 24 for red light emission, organic thin film layer 26 for blue light emission and organic thin film layer 28 for green light emission are arranged sequentially in parallel and effectively perpendicular to the positive electrode 14 on the positive electrode 14, as shown in Fig. 5. This has negative electrodes 22 of identical shape on the organic thin film layer 24 for red light emission, the organic thin film layer 26 for blue light emission, and the organic thin film layer 28 for green light emission.

In the aforementioned passive matrix panel, positive electrode lines 30 comprising plural positive electrodes 14, and negative electrode lines 32 comprising plural negative electrodes 22, for example intersect effectively at right angles to form a circuit, as shown in Fig.6. Each of the organic thin film layers 24, 26, 28 for red light emission, blue light emission and green light emission situated at each intersection point functions as a pixel, there being plural organic EL elements 34 corresponding to each pixel. In this passive matrix panel, when a current is applied by a constant current source 36 to one of the positive electrodes 14 in the positive electrode lines 30, and one of the negative electrodes 22 in the negative electrode lines 32, a current will be applied to the organic EL thin film layer situated at the intersection, and the organic EL thin film layer at this position will emit light. By controlling the light emission of this pixel unit, a full color picture can easily be formed.

In the active matrix panel, for example, scanning lines, data lines and current supply lines are arranged in a grid pattern on the glass substrate 12, as shown in Fig. 7. A TFT circuit 40 connected by the scanning lines forming the grid pattern is disposed in each square, and an positive electrode 14 (for example, ITO electrode) disposed in each square can be driven by the TFT circuit 40. The belt-like organic thin film layer 24 for red light emission, organic thin film layer 26 for blue light emission and organic thin film layer 28 for green light emission, are arranged sequentially in parallel. The negative electrodes 22 are also arranged so as to cover the organic thin film layer 24 for red light emission, organic thin film layer 26 for blue light emission and organic thin film layer 28 for green light emission. The organic thin film layer 24 for red light emission, organic thin film layer 26 for blue light emission and organic thin film layer 28 for green light emission respectively form a positive hole transporting layer 16, light-emitting layer 18 and electron transporting layer 20.

In the aforementioned active matrix panel, plural scanning lines 46 parallel to each other, plural data lines 42 parallel to each other and current supply lines 44 intersect effectively at right angles to form squares, as shown in Fig. 8, and a switching TFT 48 and drive TFT 50 are connected to each square to form a circuit. If an electric current is applied from a drive circuit 38, the switching TFT 48 and drive TFT 50 can be driven for each square. In each square, the organic thin film elements 24, 26, 28 for blue light emission, green light emission and red light emission function as a pixel. In this active matrix panel, if a current is applied from the drive circuit 38 to one of the scanning lines 46 arranged in the horizontal direction, and the current supply line 44 arranged in the vertical direction, the switching TFT 48 situated at the intersection is driven, the drive TFT 50 is driven as a result, and the organic EL element 52 at this position emits light. By controlling the light emission of this pixel unit, a full color picture can easily be formed.

Hereinafter, specific examples of the present invention will be described, but it should be understood that the present invention is not limited to these examples.

(Synthesis Example 1)

-Synthesis of Pt (3,5-di (2-pyridyl) toluene) (2-fluorophenol) (expressed as "Pt (dpt) (o2Fph)" hereinafter)-

(3,5-di (2-pyridyl) toluene) (expressed as " (dpt) " below) was synthesized as the following. That is, specifically, 3,5-dibromotoluene (5.0 g ; 20 mmol), 2-tri-n-butylstannylpyridine (26.9 g ; 73 mmol), bis(triphenyl-phosphine) palladium dichloride (1.55 g; 2.2 mmol), and lithium chloride (11.7 g ; 276 mmol) were put into 130 ml toluene and refluxed for two days. After standing to cool, to 50 ml KF saturated water solution was added. The deposited solid by filtration was taken out, washed with a small quantity of cooled toluene (20 ml x 3 times) and dried in a vacuum. The obtained solid was put into a mixed solution of dichloromethane and $NaHCO_3$ , and washed thoroughly. The organic layer was separated and after drying with $MgSO_4$ powder, the solvent was removed by an evaporator. A grey color solid object, 3,5-di (2-pyridyl) toluene 2.2 g, recrystallized from dichloromethane, was obtained. The yield was 48 %.

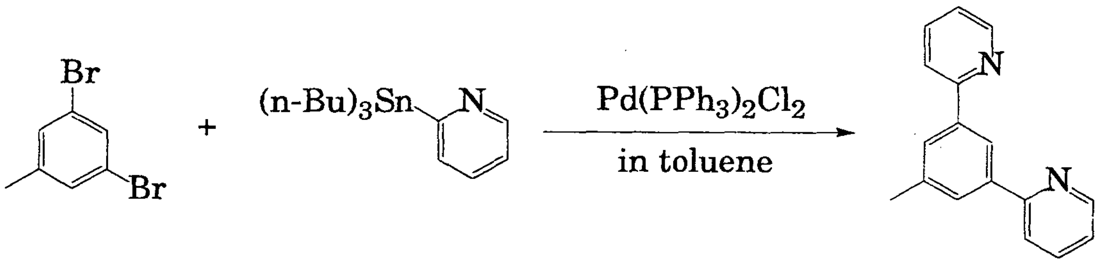


Pt (3,5-di (2-pyridyl) toluene) chloride (expressed as "Pt (dpt) Cl" below) was synthesized as the following. That is, the obtained 3,5-di (2-pyridyl) toluene (300 mg; 1.2 mmol) and $K_2PtCl_4$ (550 mg ;1.3 mmol) were put into degassed acetic acid (30 ml) and refluxed for two days at 130 °C. After cooling to ambient temperature, light yellow crystal was precipitated. The filtrated solid was washed thoroughly with methanol, water and diethyl ether, and dried in a vacuum. A yellow color powder object, Pt (dpt) Cl 436 mg, recrystallized from dichloromethane, was obtained. The yield was 75 %.

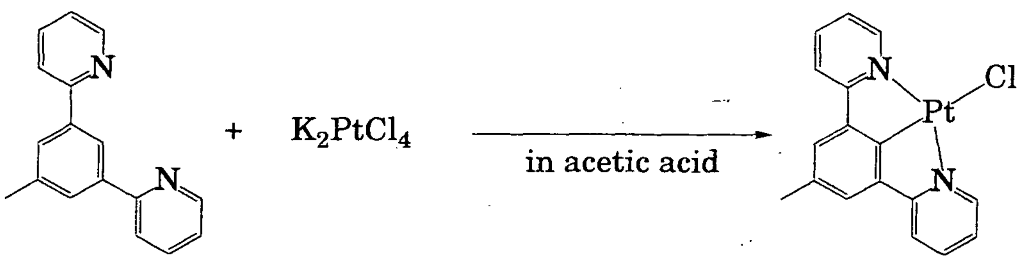


Next, Pt (3,5-di (2-pyridyl) toluene) (2-fluorophenol) (expressed as "Pt (dpt) (o2Fph)" below) was synthesized as the following. That is, the obtained Pt (dpt) Cl 200 mg (0.21 mmol) was put into acetone 30 ml and stirred. At this point, 2-fluorophenol 47 mg (0.42 mmol) was slowly added. At room temperature, this was stirred for 10 minutes. If a few drops of pure water are added, the reaction proceeds, and yellow color solid started to deposit and this was stirred for 3 hours while heated. This was let to cooled, the deposited light yellow color solid was filtrated, washed thoroughly with pure water, methanol, diethyl ether by turns, dried in a vacuum and the yellow color solid of Pt (dpt) (o2Fph) was obtained. The yield was 50 %.

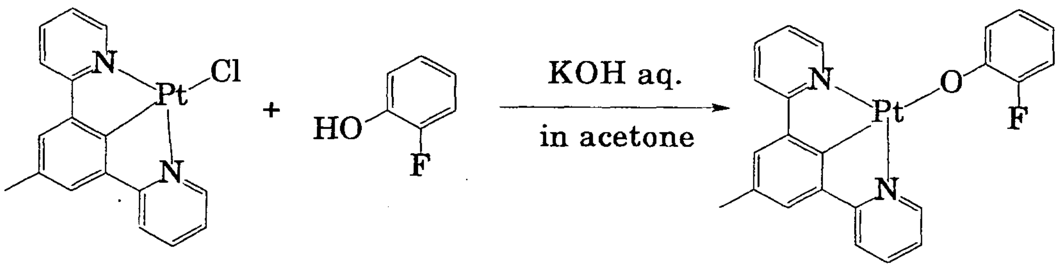


(Synthesis Example 2)

-Synthesis of Pt (3,5-di (2-pyridyl) toluene) (2,6-dimethyl-phenol) (expressed as "Pt (dpt) (odmp)" hereinafter)-

Except for 2-fluorophenol in synthesis example 1 which was changed to 2,6-dimethyl-phenol, light yellow color solid of Pt (dpt) (odmp) was obtained in the same way as synthesis example 1. The yield was 65 %.

(Synthesis Example 3)

-Synthesis of Pt (3,5-di (2-pyridyl) toluene) (2-phenylphenol) (expressed as "Pt (dpt) (o2pph)" hereinafter)-

Except for 2-fluorophenol in synthesis example 1 which was changed to 2-phenylphenol, light yellow color solid of Pt (dpt) (o2pph) was obtained in the same way as synthesis example 1. The yield was 70 %.

(Synthesis Example 4)

-Synthesis of Pt (3,5-di (2-pyridyl) toluene) (2,6-diphenylphenol) (expressed as "Pt (dpt) (o26dpph)" hereinafter)-

Except for 2-fluorophenol in synthesis example 1 which was changed to 2,6-diphenylphenol, yellow color solid of Pt (dpt) (o26dpph) was obtained in the same way as synthesis example 1. The yield was 60 %.

(Synthesis Example 5)

-Synthesis of Pt (3,5-di (2-pyridyl) toluene) (3,5-dimethylpyrazole) (expressed as "Pt (dpt) (dmpr)" hereinafter)-

Except for 2-fluorophenol in synthesis example 1 which was changed to 3,5-dimethylpyrazole, light yellow color solid of Pt (dpt) (dmpr) was obtained in the same way as synthesis example 1. The yield was 68 %.

(Synthesis Example 6)

-Synthesis of Pt (3,5-di (2-pyridyl) toluene) (5-methyl-1H-1,2,3-benzotriazole) (expressed as "Pt (dpt) (mbtaz)" hereinafter)-

Except for 2-fluorophenol in synthesis example 1 which was changed to 5-methyl-1H-1,2,3-benzotriazole, light yellow color solid of Pt (dpt) (mbtaz) was obtained in the same way as synthesis example 1. The yield was 62 %.

(Synthesis Example 7)

-Synthesis of Pt (1,3-di (2-pyridyl) benzene) (2-fluorophenol) (expressed as "Pt (dpb) (o2Fph)" hereinafter)-

(1,3-di (2-pyridyl) benzene) (expressed as " (dpb) " hereinafter) was synthesized as the following. That is, specifically, 1,3-dibromobenzene (4.74 g; 20 mmol) and, 2-tri-n-butylstannylpyridine (26.9 g; 73 mmol), and bis(triphenylphosphine) palladium dichloride (1.55 g; 2.2 mmol), and lithium chloride (11.7 g; 276 mmol), were put into 130 ml toluene and refluxed for two days. After standing to cool, 50 ml KF saturated water solution was added. The deposited solid by filtration was taken out, washed with a small quantity of cooled toluene (20 ml x 3 times) and dried in a vacuum. The obtained solid was put into a mixed solution of dichloromethane and $NaHCO_3$ , and washed thoroughly. The organic layer was separated and after drying with $MgSO_4$ powder, the solvent was removed by an evaporator. A grey color solid object, 1,3-di (2-pyridyl) benzene 2.3 g, decrystallized by dichloromethane, was obtained. The yield was 50 %.

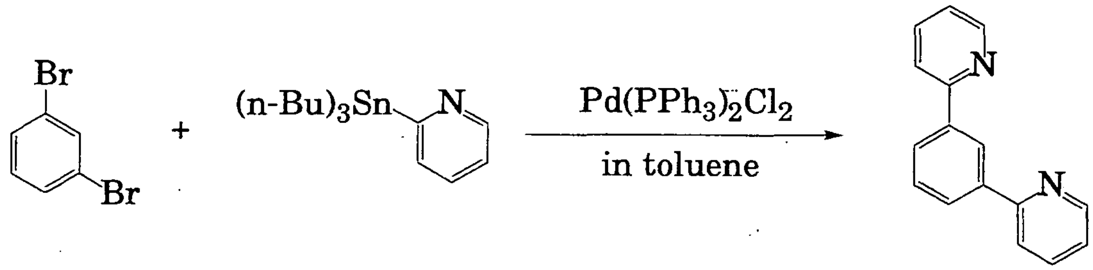


Pt (1,3-di (2-pyridyl) benzene) chloride (expressed as "Pt (dpb) Cl" below) was synthesized as the following. That is, the obtained 1,3-di (2-pyridyl) benzene (283 mg; 1.22 mmol) and $K_2PtCl_4$ (550 mg;1.33 mmol) were put into degassed acetic acid (30 ml) and refluxed for two days at 130°C. After cooling to ambient temperature, light yellow crystal was precipitated. The filtrated solid was washed thoroughly with methanol, water and diethyl ether, and dried in a vacuum. The obtained rough powder was recrystallized from dichloromethane and the object of yellow color powder, Pt (dpb) Cl 410 mg, was obtained. The yield was 72 %.

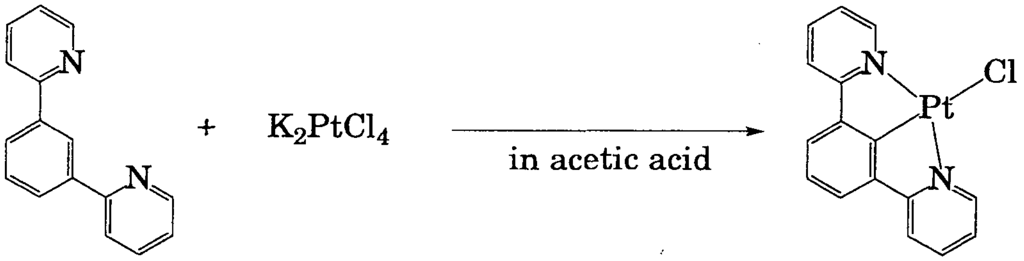


Next, Pt (1,3-di (2-pyridyl) benzene) (2-fluorophenol) chloride (expressed as "Pt (dpb) (o2Fph)" below) was synthesized as the following. That is, the obtained Pt (dpb) Cl 100 mg (0.22 mmol) was put into acetone 30 ml and stirred. At this point, 2-fluorophenol 49 mg (0.44 mmol) was slowly added. At room temperature, this was stirred for 10 minutes. If a few drops of pure water are added, the reaction proceeds, and yellow color solid started to deposit and this was stirred for 3 hours while heated. This was let to cooled, the deposited light yellow color solid was filtrated, washed thoroughly with pure water, methanol, diethyl ether by turns, dried in a vacuum and the yellow color solid of Pt (dpb) (o2Fph) was obtained. The yield was 45 %.

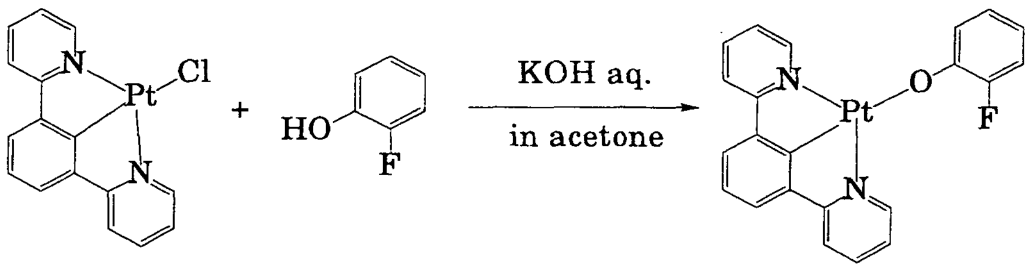


(Synthesis Example 8)

-Synthesis of Pt (1,3-di (2-pyridyl) benzene) (2,6-dimethyl-phenol) (expressed as "Pt (dpb) (odmp)" hereinafter)-

Except for 2-fluorophenol in synthesis example 7 which was changed to 2,6-dimethyl-phenol, light yellow color solid of Pt (dpb) (odmp) was obtained in the same way as synthesis example 7. The yield was 58 %.

(Synthesis Example 9)

-Synthesis of Pt (1,3 -di (2-pyridyl) benzene) (2-phenylphenol) (expressed as "Pt (dpb) (o2pph)" hereinafter)-

Except for 2-fluorophenol in synthesis example 7 which was changed to 2-phenylphenol, yellow color solid of Pt (dpb) (o2pph) was obtained in the same way as synthesis example 7. The yield was 64 %.

(Synthesis Example 10)

-Synthesis of Pt (1,3-di (2-pyridyl) benzene) (2,6-diphenylphenol) (expressed as "Pt (dpb) (o26dpph)" hereinafter)-

Except for 2-fluorophenol in synthesis example 7 which was changed to 2,6-diphenylphenol, yellow color solid of Pt (dpb) (o26dpph) was obtained in the same way as synthesis example 7. The yield was 53 %.

(Synthesis Example 11)

-Synthesis of Pt (1,3-di (2-pyridyl) benzene) (3,5-dimethylpyrazole) (expressed as "Pt (dpb) (dmpr)" hereinafter)-

Except for 2-fluorophenol in synthesis example 7 which was changed to 3,5-dimethylpyrazole, yellow color solid of Pt (dpb) (dmpr) was obtained in the same way as synthesis 7. The yield was 55 %.

(Synthesis Example 12)

-Synthesis of Pt (1,3-di (2-pyridyl) benzene) (5-methyl-1H-1,2,3-benzotriazole) (expressed as "Pt (dpb) (mbtaz)" hereinafter)-

Except for 2-fluorophenol in synthesis example 7 which was changed to 5-methyl-1H-1,2,3-benzotriazole, yellow color solid of Pt (dpb) (mbtaz) was obtained in the same way as synthesis example 7. The yield was 50 %.

(Synthesis Example 13)

-Synthesis of Pt (3,5-di (1-isoquinolyl) toluene) (2-fluorophenol) (expressed as "Pt (diqt) (o2Fph)" hereinafter)-

(3,5-di (1-isoquinolyl) toluene) (expressed as " (diqt) " below) was synthesized as the following. That is, specifically, 3,5-dibromotoluene (5.0 g; 20 mmol), 2-tri-n-butylstannyl-iso-quinoline (28.8 g; 73 mmol), bis(triphenyl-phosphine) palladium dichloride (1.55 g ; 2.2 mmol), and lithium chloride (11.7 g_; 276 mmol) were put into 130 ml toluene and refluxed for two days. After standing to cool, 50 ml KF saturated water solution was added. The deposited solid by filtration was taken out, washed with a small quantity of cooled toluene (20 ml x 3 times) and dried in a vacuum. The obtained solid was put into a mixed solution of dichloromethane and $NaHCO_3$, and washed thoroughly. The organic layer was separated and after drying with $MgSO_4$ powder, the solvent was removed by an evaporator. A grey color solid object, 3,5-di (1-isoquinolyl) toluene 2.8 g, decrystallized by dichloromethane, was obtained. The yield was 41 %.

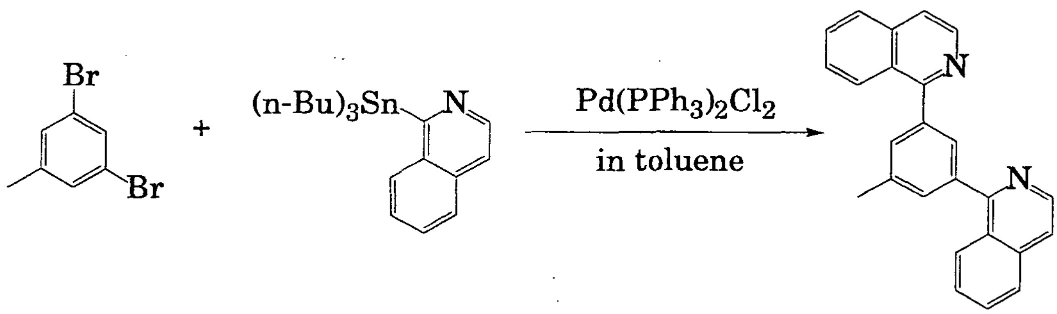


Pt (3,5-di (1-isoquinolyl) toluene) chloride (expressed as "Pt (diqt) Cl" below) was synthesized as the following. That is, the obtained 3,5-di (1-isoquinolyl) toluene (422 mg; 1.22 mmol) and $K_2PtCl_4$ (550 mg;1.33 mmol) were put into degassed acetic acid (30 ml) and refluxed for two days at 130 °C. After cooling to ambient temperature, light yellow crystal was precipitated. The filtrated solid was washed thoroughly with methanol, water and diethyl ether, and dried in a vacuum. The obtained rough powder was recrystallized from dichloromethane and the object of yellow color powder, Pt (diqt) Cl 452 mg, was obtained. The yield was 64 %.

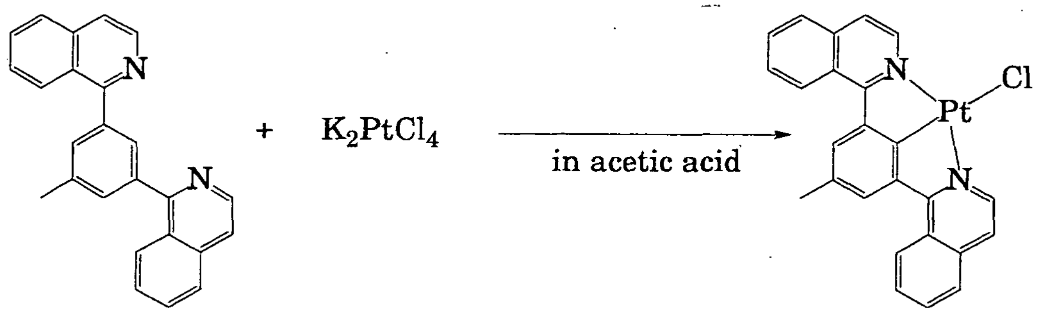


Next, Pt (3,5-di (1-isoquinolyl) toluene) (2-fluorophenol) (expressed as "Pt (diqt) (o2Fph)" hereinafter) was synthesized as the following. That is, the obtained Pt (diqt) Cl 127 mg (0.22 mmol) was put into acetone 30 ml and stirred. At this time, 2-fluorophenol 49 mg (0.44 mmol) was slowly added. At room temperature, this was stirred for 10 minutes. If a few drops of pure water are added, the reaction proceeds, and yellow color solid started to deposit and this was stirred for 3 hours while heated. This was let to cooled, the deposited light yellow color solid was filtrated, washed thoroughly with pure water, methanol, diethyl ether by turns, dried in a vacuum and the yellow color solid of Pt (diqt) (o2Fph) was obtained. The yield was 45 %.

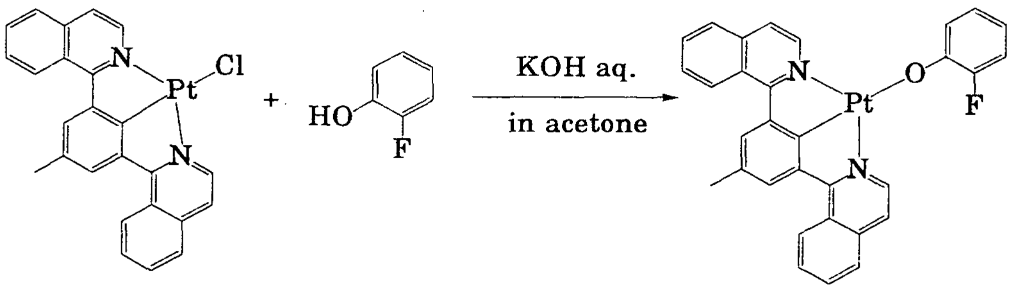


(Synthesis Example 14)

-Synthesis of Pt (3,5-di (1-isoquinolyl) toluene)

(2,6-dimethyl-phenol) (expressed as "Pt (diqt) (odmp)" hereinafter)-

Except for 2-fluorophenol in synthesis example 13 which was changed to 2,6-dimethyl-phenol, brown color solid of Pt (diqt) (odmp) was obtained in the same way as synthesis example 13. The yield was 45 %.

(Synthesis Example 15)

-Synthesis of Pt (3,5 -di (1-isoquinolyl) toluene) (2-phenylphenol) (expressed as "Pt (diqt) (o2pph)" hereinafter)-

Except for 2-fluorophenol in synthesis example 13 which was changed to 2-phenylphenol, brown color solid of Pt (diqt) (o2pph) was obtained in the same way as synthesis example 13. The yield was 42 %.

(Synthesis Example 16)

-Synthesis of Pt (3,5-di (1-isoquinolyl) toluene) (2,6-diphenylphenol) (expressed as "Pt (diqt) (o26dpph)" hereinafter)-

Except for 2-fluorophenol in synthesis example 13 which was changed to 2,6-diphenylphenol, brown color solid of Pt (diqt) (o26dpph) was obtained in the same way as synthesis example 13. The yield was 40 %.

(Synthesis Example 17)

-Synthesis of Pt (3,5-di (1-isoquinolyl) toluene) (3,5-dimethylpyrazole) (expressed as "Pt (diqt) (dmpr)" hereinafter)-

Except for 2-fluorophenol in synthesis example 13 which was changed to 3,5-dimethylpyrazole, reddish-brown

color solid of Pt (diqt) (dmpr) was obtained in the same way as synthesis 13. The yield was 40 %.

(Synthesis Example 18)

-Synthesis of Pt (3,5-di (1-isoquinolyl) toluene) (5-methyl-1H-1,2,3-benzotriazole) (expressed as "Pt (diqt) (mbtaz)" hereinafter)-

Except for 2-fluorophenol in synthesis example 13 which was changed to 5-methyl-1H-1,2,3-benzotriazole, red color solid of Pt (diqt) (mbtaz) was obtained in the same way as synthesis example 13. The yield was 42 %.

(Synthesis Example 19)

-Synthesis of Pt (3,5-terpyridine) (2-fluorophenol) (expressed as "Pt (tp) (o2Fph)" hereinafter)-

3,5-terpyTidine (expressed as " (tp) " hereinafter) was synthesized as the following. That is, specifically, 3,5-dibromotoluene (4.74 g; 20 mmol) and, 2-tri-n-butylstannylpyridine (26.9 g; 73 mmol), and bis(triphenyl-phosphine) palladium dichloride (1.55 g; 2.2 mmol), and lithium chloride (11.7 g; 276 mmol), were put into 130 ml toluene and refluxed for two days. After standing to cool, 50 ml KF saturated water solution was added. The deposited solid by filtration was taken out, washed with a small quantity of cooled toluene (20 ml x 3 times) and dried in a vacuum. The obtained solid was put into a mixed solution of dichloromethane and $NaHCO_3$, and washed thoroughly. The organic layer was separated and after drying with $MgSO_4$ powder, the solvent was removed by an evaporator. A grey color solid object, 3,5-terpyridine 2.3 g, decrystallized by dichloromethane, was obtained. The yield was 40 %.

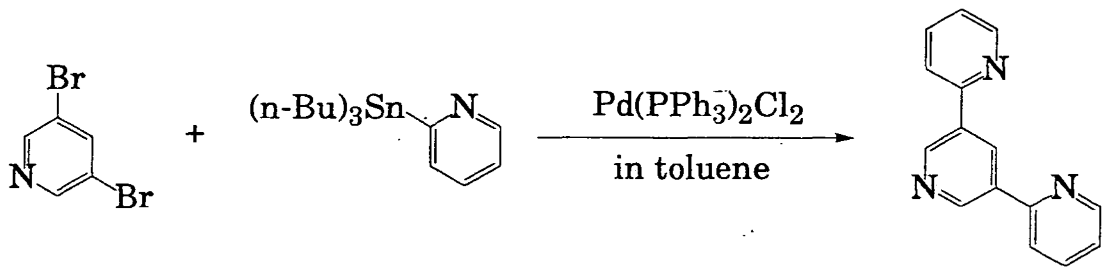


Pt (3,5-terpyridine) chloride (expressed as "Pt (tp) Cl" hereinafter) was synthesized as the following. That is, the obtained 3,5-terpyridine (284 mg; 1.22 mmol) and $K_2PtCl_4$ (550 mg;1.33 mmol) were put into degassed acetic acid (30 ml) and refluxed for two days at 130 °C. After cooling to ambient temperature, light yellow crystal was precipitated. The filtrated solid was washed thoroughly with methanol, water and diethyl ether, and dried in a vacuum. The obtained rough powder was recrystallized from dichloromethane and the object of yellow color powder, Pt (tp) Cl 390 mg, was obtained. The yield was 69 %.

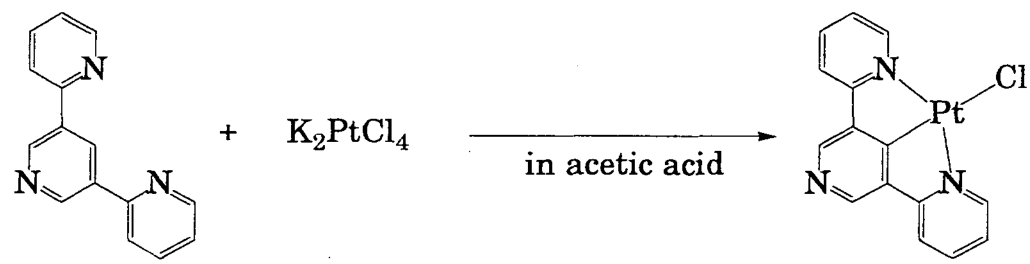


Next, Pt (3,5-terpyridine) (2-fluorophenol) (expressed as "Pt (tp) (o2Fph)" below) was synthesized as the following. That is, the obtained Pt (tp) Cl 122 mg (0.22 mmol) was put into acetone 30 ml and stirred. At this point, 2-fluorophenol 49 mg (0.44 mmol) was slowly added. At room temperature, this was stirred for 10 minutes. If a few drops of pure water are added, the reaction proceeds, and yellow color solid started to deposit and this was stirred for 3 hours while heated. This was let to cooled, the deposited yellow color solid was filtrated, washed thoroughly with pure water, methanol, diethyl ether by turns, dried in a vacuum and the yellow color solid of Pt(tp) (o2Fph) was obtained. The yield was 60 %.

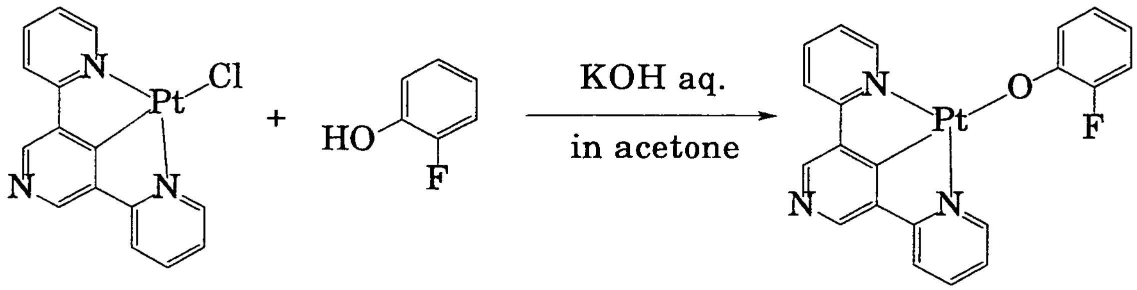


(Synthesis Example 20)

-Synthesis of Pt (3,5-terpyridine) (2,6-dimethyl-phenol) (expressed as "Pt (tp) (odmp)" hereinafter)-

Except for 2-fluorophenol in synthesis example 19 which was changed to 2,6-dimethyl-phenol, light yellow color solid of Pt (tp) (odmp) was obtained in the same way as synthesis example 19. The yield was 40 %.

(Synthesis Example 21)

-Synthesis of Pt (3,5-terpyridine) (2-phenylphenol) (expressed as "Pt (tp) (o2pph)" hereinafter)-

Except for 2-fluorophenol in synthesis example 19 which was changed to 2-phenylphenol, light yellow color solid of Pt (tp) (o2pph) was obtained in the same way as synthesis example 19. The yield was 35 %.

(Synthesis Example 22)

-Synthesis of Pt (3,5-terpyridine) (2,6-diphenylphenol) (expressed as "Pt (tp) (o26dpph)" hereinafter)-

Except for 2-fluorophenol in synthesis example 19 which was changed to 2,6-diphenylphenol, yellow color solid of Pt (tp) (o26dpph) was obtained in the same way as synthesis example 19. The yield was 32 %.

(Synthesis Example 23)

-Synthesis of Pt (3,5-terpyridine) (3,5-dimethylpyrazole) (expressed as "Pt (tp) (dmpr)" hereinafter)-

Except for 2-fluorophenol in synthesis example 19 which was changed to 3,5-dimethylpyrazole, yellow color solid of Pt (tp) (dmpr) was obtained in the same way as synthesis 19. The yield was 37 %.

(Synthesis Example 24)

-Synthesis of Pt (3,5-terpyridine) (5-methyl-1H-1,2,3-benzotriazole) (expressed as "Pt (tp) (mbtaz)" below)-

Except for 2-fluorophenol in synthesis example 19 which was changed to 5-methyl-1H-1,2,3-benzotriazole, yellow color solid of Pt (tp) (mbtaz) was obtained in the same way as synthesis example 19. The yield was 38 %.

(Synthesis Example 25)

-Synthesis of Pt (1,3-di (N-pyrazolyl) benzene) (2-fluorophenol) (expressed as "Pt (dpzb) (o2Fph)" hereinafter)-

1,3-di (N-pyrazolyl) benzene (expressed as " (dpzb) " below) was synthesized as the following. That is, specifically, 1,3-diiodobenzene (6.6 g ; 20 mmol), pyrazole (3.26 g ; 48 mmol), CuI (76 mg ; 0.4 mmol), *trans*-diaminocyclohexane (456 mg ; 4 mmol), potassium phosphate (17.8 g ; 84 mmol), and dodecane (1.36 g ; 8 mmol), were put into 40 ml dioxane and refluxed for two days. After standing to cool, 120 ml ethyl acetate was added and further, 600 ml ethyl acetate as efflux was put through silica gel column. The efflux was concentrated. The object (light yellow color crystal), 1,3-di (N-pyrazolyl) benzene 2.2 g was obtained by column chromatography using efflux of hexane : ethyl acetate = 50 : 1 and silica gel column. The yield was 52 %.

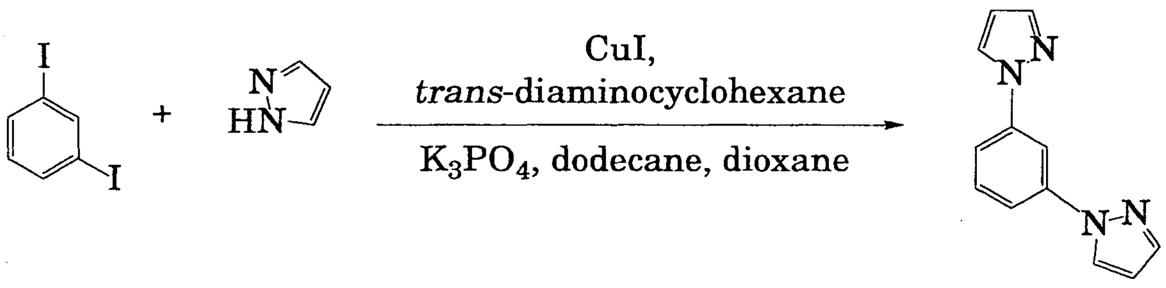


Pt (1,3-di (N-pyrazolyl) benzene) chloride (expressed as "Pt (dpzb) Cl" below) was synthesized as the following. That is, the obtained 1,3-di (N-pyrazolyl) benzene (256 mg ; 1.22 mmol) and $K_2PtCl_4$ (550 mg ;1.33 mmol) were put into degassed acetic acid (30 ml) and refluxed for two days at 130°C. After cooling to ambient temperature, light yellow crystal was precipitated. The filtrated solid was washed thoroughly with methanol, water and diethyl ether, and dried in a vacuum. The obtained rough powder was recrystallized from dichloromethane and the object of yellow color powder, Pt (dpzb) Cl 410 mg, was obtained. The yield was 76 %.

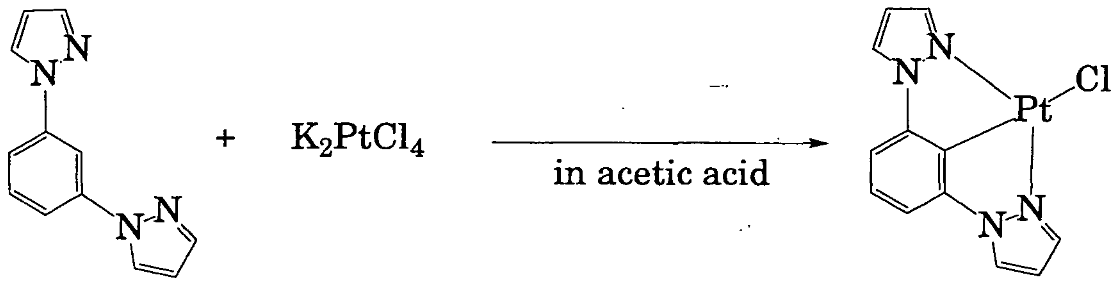


Next, Pt (1,3-di (N-pyrazolyl) benzene) (2-fluorophenol) chloride (expressed as "Pt (dpzb) (o2Fph)" below) was synthesized as the following. That is, the obtained Pt (dpzb) Cl 97 mg (0.22 mmol) was put into acetone 30 ml and stirred. At this point, 2-fluorophenol 49 mg (0.44 mmol) was slowly added. At room temperature, this was stirred for 10 minutes. If a few drops of pure water are added, the reaction proceeds, and yellow color solid started to deposit and this was stirred for 3 hours while heated. This was let to cooled, the deposited yellow color solid was filtrated, washed thoroughly with pure water, methanol, diethyl ether by turns, dried in a vacuum and the yellow color solid of Pt (dpzb) (o2Fph) was obtained. The yield was 45 %.

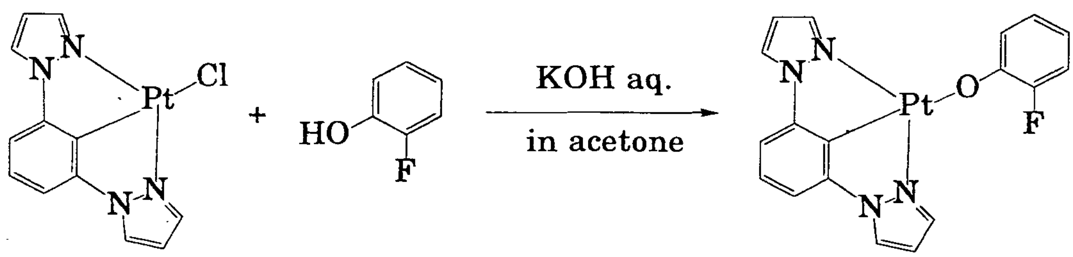


(Synthesis Example 26)

-Synthesis of Pt (1,3-di (N-pyrazolyl) benzene) (2,6-dimethyl-phenol) (expressed as "Pt (dpzb) (odmp)" hereinafter)-

Except for 2-fluorophenol in synthesis example 25 which was changed to 2,6-dimethyl-phenol, light yellow color solid of Pt (dpzb) (odmp) was obtained in the same way as synthesis example 25. The yield was 43 %.

(Synthesis Example 27)

Synthesis of Pt (1,3 -di (N-pyrazolyl) benzene) (2-phenylphenol) (expressed as "Pt (dpzb) (o2pph)" hereinafter)-

Except for 2-fluorophenol in synthesis example 25 which was changed to 2-phenylphenol, light yellow color solid of Pt (dpzb) (o2pph) was obtained in the same way as synthesis example 25. The yield was 40 %.

(Synthesis Example 28)

-Synthesis of Pt (1,3-di (N-pyrazolyl) benzene) (2,6-diphenylphenol) (expressed as "Pt (dpzb) (o26dpph)" hereinafter)-

Except for 2-fluorophenol in synthesis example 25 which was changed to 2,6-diphenylphenol, yellow color solid of Pt (dpzb) (o26dpph) was obtained in the same way as synthesis example 25. The yield was 36 %.

(Synthesis Example 29)

-Synthesis of Pt (1,3-di (N-pyrazolyl) benzene) (3,5-dimethylpyrazole) (expressed as "Pt (dpzb) (dmpr)" hereinafter)-

Except for 2-fluorophenol in synthesis example 25 which was changed to 3,5-dimethylpyrazole, yellow color solid of Pt (dpzb) (dmpr) was obtained in the same way as synthesis 25. The yield was 40 %.

(Synthesis Example 30)

-Synthesis of Pt (1,3-di (N-pyrazolyl) benzene) (5-methyl-1H-1,2,3-benzotriazole) (expressed as "Pt (dpzb) (mbtaz)" hereinafter)-

Except for 2-fluorophenol in synthesis example 25 which was changed to 5-methyl-1H-1,2,3-benzotriazole, yellow color solid of Pt (dpzb) (mbtaz) was obtained in the same way as synthesis example 25. The yield was 38 %.

(Synthesis Example 31)

-Synthesis of Pt (3,5-di (2-pyridyl) toluene) (2,6-dimethyl-thiophenol) (expressed as "Pt (dpt) (sdmp)" hereinafter)-

Except for 2-fluorophenol in synthesis example 1 which was changed to 2,6-dimethyl-thiophenol, light yellow color solid of Pt (dpt) (sdmp) was obtained in the same way as synthesis example 1. The yield was 67 %.

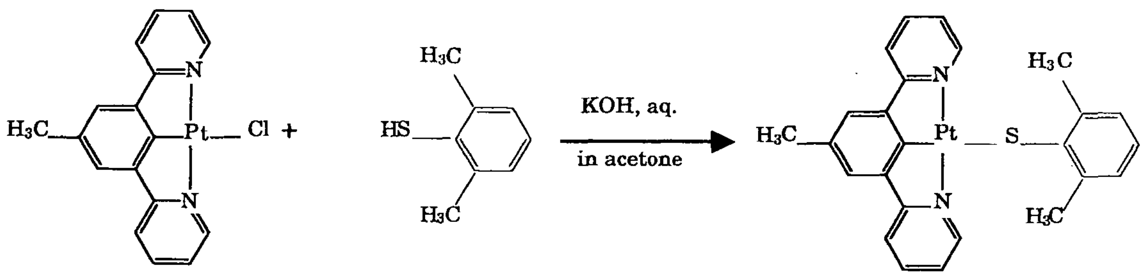


(Synthesis Example 32)

-Synthesis of Pt (3,5-di (2-pyridyl) toluene) (2-chlorophenol) (expressed as "Pt (dpt) (o2Clph)" hereinafter)-

Except for 2-fluorophenol in synthesis example 1 which was changed to 2-chlorophenol, light yellow color solid of Pt (dpt) (o2Clph) was obtained in the same way as synthesis example 1. The yield was 65 %.

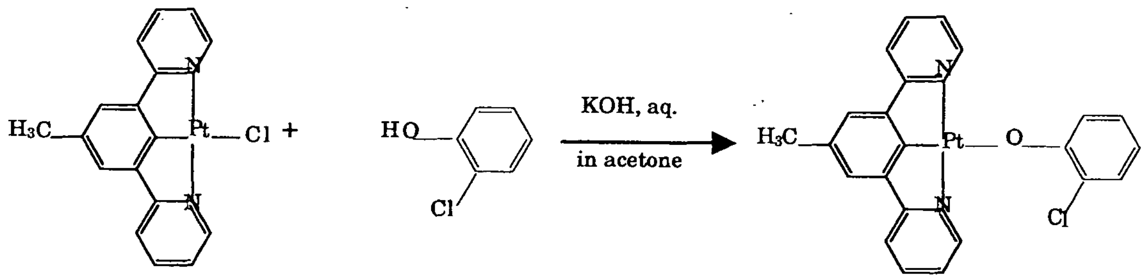

(Synthesis Example 33)

-Synthesis of Pt (3,5-di (2-pyridyl) toluene) (2-bromophenol) (expressed as "Pt (dpt) (o2Brph)" hereinafter)-

Except for 2-fluorophenol in synthesis example 1 which was changed to 2-bromophenol, light yellow color solid of Pt (dpt) (o2Brph) was obtained in the same way as synthesis example 1. The yield was 53 %.

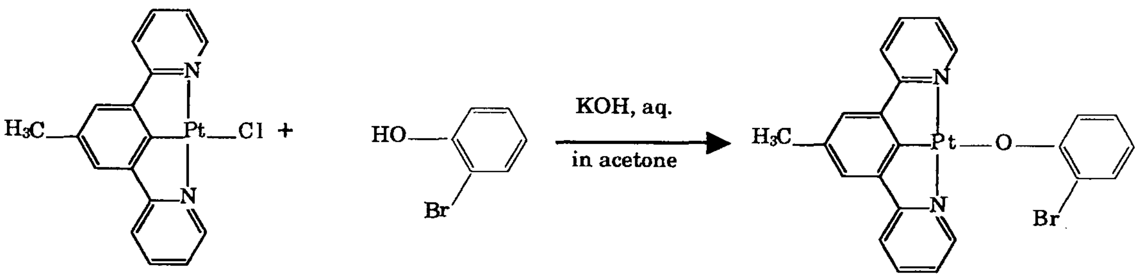


(Comparative Synthesis Example 1)

-Synthesis of Pt (3,5-di (2-pyridyl) toluene) (biphenyloxalate) (expressed as "Pt (dpt) (oph)" hereinafter)-

Pt (3,5-di (2-pyridyl) toluene) chloride Cl 100 mg (0.21 mmol) was added to acetone 30 ml and stirred. At this time, sodium phenoxide trihydrate 53 mg (0.32 mmol) dissolved in methanol 20 ml was slowly dropped and stirred for 10 minutes at room temperature. If a few drops of water are dropped, the reaction proceeds, and light yellow color solid started to deposit and this was stirred for 3 hours while heated. This was let to cooled, the deposited light yellow color solid was filtrated, washed thoroughly with pure water, methanol, diethyl ether by turns, dried in a vacuum and the object, light yellow color solid of Pt (dpt) (oph) was obtained. The yield was 80 %.

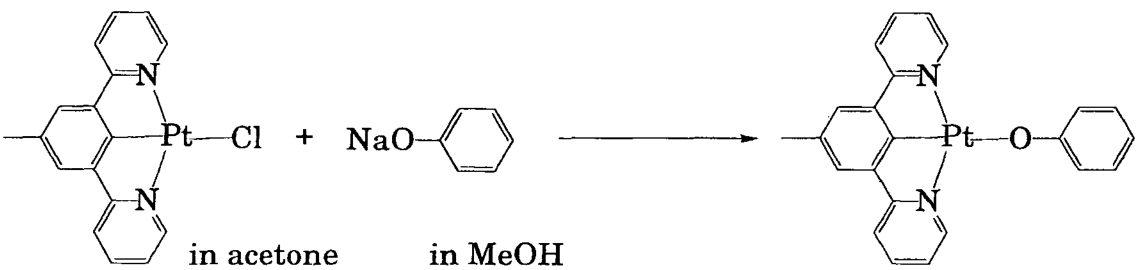


(Comparative Synthesis Example 2)

-Synthesis of Pt (3,5-di (2-pyridyl) toluene) (1,2,4-triazolate) (expressed as "Pt (dpt) (taz)" hereinafter)-

Pt (3,5-di (2-pyridyl) toluene) chloride Cl 100 mg (0.21 mmol) was added to acetone 30 ml and stirred. At this time, 1,2,4-triazole sodium 29 mg (0.32 mmol) dissolved in methanol 20 ml was slowly dropped and stirred for 10 minutes at room temperature. If a few drops of water are dropped, the reaction proceeds, and yellow color solid started to deposit and this was stirred for 3 hours while heated. This was let to cool, the deposited yellow color solid was filtrated, washed thoroughly with pure water, methanol, diethyl ether by turns, dried in a vacuum and the object, yellow color solid of Pt (dpt) (taz) was obtained. The yield was 82 %.

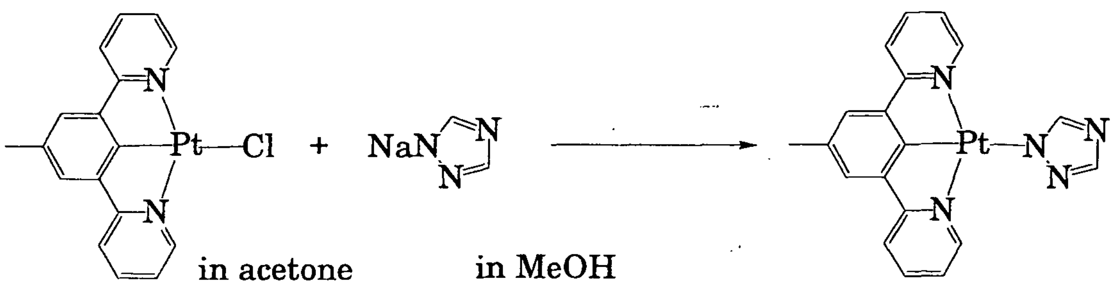

(Comparative Synthesis Example 3)

-Synthesis of Pt (3,5-di (2-pyridyl) toluene) (2-benzothiazoloxalate) (expressed as "Pt (dpt) (obtz)" hereinafter)-

Pt (3,5-di (2-pyridyl) toluene) chloride Cl 100 mg (0.21 mmol) and 2-hydroxybenzothiazole was added to dimethyl sulfoxide (DMSO) 30 ml and stirred. At this time, KOH powder 200 mg (3.5 mmol) was added and stirred for 10 minutes at room temperature. If a few drops of pure water are added, the reaction proceeds, and yellow solid started to deposit and this was stirred for 3 hours while heated. This was let to cooled, the deposited yellow color solid was filtrated, washed thoroughly with pure water, methanol, diethyl ether by turns, dried in a vacuum and the yellow color solid of Pt (dpt) (obtz) was obtained. The yield was 69 %.

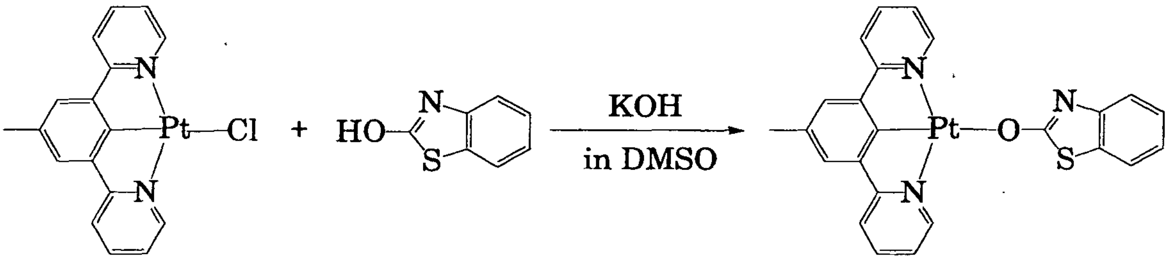


(Comparative Synthesis Example 4)

-Synthesis of Pt (1,3-di (2-pyridyl) benzene) (biphenyl oxalate) (expressed as "Pt (dpb) (oph)" hereinafter)-

Except for Pt (3,5-di (2-pyridyl) toluene) chloride in comparative synthesis example 1 which was changed to Pt (1,3-di (2-pyridyl) benzene) chloride, orange color solid of Pt (dpb) (oph) was obtained in the same way as comparative synthesis example 1. The yield was 45 %.

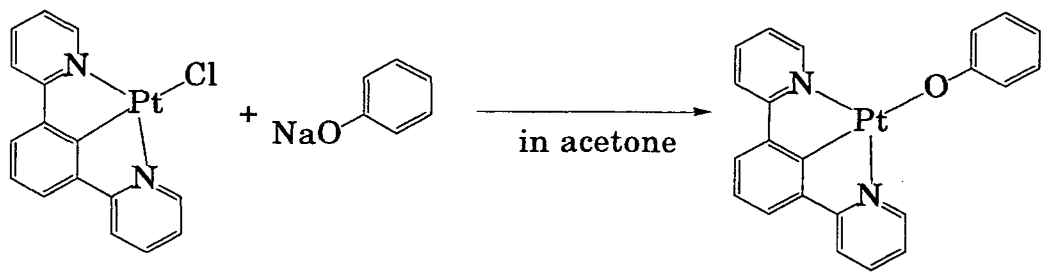


(Comparative Synthesis Example 5)

-Synthesis of Pt (3,5-di (1-isoquinolyl) toluene) (biphenyl oxide) (expressed as "Pt (diqt) (obp)" hereinafter)-

Except for Pt (3,5-di (2-pyridyl) toluene) chloride in comparative synthesis example 1 which was changed to Pt (3,5-di (1-isoquinolyl) toluene) chloride, orange color solid of Pt (diqt) (obp) was obtained in the same way as comparative synthesis example 1. The yield was 83 %.

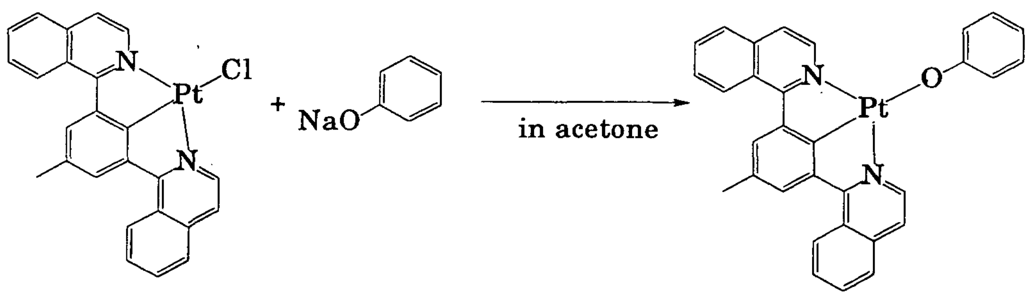

(Comparative Synthesis Example 6)

-Synthesis of Pt (3,5-di (2-pyridyl) pyridine) (phenoxide) (expressed as "Pt (dppr) (oph)" hereinafter)-

Except for Pt (3,5-di (2-pyridyl) toluene) chloride in comparative synthesis example 1 which was changed to Pt (3,5-di (2-pyridyl) pyridine) chloride, orange color solid of Pt (dppr) (oph) was obtained in the same way as comparative synthesis example 1. The yield was 55 %.

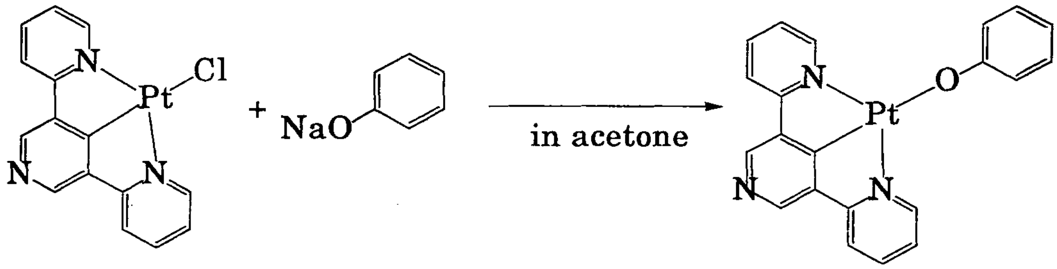


(Comparative Synthesis Example 7)

-Synthesis of Pt (1,3-di (N-pyrazole) benzene) (phenoxide) (expressed as "Pt (dpzb) (oph)" hereinafter)-

Except for Pt (3,5-di (2-pyridyl) toluene) chloride in comparative synthesis example 1 which was changed to Pt (1,3-di (N-pyrazole) benzene) chloride, orange color solid of Pt (dpzb) (oph) was obtained in the same way as comparative synthesis example 1. The yield was 40 %.

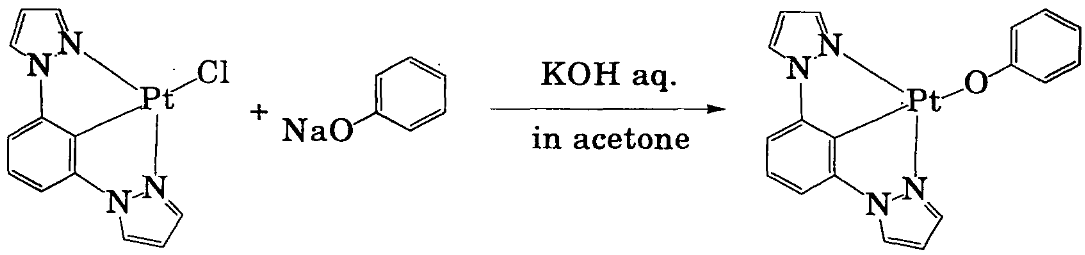


At this point, the aforementioned terdentate ligand and monodentate ligand in each organometallic complex obtained from synthesis example 1 to 33, are expressed in Table 3 and Table 4, respectively. The combination of the aforementioned terdentate ligand and monodentate ligand in synthesis example 1 to 30, is expressed in Table 5.

Table 3

| N^C^N ligand | dpt | dpb | diqt | tp | dpzb |
|---|---|---|---|---|---|
| Structure | 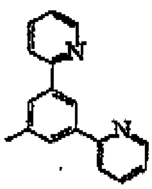 | 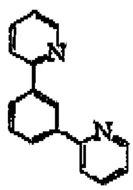 | 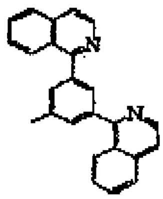 | 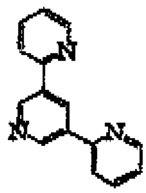 | 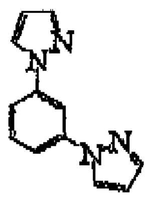 |

Table 4

| Ligand | o2Fph | odmp | o2pph | 026dpph | dmpr | mbtaz |
|---|---|---|---|---|---|---|
| Structure | 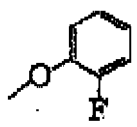 | 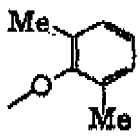 | 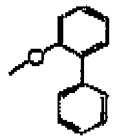 | 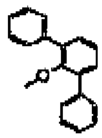 | 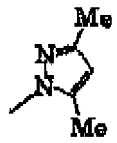 | 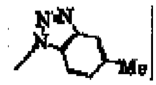 |

Table 5

| Ligand | dpt | dpb | diqt | tp | dpzb |
|---|---|---|---|---|---|
| o2Fph | Synthesis Example 1 | Synthesis Example 7 | Synthesis Example 13 | Synthesis Example 19 | Synthesis Example 25 |
| odmp | Synthesis Example 2 | Synthesis Example 8 | Synthesis Example 14 | Synthesis Example 20 | Synthesis Example 26 |
| o2pph. | Synthesis Example 3 | Synthesis Example 9 | Synthesis Example 15 | Synthesis Example 21 | Synthesis Example 27 |
| o26dpph | Synthesis Example 4 | Synthesis Example 10 | Synthesis Example 16 | Synthesis Example 22 | Synthesis Example 28 |
| dmpr | Synthesis Example 5 | Synthesis Example 11 | Synthesis Example 17 | Synthesis Example 23 | Synthesis Example 29 |
| mbtaz | Synthesis Example 6 | Synthesis Example 12 | Synthesis Example 18 | Synthesis Example 24 | Synthesis Example 30 |

(Example 1) (Reference)

Pt (dpt) (o2Fph), synthesized by synthesis example 1 on a silica glass substrate was manufactured by coevaporation to a thin film of thickness of 50 nm (light-emitting solid), 2 % doped in CBP by vapor deposition rate ratio. The quantum yield of PL (photoluminescence) of this thin film (light-emitting solid), known PL quantum yield tris(8-hydroxyquinoline) aluminum ($Alq_3$) thin film (PL quantum yield : 22%) as the reference, was calculated by the following measurement.

That is, an excitation light (365 nm constant light) from light source is illuminated slantingly on a thin film sample on a transparent substrate. PL photon number [P(sample)] was calculated by conversion from the PL spectrum of the thin film measured by spectroradiometer (Minolta, CS-1000) 104. At the same time of light emission measurement, the total intensity [*I*(sample)] of the transmitted and reflected excited light from the sample was detected by photodiode. Subsequently, the same measurement was also carried out on the reference, Alq3 thin film and the PL photon number [*P*(ref)] of the reference and the total intensity [*I*(ref)] of the transmitted and reflected excited light was calculated. Next, the total Intensity [*I*(substrate)] of the transmitted and reflected excited light on the transparent plate only were calculated. The PL quantum yield of the thin film sample can be calculated by the following formula. The result was shown in Table 6.

$$(PL\ quantum\ efficiency) = \frac{P(sample)/[I(substrate) - I(sample)]}{P(ref.)/[I(substrate) - I(ref.)]} \times 22\%$$

(Examples/Ref. Examples 2 to 30 and 30 a to c and comparative example 1 to 7)

Except for the organometallic complex as light-emitting material which was changed to organometalic complex from Pt (dpt) (o2Fph) to organometallic complex expressed in Table 6 to Table 8 (these were synthesized by the aforementioned synthesis examples), the quantum yield of phosphorescence light emission of the formed thin film (light-emitting solid) was measured under the same condition as example 1. The result is shown in Table 6 to Table 8.

Table 6

| | Light-emitting Material | Emission Peak (nm) | PL Quantum Yield(%) |
|---|---|---|---|
| Ref. Example 1 | Pt(dpt)(o2Fph) | 516 | 99 |
| Ref. Example 2 | Pt(dpt)(odmp) | 529 | 77 |
| Ref. Example 3 | Pt(dpt)(o2pph) | 525 | 94 |
| Ref. Example 4 | Pt(dpt)(o26dpph) | 527 | 97 |
| Ref. Example 5 | Pt(dpt)(dmpr) | 504 | 96 |
| Ref. Example 6 | Pt(dpt)(mbtaz) | 505 | 92 |
| Example 7 | Pt(dpb)(o2Fph) | 505 | 94 |
| Example 8 | Pt(dpb)(odmp) | 516 | 70 |
| Example 9 | Pt(dpb)(o2pph) | 512 | 92 |
| Example 10 | Pt(dpb)(o26dpph) | 515 | 95 |
| Example 11 | Pt(dpb)(dmpr) | 496 | 91 |
| Example 12 | Pt(dpb)(mbtaz) | 497 | 90 |
| Ref. Example 13 | Pt(diqt)(o2Fph) | 605 | 75 |
| Ref. Example 14 | Pt(diqt)(odmp) | 608 | 64 |
| Ref. Example 15 | Pt(diqt)(o2pph) | 603 | 79 |
| Ref. Example 16 | Pt(diqt)(o26dpph) | 605 | 84 |
| Ref. Example 17 | Pt(diqt)(dmpr) | 600 | 80 |
| Ref. Example 18 | Pt(diqt)(mbtaz) | 601 | 75 |
| Example 19 | Pt(tp)(o2Fph) | 475 | 85 |
| Example 20 | Pt(tp)(odmp) | 480 | 72 |
| Example 21 | Pt(tp)(o2pph) | 477 | 84 |
| Example 22 | Pt(tp)(o26dpph) | 479 | 88 |
| Example 23 | Pt(tp)(dmpr) | 474 | 83 |
| Example 24 | Pt(tp)(mbtaz) | 475 | 81 |
| Example 25 | Pt(dpzb)(o2Pph) | 445 | 69 |
| Example 26 | Pt(dpzb)(odmp) | 450 | 56 |
| Example 27 | Pt(dpzb)(o2pph) | 447 | 70 |
| Example 28 | Pt(dpzb)(o26dpph) | 449 | 71 |
| Example 29 | Pt(dpzb)(dmpr) | 443 | 67 |
| Example 30 | Pt(dpzb)(mbtaz) | 445 | 65 |

Table 7

| | Light-emitting Material | Emission Peak (nm) | PL Quantum Yield (%) |
|---|---|---|---|
| Ref. Example 30a | Pt(dpt)(sdmp) | 535 | 91 |
| Ref. Example 30b | Pt(dpt)(o2Clph) | 519 | 94 |
| Ref. Example 30c | Pt(dpt)(o2Brph) | 522 | 91 |

Table 8

| | Light-emitting Material | Emission Peak (nm) | PL Quantum Yield(%) |
|---|---|---|---|
| Comparative Example 1 | Pt(dpt)(oph) | 523 | 98 |
| Comparative Example 2 | Pt(dpt)(taz) | 503 | 98 |
| Comparative Example 3 | Pt(dpt)(obtz) | 504 | 94 |
| Comparative Example 4 | Pt(dpb)(oph) | 511 | 95 |
| Comparative Example 5 | Pt(diqt)(oph) | 608 | 80 |
| Comparative Example 6 | Pt(tp)(oph) | 476 | 85 |
| Comparative Example 7 | Pt(dpzp)(oph) | 447 | 70 |

From the result shown in Table 6 to Table 8, it is obvious that phosphorescence light emission thin film by organometallic complex of the present invention has very high quantum yield of phosphorous light emission.

(Ref. Example 31)

An organic EL element of the laminated type using the obtained organometallic complex Pt (dpt) (o2Fph) as light-emitting material for the light-emitting layer was manufactured. A glass substrate on which an ITO electrode is attached to was cleaned using water, acetone and isopropyl alcohol. Using a vacuum vapor deposition device (degree of vacuum = 1 x $10^{-4}$ Pa, substrate-temperature = room temperature), 4,4',4"-tri (2-naphthylphenylamino) triphenylamine (2-TNATA) was formed as a positive hole injecting layer on this ITO electrode to a thickness of 40 nm. Next the aforementioned NPD as a positive hole transporting layer, was formed to a thickness of 10 nm on this positive hole injecting layer. On the light-emitting layer, the aforementioned BCP was formed as a positive hole blocking layer to a thickness of 20 nm. The aforementioned $Alq_3$ was formed as an electron transporting layer on this positive hole blocking layer to a thickness of 20 nm. On this electron transporting layer, LiF was then vapor deposited to a thickness of 0.5 nm, finally, aluminium was vapor deposited to a thickness of 100 nm, and sealed under a nitrogen atmosphere.

In the manufactured organic EL element of the laminated type from the above, ITO as a positive electrode and aluminium as a negative etectrode, a voltage was applied and the EL properties were measured. When the current density is 5 A/$m^2$, the voltage and current efficiency are shown in Table 8.

(Examples/Ref. Examples 32 to 60 and 60a to 60c, and comparative example 8 to 14)

Except for Pt (dpt) (o2Fph) as the light-emitting material that is changed to the organometallic complex (synthesized by the aforementioned synthesis examples) expressed in Table 8 to Table 10, the organic EL element was manufactured under the same condition as example 31. In these organic EL element, ITO as a positive electrode and aluminium as a negative electrode, a voltage was applied and the EL properties were measured in the same was as example 31. When the current density is 5 A/$m^2$, the voltage and current efficiency are shown in Table 9 to Table 11.

Table 9

| | Light-emitting Material | Voltage (V) | Current Efficiency (cd/A) |
|---|---|---|---|
| Ref. Example 31 | Pt(dpt)(o2Fph) | 6.2 | 58.5 |
| Ref. Example 32 | Pt(dpt)(odmp) | 6.2 | 47,5 |
| Ref. Example 33 | Pt(dpt)(o2pph) | 6.1 | 59.2 |
| Ref. Example 34 | Pt(dpt)(o26dpph) | 6.1 | 60.4 |
| Ref. Example 35 | Pt(dpt)(dmpr) | 6.3 | 57.5 |
| Ref. Example 36 | Pt(dpt)(mbtaz) | 6.3 | 57.9 |
| Example 37 | Pt(dpb)(o2Fph) | 6.3 | 52.5 |
| Example 38 | Pt(dpb)(odmp) | 6.3 | 45.5 |
| Example 39 | Pt(dpb)(o2pph) | 6.3 | 53.6 |
| Example 40 | Pt(dpb)(o26dpph) | 6.2 | 54.8 |

(continued)

| | Light-emitting Material | Voltage (V) | Current Efficiency (cd/A) |
|---|---|---|---|
| Example 41 | Pt(dpb)(dmpr) | 6.3 | 50.1 |
| Example 42 | Pt(dpb)(mbtaz) | 6.4 | 51 |
| Ref. Example 43 | Pt(diqt)(o2Fph) | 5.9 | 13.1 |
| Ref. Example 44 | Pt(diqt)(odmp) | 5.9 | 11.5 |
| Ref. Example 45 | Pt(diqt)(o2pph) | 5.8 | 13.8 |
| Ref. Example 46 | Pt(diqt)(o26dpph) | 5.8 | 14.5 |
| Ref. Example 47 | Pt(diqt)(dmpr) | 5.9 | 13.9 |
| Ref. Example 48 | Pt(diqt)(mbtaz) | 5.9 | 14.1 |
| Example 49 | Pt)(tp)(o2Fph) | 6.8 | 25.3 |
| Example 50 | Pt(tp)(odmp) | 6.8 | 23.7 |
| Example 51 | Pt(tp)(o2pph) | 6.7 | 26.5 |
| Example 52 | Pt(tp)(o26dpph) | 6.7 | 28.3 |
| Example 53 | Pt(tp)(dmpr) | 6.8 | 24.3 |
| Example 54 | Pt(tp)(mbtaz) | 6.8 | 24.9 |
| Example 55 | Pt(dpzb)(o2Fph) | 7.2 | 11.1 |
| Example 56 | Pt(dpzb)(odmp) | 7.2 | 10.2 |
| Example 57 | Pt(dpzb)(o2pph) | 7.1 | 11.3 |
| Example 58 | Pt(dpzb)(o26dpph) | 7.1 | 11.8 |
| Example 59 | Pt(dpzb)(dmpr) | 7.3 | 10.9 |
| Example 60 | Pt(dpzb)(mbtaz) | 7.2 | 11.3 |

Table 10

| | Light-emitting Material | Voltage (V) | Current: Efficiency (cd/A) |
|---|---|---|---|
| Ref. Example 60A | Pt(dpt)(sdmp) | 6.1 | 55.3 |
| Ref. Example 60b | Pt(dpt)(o2Clph) | 6.2 | 48.5 |
| Ref. Example 60c | Pt(dpt)(o2Brph) | 6.2 | 44.2 |

Table 11

| | Light-emitting Material | Voltage (V) | Current Efficiency (cd/A) |
|---|---|---|---|
| Comparative Example 8 | Pt(dpt)(oph) | 6.2 | 59 |
| Comparative Example 9 | Pt(dpt)(taz) | 6.3 | 55.7 |
| Comparative Example 10 | Pt(dpt)(obtz) | 6.2 | 55.9 |
| Comparative Example 11 | Pt(dpb)(oph) | 6.3 | 57.3 |
| Comparative Example 12 | Pt(diqt)(oph) | 5.8 | 13.9 |
| Comparative Example 13 | Pt(tp)(oph) | 6.8 | 25.6 |
| Comparative Example 14 | Pt(dpzp)(oph) | 7.1 | 10.9 |

From the results shown in Table 9 to Table 11, it is apparent that the organic EL element of Examples/Ref. Examples 30 to 60 and 60a to 60c shows very high EL efficiency on the whole.

(Examples/Ref. Examples 61 to 90 and comparative example 15 to 21)

The organic EL elements manufactured in Examples/Ref. Examples 31 to 60 and comparative example 8 to 14, respectively, are continuously droven by current density of 10 $A/m^2$ and the change of the light-emitting luminance was studied. The initial luminance and the luminance half-life time from the initial luminance are shown in Table 12 and Table 13.

Table 12

| | Light-emiting Material | Initial Luminance ($cd/m^2$) in Current Density 10 $A/m^2$ | Luminance- Half-life Time (h) in Current Density 10 $A/m^2$ | Initial Luminance ($cd/m^2$) in Current Density 50 $A/m^2$ | Luminance Half-life Time (h) in Current Density 50 $A/m^2$ |
|---|---|---|---|---|---|
| Ref. Example 61 | Pt(dpt)(o2Pph) | 580 | 1830 | 2610 | 330 |
| Ref. Example 62 | Pt(dpt)(odmp) | 471 | 1930 | 2120 | 350 |
| Ref. Example 63 | Pt(dpt)(o2pph) | 585 | 1790 | 2620 | 320 |
| Ref. Example 64 | Pt(dpt)(o26dpph) | 600 | 1880 | 2680 | 340 |
| Ref. Example 65 | Pt(dpt)(dmpr) | 571 | 1850 | 2550 | 330 |
| Ref. Example 66 | Pt(dpt)(mhtaz) | 574 | 1760 | 2570 | 310 |
| Example 67 | Pt(dpb)(o2Pph) | 522 | 1770 | 2330 | 310 |
| Example 68 | Pt(dpb)(odmp) | 452 | 1910 | 2000 | 350 |
| Example 69 | Pt(dpb)(o2pph) | 534 | 1870 | 2390 | 340 |
| Example 70 | Pt(dpb)(o26dpph) | 545 | 1850 | 2450 | 330 |
| Example 71 | pt(dpb)(dmpr) | 499 | 1790 | 2200 | 320 |
| Example 72 | Pt(dpb)(mbtaz) | 504 | 1790 | 2210 | 320 |
| Ref. Example 73 | Pt(diqt)(o2Dph) | 129 | 3330 | 560 | 690 |
| Ref. Example 74 | Pt(diqt)(odmp) | 112 | 4220 | 490 | 810 |

(continued)

| | Light-emiting Material | Initial Luminance (cd/$m^2$) in Current Density 10 A/$m^2$ | Luminance- Half-life Time (h) in Current Density 10 A/$m^2$ | Initial Luminance (cd/$m^2$) in Current Density 50 A/$m^2$ | Luminance Half-life Time (h) in Current Density 50 A/$m^2$ |
|---|---|---|---|---|---|
| Ref. Example 75 | Pt(diqt)(o2pph) | 135 | 3800 | 590 | 740 |
| Ref. Example 76 | Pt(diqt)(o264dpph) | 142 | 3890 | 620 | 780 |
| Ref. Example 77 | Pt(diqt)(dmpr) | 135 | 3690 | 600 | 730 |
| Ref. Example 78 | Pt(diqt)(mbtaz) | 139 | 3700 | 610 | 730 |
| Example 79 | Pt(tp)(o2Fph) | 260 | 1210 | 1110 | 220 |
| Example 80 | Pt(tp)(odmp) | 235 | 1390 | 1030 | 240 |
| Example 81 | Pt(tp)(o2pph) | 264 | 1240 | 1150 | 220 |
| Example 82 | Pt(tp)(o26dpph) | 285 | 1270 | 1270 | 230 |
| Example 83 | Pt(tp)(dmpr) | 241 | 1190 | 1060 | 210 |
| Example 84 | Pt(tp)(mbtax) | 246 | 1200 | 1090 | 220 |
| Example 85 | Pt(dpzb)(o2Fph) | 108 | 1030 | 470 | 190 |
| Example 86 | Pt(dpzb)(odmp) | 100 | 1150 | 440 | 210 |
| Example 87 | Pt(dpzb)(o2pph) | 110 | 1070 | 470 | 200 |
| Example 88 | Pt(dpzb)(o26dpph) | 114 | 1130 | 480 | 210 |
| Example 89 | Pt(dpzb)(dmpt) | 107 | 1100 | 470 | 210 |
| Example 90 | Pt(dpzb)(mbtaz) | 111 | 1140 | 470 | 220 |
| Ref. Example 90a | Pt(dpt)(admp) | 462 | 1780 | 2020 | 320 |
| Ref. Example 90b | Pt(dpt)(o2Clph) | 530 | 1230 | 2420 | 210 |

(continued)

| | Light-emiting Material | Initial Luminance ($cd/m^2$) in Current Density 10 $A/m^2$ | Luminance- Half-life Time (h) in Current Density 10 $A/m^2$ | Initial Luminance ($cd/m^2$) in Current Density 50 $A/m^2$ | Luminance Half-life Time (h) in Current Density 50 $A/m^2$ |
|---|---|---|---|---|---|
| Ref. Example 90c | Pt(dpt)(02Brph) | 520 | 930 | 2370 | 170 |

Table 13

| | Light-emitting Material | Initial Luminance ($cd/m^2$) in Current Density 10 $A/m^2$ | Luminance Half-life Time (h) in Current Density 10 $A/m^2$ | Initial Luminance ($cd/m^2$) in Current Density 50 $A/m^2$ | Luminance Half-life Time (h) in Current Density 50 $A/m^3$ |
|---|---|---|---|---|---|
| Comparative Example 15 | Pt(dgt)(oph) | 555 | 350 | 2610 | 58 |
| Comparative Example 16 | Pd(dpt)(taz) | 521 | 290 | 2090 | 42 |
| Comparative Example 17 | Pt(dpt))(obtz) | 545 | 510 | 2570 | 52 |
| Comparative Example 18 | Pt(dpb)(oph) | 469 | 340 | 2080 | 55 |
| Comparative Example 19 | Pt(di)(oph) | 131 | 560 | 580 | 58 |
| Comparative Example 20 | Pt(tp)(oph) | 264 | 180 | 1160 | 32 |
| comparative Example 21 | Pt(dpap)(oph) | 106 | 190 | 446 | 21 |

From the results shown in Table 12 to Table 13, it is apparent that the luminance half-life time for the organic EL element of Examples / Ref. Examples 61 to 90 and 90a to 90c, is very long and very long-lived as compared with comparative example 15 to 21.

According to the present invention, the problems inherent in the art may be solved. According to the present invention, suitable organometallic complex and light-emitting solid as light-emitting materials and color transformation materials in organic EL elements and illuminators, and the like that show high luminance and long lifetime phosphorescence light emission, may be provided. According to the present invention, an organic EL element utilizing the aforementioned organometallic complex or light-emitting solid that have excellent luminous efficiency, thermal and electrical stability, very long drive lifetime, may be provided. Also, an organic EL display suitable in full-color displays, and the like, that uses the aforementioned organic EL element, high performance and has excellent color balance without changing luminescent area and average drive current that may be constant and not depending on luminescent pixel, and very long drive lifetime, may be provided.

The organometallic complex or light-emitting solid of the present invention shows phosphorescence light emission and may be suitably used as light-emitting materials, color transformation materials, and then like, in organic EL elements and illuminators, and the like. The organic EL element of the present invention uses this organometallic complex, therefore, it has excellent lifetime, luminous efficiency, thermal and electrical stability, color transformation efficiency, and the like, and long drive lifetime, and may be suitably used in various fields such as computers, display devices for vehicle mounting, field display devices, home apparatuses, industrial apparatus, household electric appliances, traffic display devices, clock display devices, calendar display units, luminescent screens and audio equipment, and may be particularly suitably used in the organic EL display of illuminators and the present invention described hereinafter.

The organic EL display of the present invention uses the aforementioned organic EL element, therefore, is high

performance, long-lived and may be suitably used in various fields such as televisions, cellular phones, computers, display devices for vehicle mounting, field display devices, home apparatuses, industrial apparatus, household electric appliances, traffic display devices, clock display devices, calendar display units, luminescent screens and audio equipment.

## Claims

1. An organometallic complex expressed by the following general formula (1):

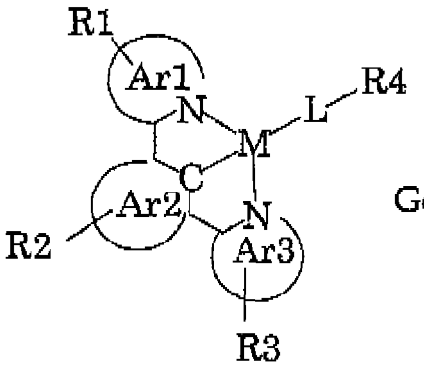

General formula (1)

wherein M represents a metal atom selected from iron, cobalt, nickel, ruthenium, rhodium, palladium, osmium, iridium and platinum, whereby M atoms in two or more molecules of the complex maybe the same or of two or more than two types;

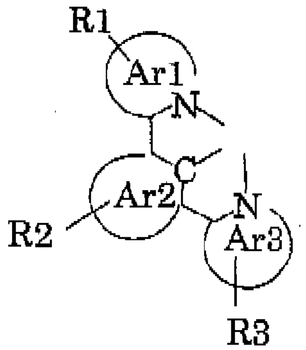

represents a terdentate ligand which is terdentate-bonded to the metal atom through two nitrogen atoms and a carbon atom, the carbon atom being situated in-between these two nitrogen atoms, wherein:

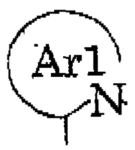

and

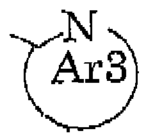

which may be identical or different with each other, are ring structures comprising a nitrogen atom for bonding to the metal atom selected from the following groups

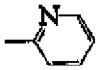 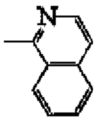 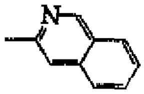 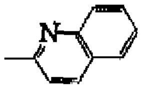 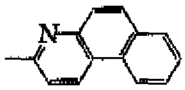 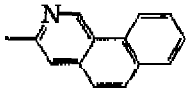 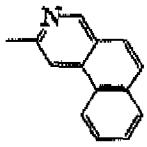

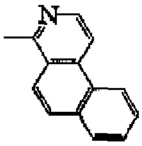 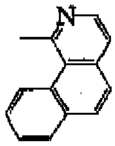 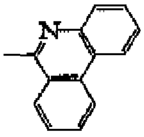 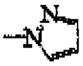 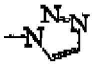 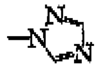 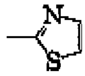 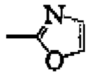 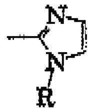

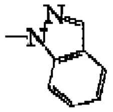 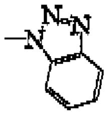 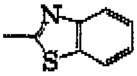 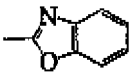 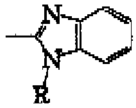

wherein R represents a hydrogen atom;
R1 and R3 each represents a hydrogen atom;
and wherein:

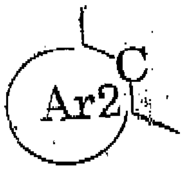

is a ring structure comprising a carbon atom for bonding to the metal atom selected from the following groups;

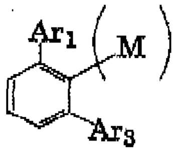 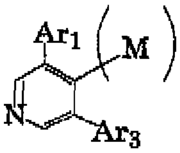 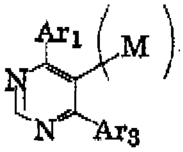 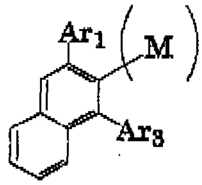 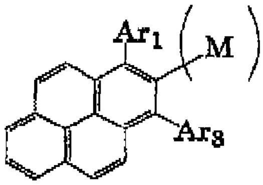

wherein Ar1 and Ar3 are as defined above and M is indicated in parentheses to show the carbon atom which Ar2 is bonded to M;
R2 represents a hydrogen atom;
L represents a monodentate ligand, comprising a ring structure which is monodentate-bonded towards the metal atom through one of the atoms selected from a nitrogen atom, an oxygen atom and a sulfur atom, selected from

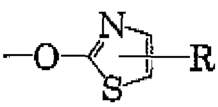 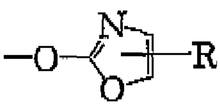 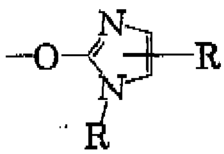 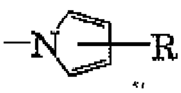

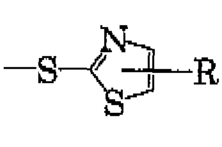
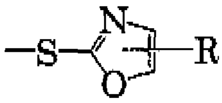
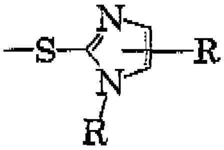
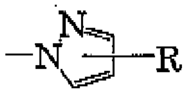

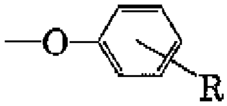
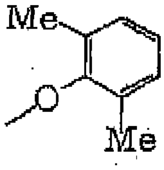
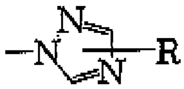
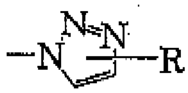

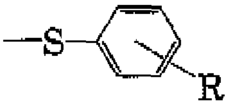
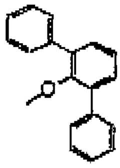
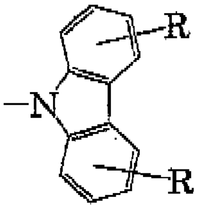
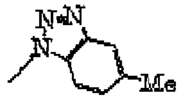

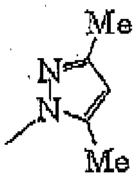

in which Me represents a methyl group and R represents the substituent group or groups represented by R4 in General Formula 1 and selected from a methyl group, an ethyl group, a propyl group, a butyl group an isopropyl group, a phenyl group and a toluyl group, provided that where the ring structure is a six-membered ring the substituent group R is not at the p-position in L compared with M, and provided that, where no R group is represent, the ligand illustrated is the totality of L.

**2.** An organometallic complex expressed by the following General Formula (2):

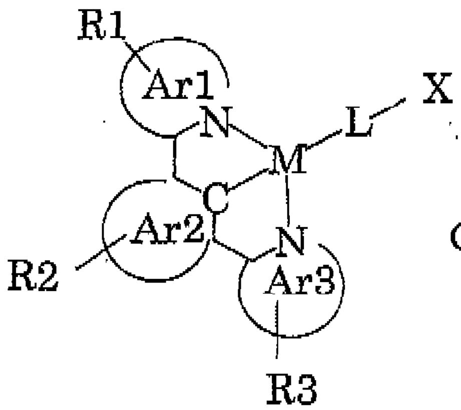

General formula (2)

wherein M represents a metal atom selected from iron, cobalt, nickel, ruthenium, rhodium, palladium, osmium, iridium and platinum, whereby M atoms in two or more molecules of the complex may be the same or of two or more than two types;

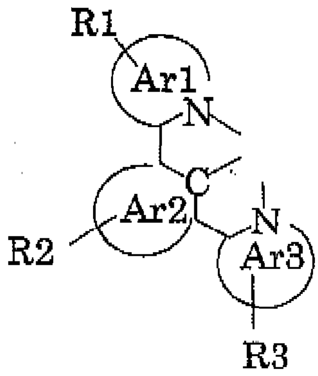

represents a terdentate ligand which is terdentate-bonded to the metal atom through two nitrogen atoms and a carbon atom, the carbon atom being situated in-between these two nitrogen atoms, wherein

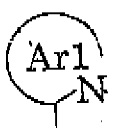 and 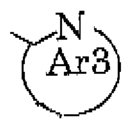

which may be identical or different with each other, are ring structures comprising a nitrogen atom for bonding to the metal atom selected from the following groups

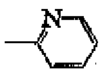 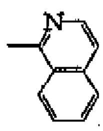 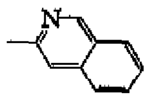 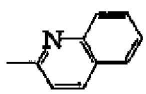 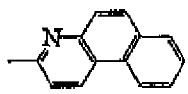 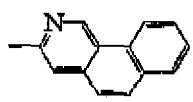 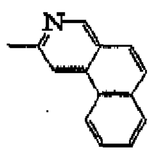

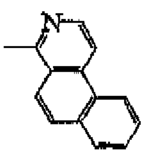 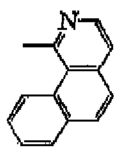 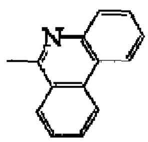 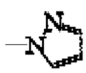 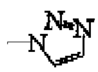 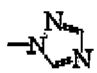 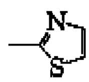 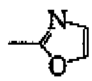 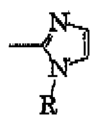

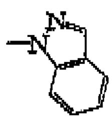 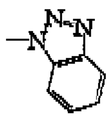 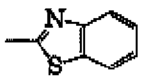 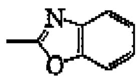 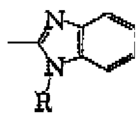

wherein R represents a hydrogen atom; R1 and R3 each represents a hydrogen atom; and wherein

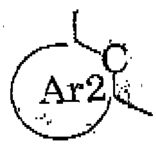

is a ring structure comprising a carbon atom for bonding to the metal atom selected from the following groups:

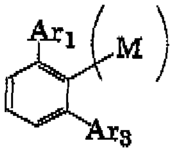 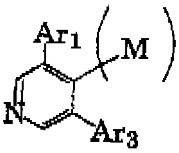 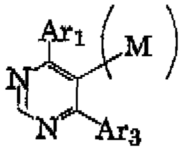 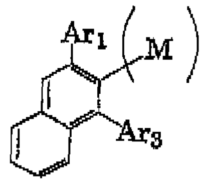 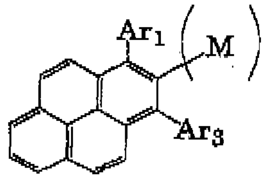

wherein Ar1 and Ar3 are as defined above and M is indicated in parentheses to show the carbon atom by which Ar2 is bonded to M;

R2 represents a hydrogen atom;

and L represents a monodentate ligand, comprising a ring structure which is monodentate-bonded towards the metal atom through one of the atoms selected from a nitrogen atom, an oxygen atom and a sulfur atom, selected from

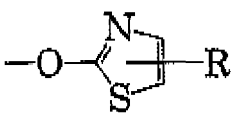 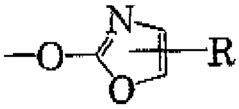 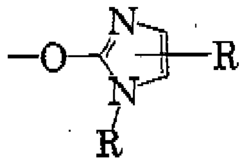 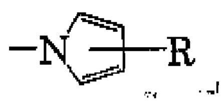

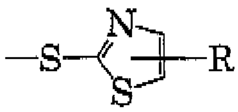 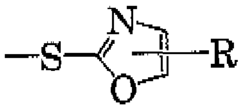 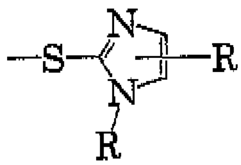 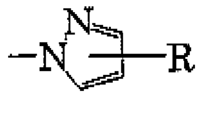

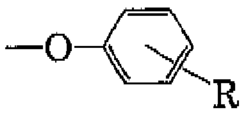 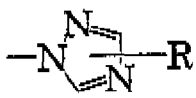 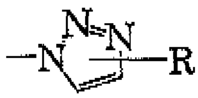

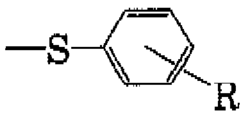 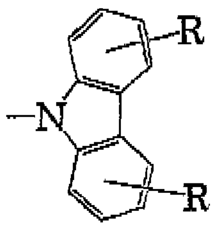

in which R represents the substituent group or groups represented by X in General Formula 2 and selected from halogen atoms.

3. An organometallic complex according to Claim 2, wherein the halogen atom is a fluorine atom.

4. An organometallic complex according to any preceding claim, wherein Ar1 and Ar3 are identical.

5. An organometallic complex according to any preceding claim, wherein the organometallic complex is neutral electrically.

6. An organometallic complex according to any preceding claim, wherein the organometallic complex shows sublimation properties in a vacuum.

7. An organometallic complex according to any preceding claim, wherein the organometallic complex is used in either

an organic electroluminescent element or an illuminator.

8. A light-emitting solid comprising the organometallic complex according to any preceding claim.

9. An organic electroluminescent element comprising an organic thin film layer interposed between a positive electrode and a negative electrode, which organic thin film layer comprises the organometallic complex according to any one of Claims 1 to 7.

10. An organic electroluminescent element according to Claim 9, wherein the organic thin film layer comprises a light-emitting layer in-between a positive hole transporting layer and an electron transporting layer, and the light-emitting layer comprises the organometallic complex as a light-emitting material.

11. An organic electroluminescent element according to Claim 10, wherein the light-emitting layer is made from the organometallic complex independently.

12. An organic electroluminescent element according to Claim 10 or 11, wherein the light-emitting layer comprises a carbazole derivative expressed by the following structural formula (2):

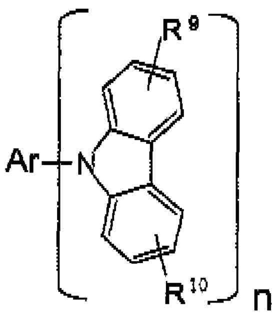

Structural formula (2)

wherein Ar represents a divalent or a trivalent group comprising an aromatic ring, or a divalent or a trivalent group which comprises heterocyclic aromatic ring, $R^9$ and $R^{10}$ are independent and represent a hydrogen atom, a halogen atom, an alkyl group, an aralkyl group, an alkenyl group, n aryl group, a cyano group, an amino group, an acyl group, an alkoxycarbonyl group, a carboxyl group, n alkoxy group, an alkylsulfonyl group, a hydroxyl group, an amide group, an aryloxy group, an aromatic hydrocarbon or an aromatic heterocyclic group, and these may be further substituted by a substituent group, n represents an integer, 2 or 3.

13. An organic electroluminescent element according to any one of Claims 9 to 12, wherein the electron transporting material comprised in the electron transporting layer is 2,9-dimethyl-4,7-diphenyl-1,10-phenanthroline (BCP) expressed by the following structural formula (68):

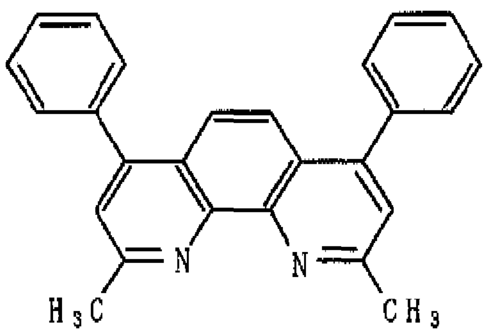

BCP

Structural formula (68)

14. An organic electroluminescent display comprising the organic electroluminescent element according to any one of Claims 9 to 13.

15. An organic electroluminescent display according to Claim 14, wherein the organic electroluminescent display is one of a passive matrix panel and an active matrix panel.

**Patentansprüche**

1. Organometallischer Komplex, ausgedrückt durch die nachstehende allgemeine Formel (1):

Allgemeine Formel (1):

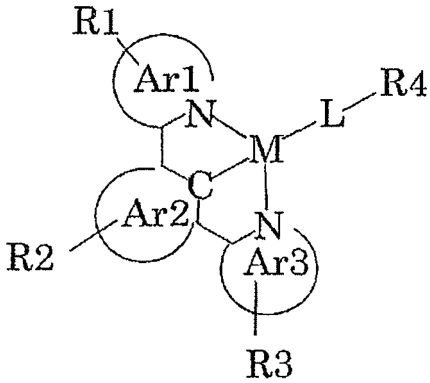

worin M ein Metallatom, ausgewählt aus Eisen, Kobalt, Nickel, Ruthenium, Rhodium, Palladium, Osmium, Iridium und Platin, ist, wobei die M-Atome in zwei oder mehr Molekülen des Komplexes die gleichen oder zwei oder mehr als zwei Arten sein können;

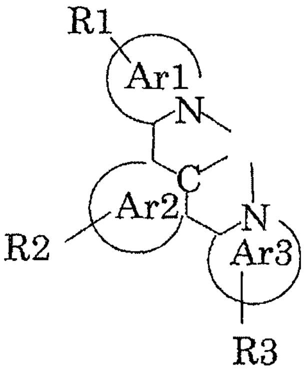

einen dreizähnigen Liganden darstellt, der durch zwei Stickstoffatome und ein Kohlenstoffatom dreizähnig an das Metallatom gebunden ist, wobei sich das Kohlenstoffatom zwischen diesen beiden Stickstoffatomen befindet, wobei

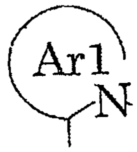 und 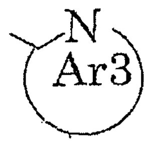 ,

die gleich oder voneinander verschieden sein können, Ringstrukturen sind, die ein Stickstoffatom zur Bindung an das Metallatom umfassen, ausgewählt aus den nachstehenden Gruppen:

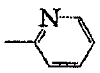 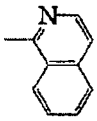 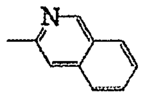 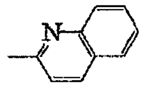 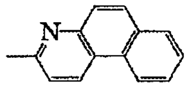 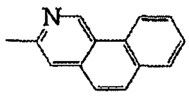 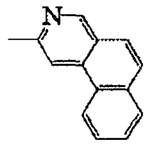

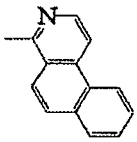 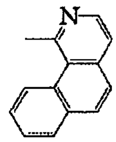 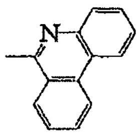 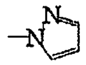 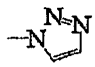 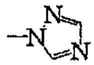 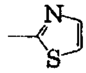 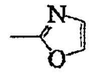 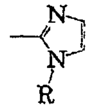

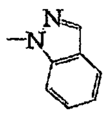 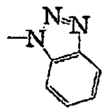 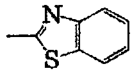 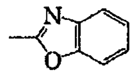 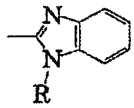

worin
R ein Wasserstoffatom darstellt;
R1 und R3 jeweils ein Wasserstoffatom darstellen; und wobei

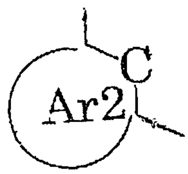

eine Ringstruktur ist, die ein Kohlenstoffatom zur Bindung an das Metallatom umfasst, ausgewählt aus den nachstehenden Gruppen:

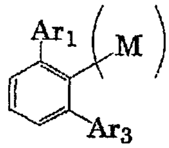 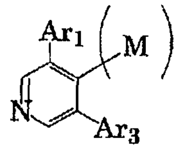 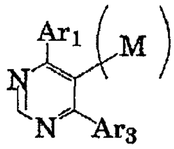 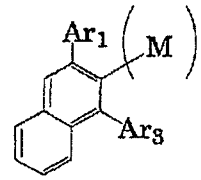 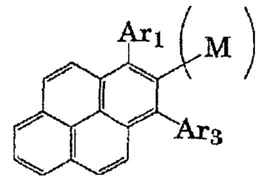

worin $Ar_1$ und $Ar_3$ wie oben definiert sind und M in Klammern angegeben ist, um das Kohlenstoffatom zu zeigen, durch das $Ar_2$ an M gebunden ist;
R2 ein Wasserstoffatom darstellt;
L einen einzähnigen Liganden darstellt, der eine Ringstruktur umfasst, die in Richtung des Metallatoms durch eines der Atome, ausgewählt aus einem Stickstoffatom, einem Sauerstoffatom und einem Schwefelatom, ausgewählt aus:

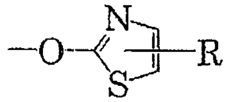 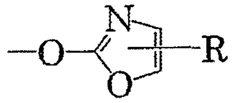 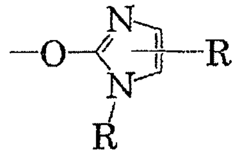 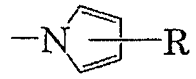

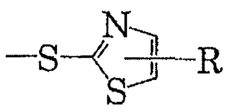 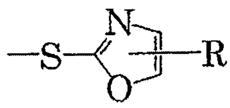 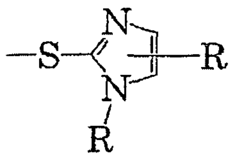 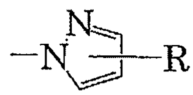

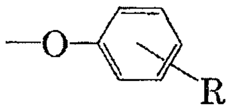 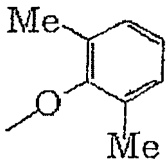 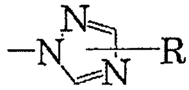 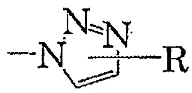

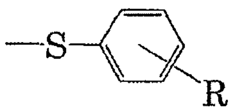 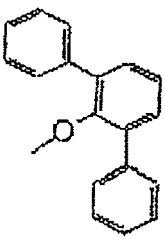 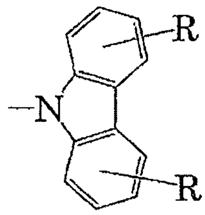 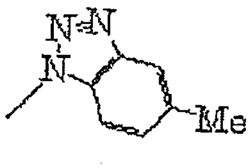

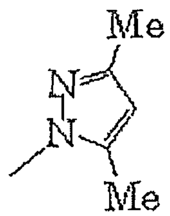

einzähnig gebunden ist, worin Me eine Methylgruppe darstellt und R eine Substituentengruppe oder eine in der allgemeinen Formel (1) durch R4 dargestellte Gruppe darstellt und aus einer Methylgruppe, einer Ethylgruppe, einer Propylgruppe, einer Butylgruppe, einer Isopropylgruppe, einer Phenylgruppe und einer Toluylgruppe ausgewählt ist, vorausgesetzt, dass, wenn die Ringstruktur ein 6-gliedriger Ring ist, die Substituentengruppe R relativ zu M nicht in der p-Position an L gebunden ist, und vorausgesetzt, dass dort, wo keine Gruppe R vorhanden ist, der dargestellte Ligand die Gesamtheit von L ist.

**2.** Organometallischer Komplex, ausgedrückt durch die nachstehende allgemeine Formel (2):

Allgemeine Formel (2):

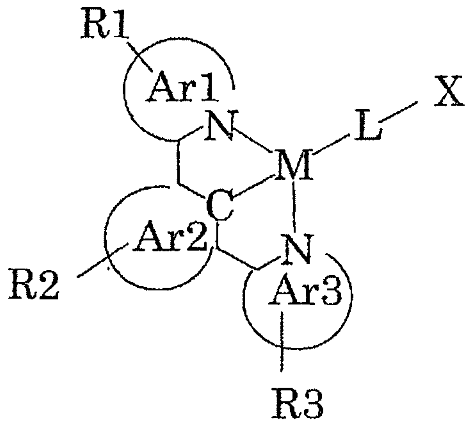

worin M ein Metallatom, ausgewählt aus Eisen, Kobalt, Nickel, Ruthenium, Rhodium, Palladium, Osmium, Iridium und Platin, ist, wobei die M-Atome in zwei oder mehr Molekülen des Komplexes die gleichen oder zwei oder mehr als zwei Arten sein können;

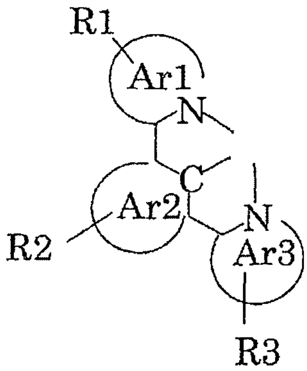

einen dreizähnigen Liganden darstellt, der durch zwei Stickstoffatome und ein Kohlenstoffatom dreizähnig an das Metallatom gebunden ist, wobei sich das Kohlenstoffatom zwischen diesen beiden Stickstoffatomen befindet, wobei

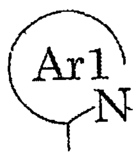 und 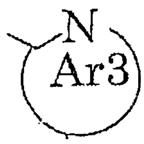 ,

die gleich oder voneinander verschieden sein können, Ringstrukturen sind, die ein Stickstoffatom zur Bindung an das Metallatom umfassen, ausgewählt aus den nachstehenden Gruppen:

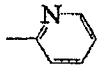 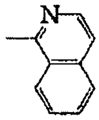 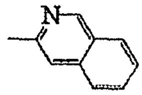 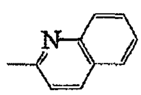 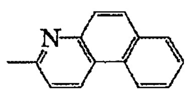 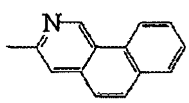 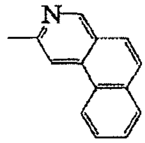

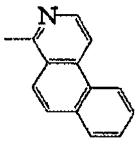 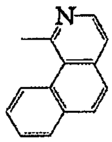 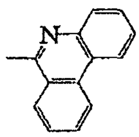 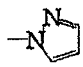 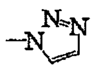 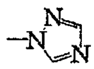 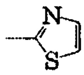 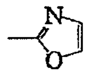 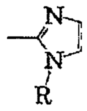

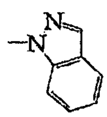 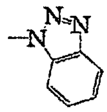 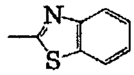 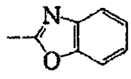 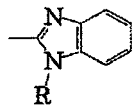

worin
R ein Wasserstoffatom darstellt;
R1 und R3 jeweils ein Wasserstoffatom darstellen; und wobei

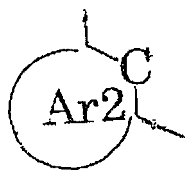

eine Ringstruktur ist, die ein Kohlenstoffatom zur Bindung an das Metallatom umfasst, ausgewählt aus den nachstehenden Gruppen:

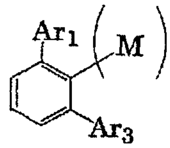 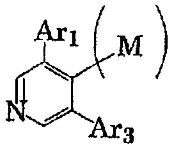 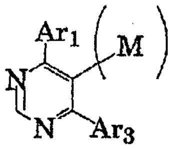 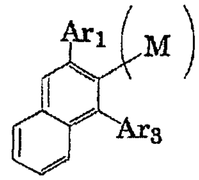 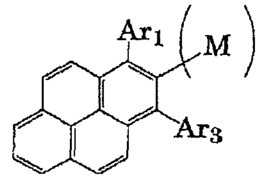

worin $Ar_1$ und $Ar_3$ wie oben definiert sind und M in Klammern angegeben ist, um das Kohlenstoffatom zu zeigen, durch das $Ar_2$ an M gebunden ist;
R2 ein Wasserstoffatom darstellt; und
L einen einzähnigen Liganden darstellt, der eine Ringstruktur umfasst, die in Richtung des Metallatoms durch eines der Atome, ausgewählt aus einem Stickstoffatom, einem Sauerstoffatom und einem Schwefelatom, ausgewählt aus:

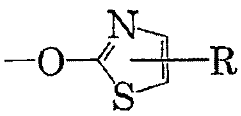 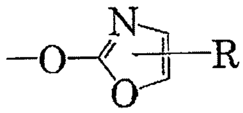 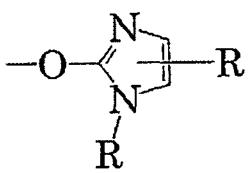 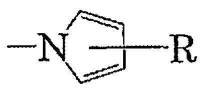

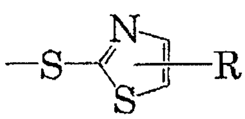 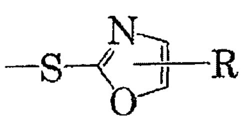 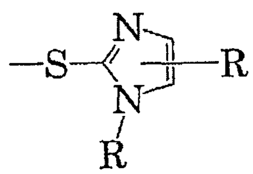 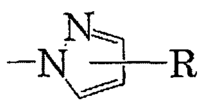

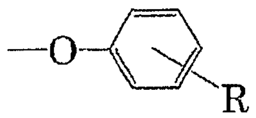
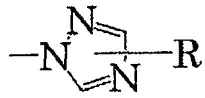
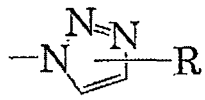

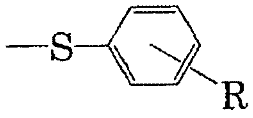
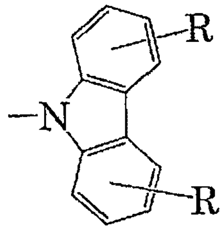

einzähnig gebunden ist, worin R eine Substituentengruppe oder eine in der allgemeinen Formel (2) durch X dargestellte Gruppe darstellt und aus einem Halogenatom ausgewählt ist.

**3.** Organometallischer Komplex gemäss Anspruch 2, worin das Halogenatom ein Fluoratom ist.

**4.** Organometallischer Komplex gemäss einem der vorhergehenden Ansprüche, worin $Ar_1$ und $Ar_3$ identisch sind.

**5.** Organometallischer Komplex gemäss einem der vorhergehenden Ansprüche, wobei der organometallische Komplex elektrisch neutral ist.

**6.** Organometallischer Komplex gemäss einem der vorhergehenden Ansprüche, wobei der organometallische Komplex Sublimationseigenschaften im Vakuum zeigt.

**7.** Organometallischer Komplex gemäss einem der vorhergehenden Ansprüche, wobei der organometallische Komplex entweder in einem organischen Elektrolumineszenzelement oder einer Beleuchtungseinrichtung verwendet wird.

**8.** Lichtemittierender Feststoff, umfassend den organometallischen Komplex gemäss einem der vorhergehenden Ansprüche.

**9.** Organisches Elektrolumineszenzelement, umfassend eine organische Dünnfilmschicht, die zwischen einer positiven Elektrode und einer negativen Elektrode angeordnet ist, wobei die organische Dünnfilmschicht den organometallischen Komplex gemäss irgendeinem der Ansprüche 1 bis 7 umfasst.

**10.** Organisches Elektrolumineszenzelement gemäss Anspruch 9, wobei die organische Dünnfilmschicht eine lichtemittierende Schicht zwischen einer positiven Lochtransportschicht und einer Elektronentransportschicht umfasst und die lichtemittierende Schicht den organometallischen Komplex als lichtemittierendes Material umfasst.

**11.** Organisches Elektrolumineszenzelement gemäss Anspruch 10, wobei die lichtemittierende Schicht unabhängig aus dem organometallischen Komplex hergestellt ist.

**12.** Organisches Elektrolumineszenzelement gemäss Anspruch 10 oder 11, wobei die lichtemittierende Schicht ein durch die nachstehende Strukturformel (2) ausgedrücktes Carbazolderivat umfasst: Strukturformel (2):

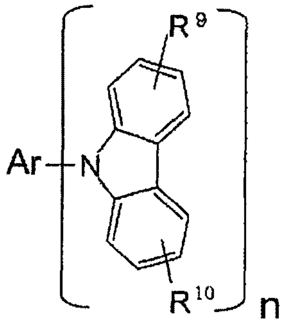

worin Ar eine divalente oder trivalente Gruppe, die einen aromatischen Ring umfasst, oder eine divalente oder trivalente Gruppe, die einen heterocyclischen aromatischen Ring umfasst, darstellt, $R^9$ und $R^{10}$ voneinander unabhängig sind und ein Wasserstoffatom, ein Halogenatom, eine Alkylgruppe, eine Aralkylgruppe, eine Alkenylgruppe, eine Arylgruppe, eine Cyanogruppe, eine Aminogruppe, eine Acylgruppe, eine Alkoxycarbonylgruppe, eine Carboxylgruppe, eine Alkoxygruppe, eine Alkylsulfonylgruppe, eine Hydroxylgruppe, eine Amidgruppe, eine Aryloxygruppe, einen aromatischen Kohlenwasserstoff oder eine aromatische heterocyclische Gruppe darstellen und diese ferner durch eine Substituentengruppe substituiert sein können und n eine ganze Zahl von 2 oder 3 darstellt.

**13.** Organisches Elektrolumineszenzelement gemäss irgendeinem der Ansprüche 9 bis 12, wobei das Elektronentransportmaterial in der Elektronentransportschicht das in der nachstehenden Strukturformel (68) ausgedrückte 2,9-Dimethyl-4,7-diphenyl-1,10-phenanthrolin (BCP) ist:

Strukturformel (68):

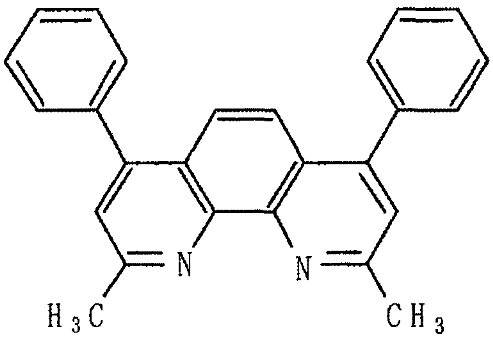

BCP .

**14.** Organische Elektrolumineszenzanzeige, umfassend das organisches Elektrolumineszenzelement gemäss irgendeinem der Ansprüche 9 bis 13.

**15.** Organische Elektrolumineszenzanzeige gemäss Anspruch 14, wobei die organische Elektrolumineszenzanzeige eines aus einem Passiv-Matrix-Panel und einem Aktiv-Matrix-Panel ist.

## Revendications

**1.** Complexe organométallique exprimé par la formule générale suivante (1) :

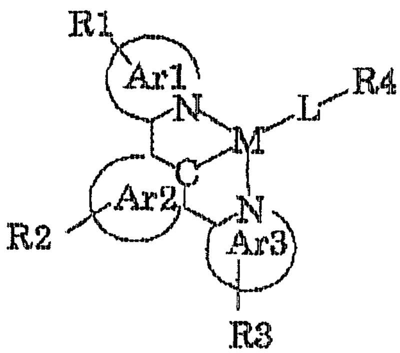

Formule générale (1)

dans laquelle M représente un atome de métal choisi parmi le fer, le cobalt, le nickel, le ruthénium, le rhodium, le palladium, l'osmium, l'iridium et le platine, les atomes M de deux molécules ou plus du complexe pouvant être identiques ou de deux ou plus de deux types ;

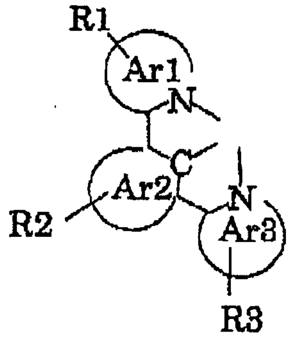

représente un ligand tridentate qui est lié à la manière d'un tridentate à l'atome de métal par deux atomes d'azote et un atome de carbone, l'atome de carbone étant situé entre ces deux atomes d'azote, dans laquelle :

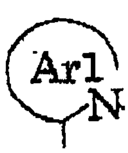 et 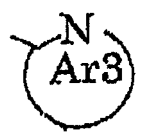

qui peuvent être identiques ou différents l'un de l'autre, sont des structures en noyau comprenant un atome d'azote pour la liaison à l'atome de métal choisies parmi les groupes suivants

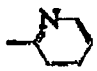 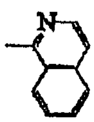 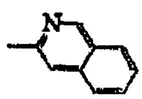 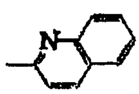 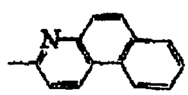 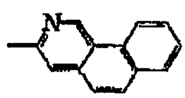 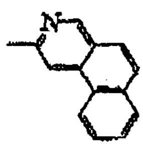

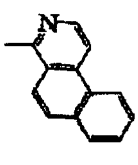 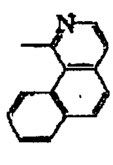 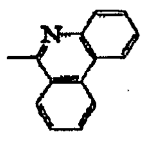 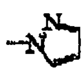 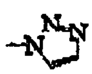 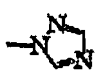 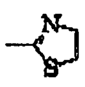 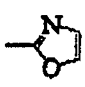 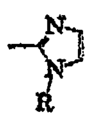

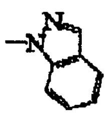 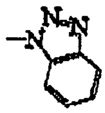 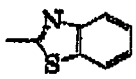 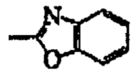 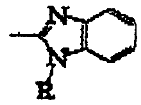

formules dans lesquelles R représente un atome d'hydrogène ;
R1 et R3 représentent chacun un atome d'hydrogène ;
et dans laquelle :

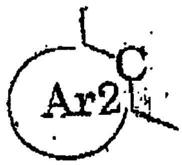

est une structure en noyau comprenant un atome de carbone pour la liaison à l'atome de métal choisie parmi les groupes suivants ;

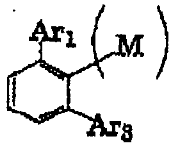 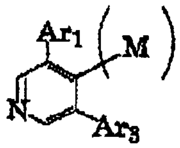 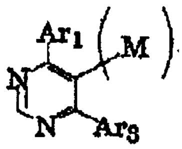 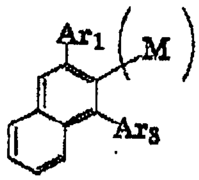 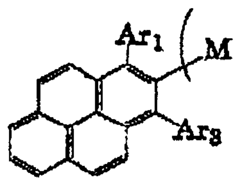

formules dans lesquelles Ar1 et Ar3 sont tels que définis ci-dessus et M est indiqué entre parenthèses pour indiquer l'atome de carbone via lequel Ar2 est lié à M ;
R2 représente un atome d'hydrogène ;
L représente un ligand monodentate, comprenant une structure en noyau qui est liée à la manière d'un monodentate à l'atome de métal par l'un des atomes choisis parmi un atome d'azote, un atome d'oxygène et un atome de soufre, choisie parmi

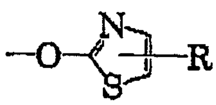 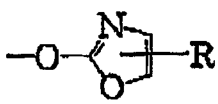 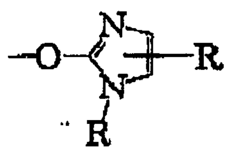 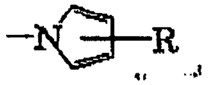

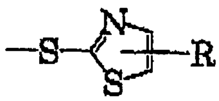 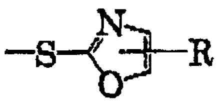 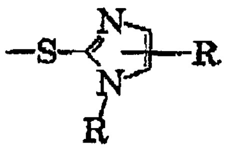 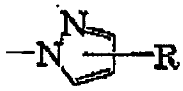

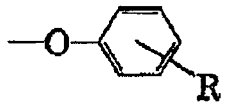
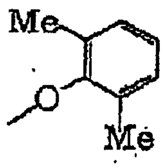
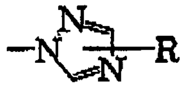
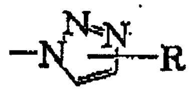
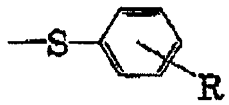
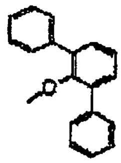
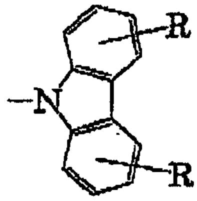
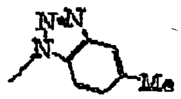

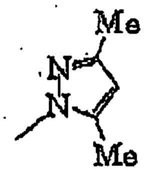

formules dans lesquelles Me représente un groupe méthyle et R représente le ou les groupes substituants représentés par R4 dans la Formule générale 1 et choisis parmi un groupe méthyle, un groupe éthyle, un groupe propyle, un groupe butyle, un groupe isopropyle, un groupe phényle et un groupe toluyle, à condition que lorsque la structure en noyau est un noyau à six chaînons le groupe substituant R ne soit pas en position p dans L par rapport à M, et à condition que lorsqu'aucun groupe R n'est présent, le ligand illustré soit la totalité de L.

**2.** Complexe organométallique exprimé par la formule générale suivante (2) :

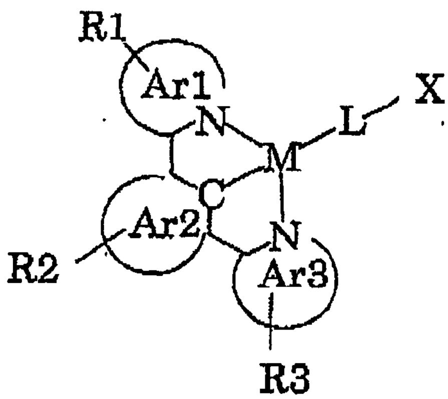

Formule générale (2)

dans laquelle M représente un atome de métal choisi parmi le fer, le cobalt, le nickel, le ruthénium, le rhodium, le palladium, l'osmium, l'iridium et le platine, les atomes M de deux molécules ou plus du complexe pouvant être identiques ou de deux ou plus de deux types ;

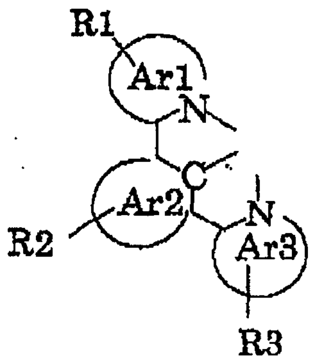

représente un ligand tridentate qui est lié à la manière d'un tridentate à l'atome de métal par deux atomes d'azote et un atome de carbone, l'atome de carbone étant situé entre ces deux atomes d'azote, dans laquelle

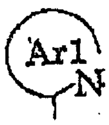 et 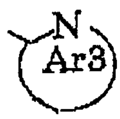

qui peuvent être identiques ou différents l'un de l'autre, sont des structures en noyau comprenant un atome d'azote pour la liaison à l'atome de métal choisies parmi les groupes suivants

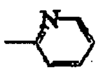 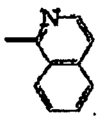 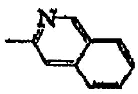 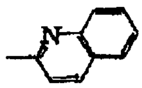 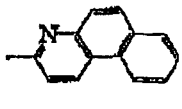 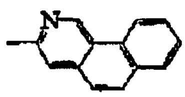 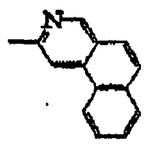

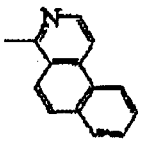 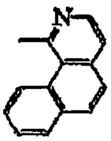 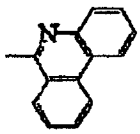 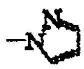 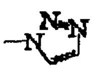 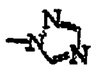 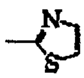 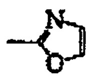 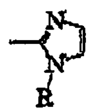

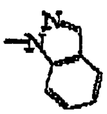 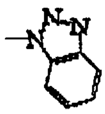 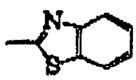 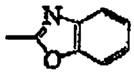 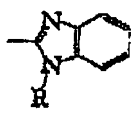

formules dans lesquelles R représente un atome d'hydrogène ; R1 et R3 représentent chacun un atome d'hydrogène ;
et dans laquelle

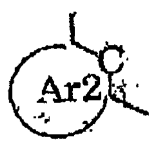

est une structure en noyau comprenant un atome de carbone pour la liaison à l'atome de métal choisie parmi les groupes suivants :

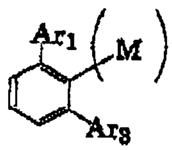 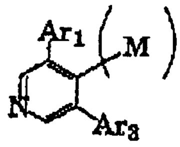 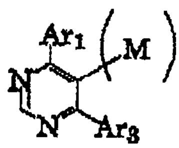 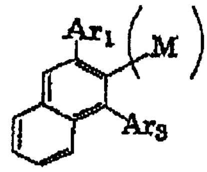 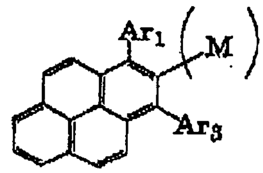

formules dans lesquelles Ar1 et Ar3 sont tels que définis ci-dessus et M est indiqué entre parenthèses pour indiquer l'atome de carbone via lequel Ar2 est lié à M ;

R2 représente un atome d'hydrogène ;

et L représente un ligand monodentate, comprenant une structure en noyau qui est liée à la manière d'un monodentate à l'atome de métal par l'un des atomes choisis parmi un atome d'azote, un atome d'oxygène et un atome de soufre, choisie parmi

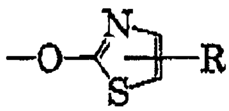 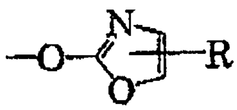 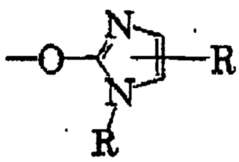 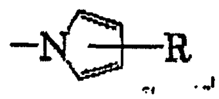

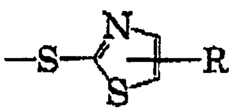 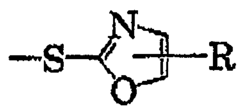 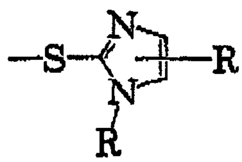 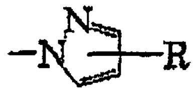

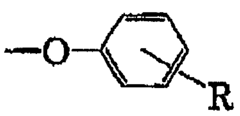 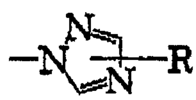 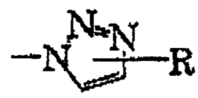

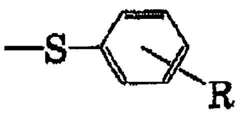 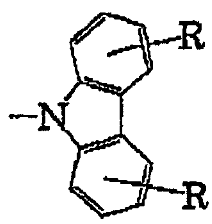

formules dans lesquelles R représente le ou les groupes substituants représentés par X dans la Formule générale 2 et choisis parmi les atomes d'halogène.

**3.** Complexe organométallique selon la revendication 2, dans lequel l'atome d'halogène est un atome de fluor.

**4.** Complexe organométallique selon l'une quelconque des revendications précédentes, dans lequel Ar1 et Ar3 sont identiques.

**5.** Complexe organométallique selon l'une quelconque des revendications précédentes, dans lequel le complexe organométallique est électriquement neutre.

**6.** Complexe organométallique selon l'une quelconque des revendications précédentes, dans lequel le complexe organométallique présente des propriétés de sublimation sous vide.

**7.** Complexe organométallique selon l'une quelconque des revendications précédentes, dans lequel le complexe organométallique est utilisé soit dans un élément électroluminescent organique soit dans un illuminateur.

**8.** Solide électroluminescent comprenant le complexe organométallique selon l'une quelconque des revendications précédentes.

**9.** Élément électroluminescent organique comprenant une couche de film mince organique interposée entre une électrode positive et une électrode négative, laquelle couche de film mince organique comprend le complexe organométallique selon l'une quelconque des revendications 1 à 7.

**10.** Élément électroluminescent organique selon la revendication 9, dans lequel la couche de film mince organique comprend une couche émettrice de lumière entre une couche de transport de trous positifs et une couche de transport d'électrons, et la couche émettrice de lumière comprend le complexe organométallique en tant que matériau émetteur de lumière.

**11.** Élément électroluminescent organique selon la revendication 10, dans lequel la couche émettrice de lumière est préparée à partir du complexe organométallique indépendamment.

**12.** Élément électroluminescent organique selon la revendication 10 ou 11, dans lequel la couche émettrice de lumière comprend un dérivé carbazole exprimé par la formule structurelle suivante (2) :

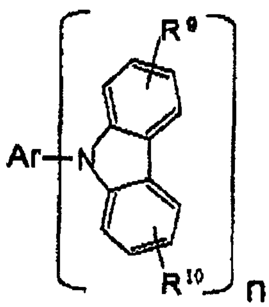

Formule structurelle (2)

dans laquelle Ar représente un groupe divalent ou trivalent comprenant un noyau aromatique, ou un groupe divalent ou trivalent qui comprend un noyau aromatique hétérocyclique, $R^9$ et $R^{10}$ sont indépendants et représentent un atome d'hydrogène, un atome d'halogène, un groupe alkyle, un groupe aralkyle, un groupe alcényle, un groupe n-aryle, un groupe cyano, un groupe amino, un groupe acyle, un groupe alcoxycarbonyle, un groupe carboxyle, un groupe n-alcoxy, un groupe alkylsulfonyle, un groupe hydroxyle, un groupe amide, un groupe aryloxy, un hydrocarbure aromatique ou un groupe hétérocyclique aromatique, et ceux-ci peuvent en outre être substitués par un groupe substituant, n représente un nombre entier, 2 ou 3.

**13.** Élément électroluminescent organique selon l'une quelconque des revendications 9 à 12, dans lequel le matériau de transport d'électrons compris dans la couche de transport d'électrons est la 2,9-diméthyl-4,7-diphényl-1,10-phénanthroline (BCP) exprimée par la formule structurelle suivante (68) :

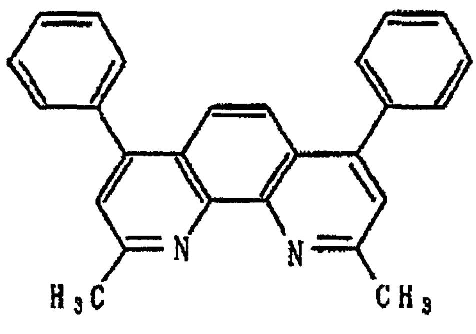

BCP

Formule structurelle (68)

**14.** Affichage électroluminescent organique comprenant l'élément électroluminescent organique selon l'une quelconque des revendications 9 à 13.

**15.** Affichage électroluminescent organique selon la revendication 14, dans lequel l'affichage électroluminescent organique est l'un parmi un panneau à matrice passive et un panneau à matrice active.

Fig. 1

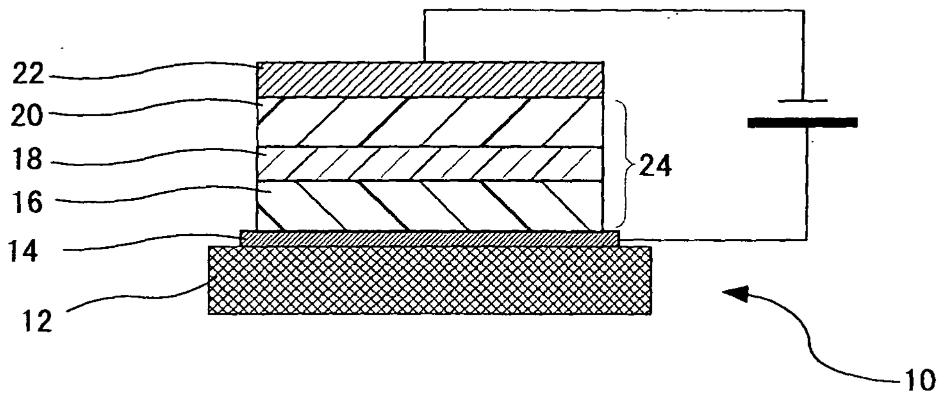


Fig. 2

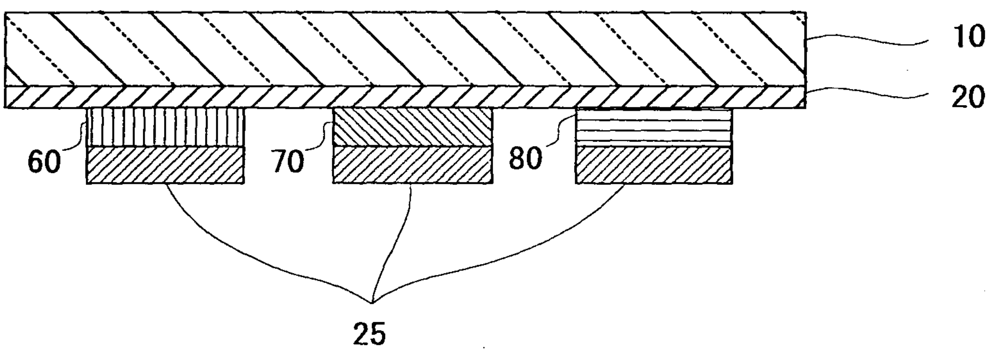

Fig. 3

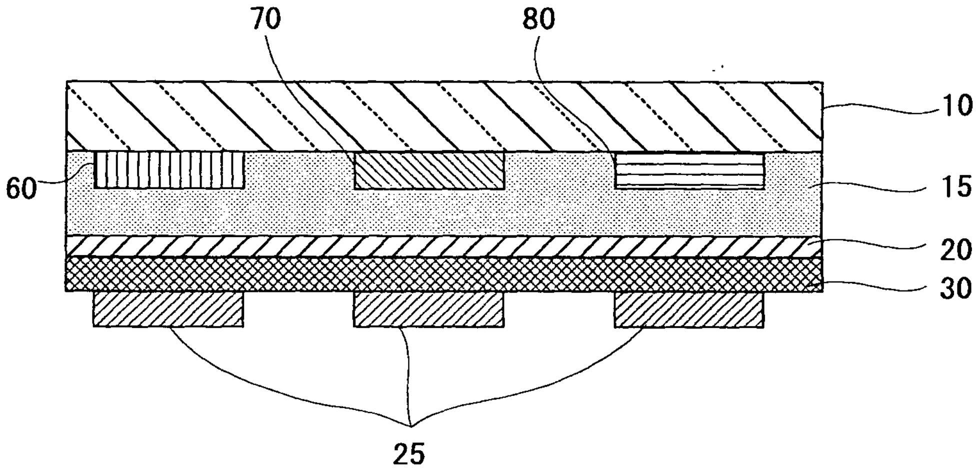


Fig. 4

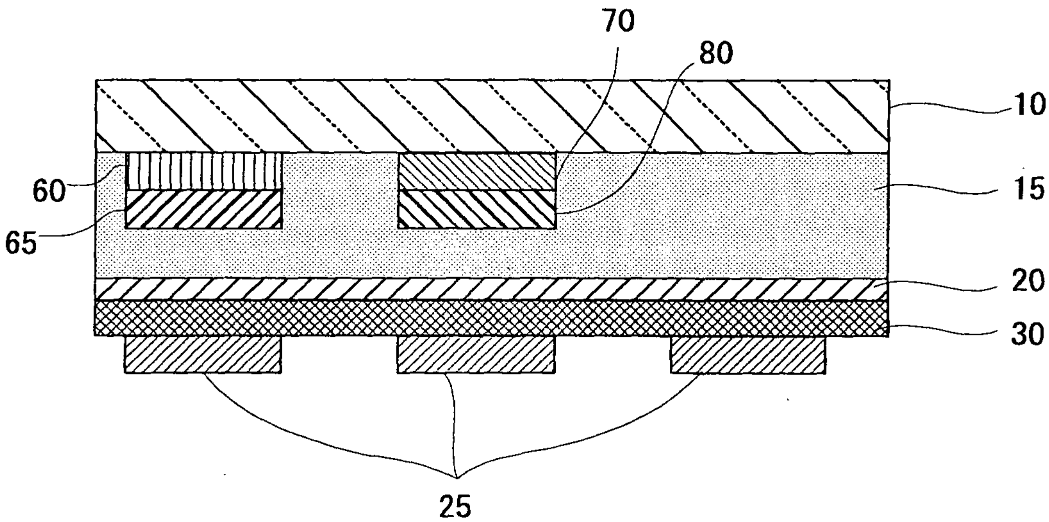

Fig. 5

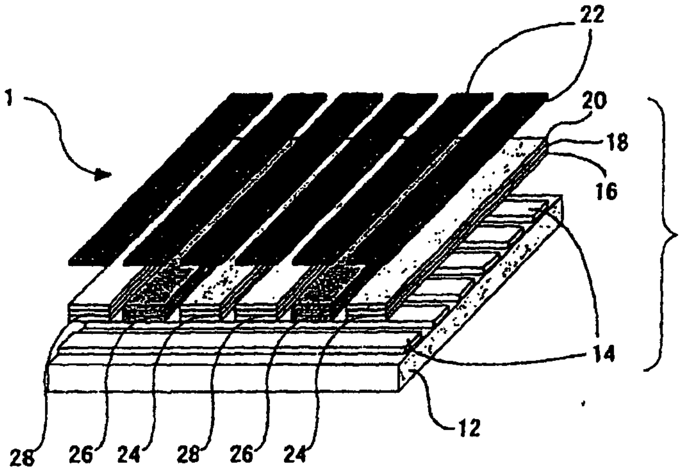


Fig. 6

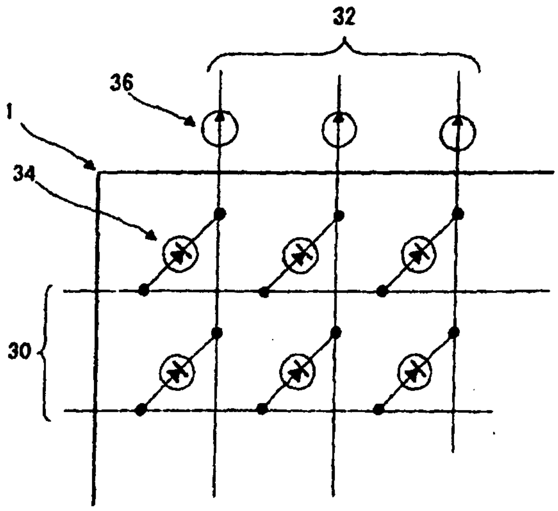

Fig. 7

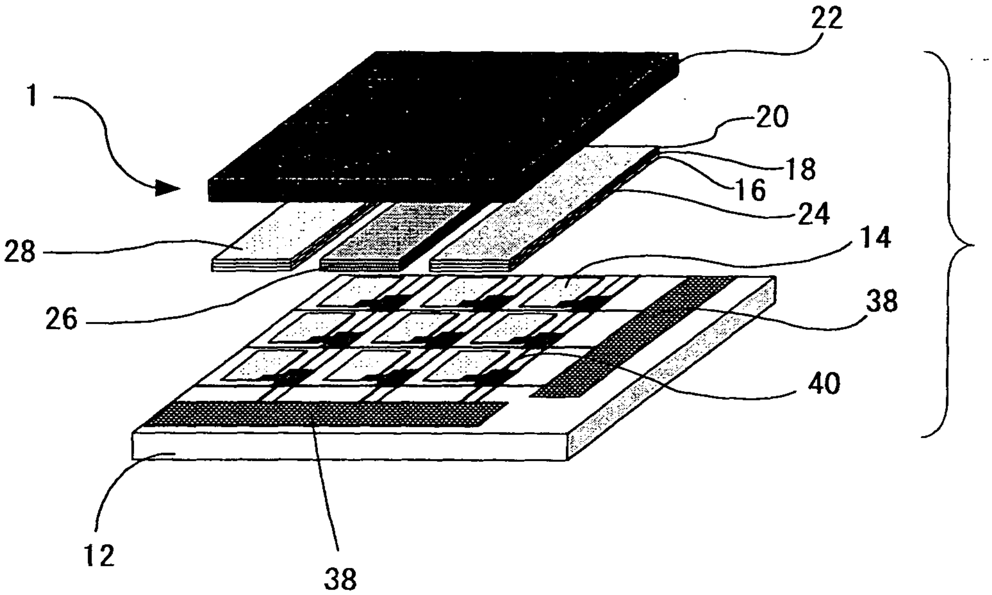


Fig. 8

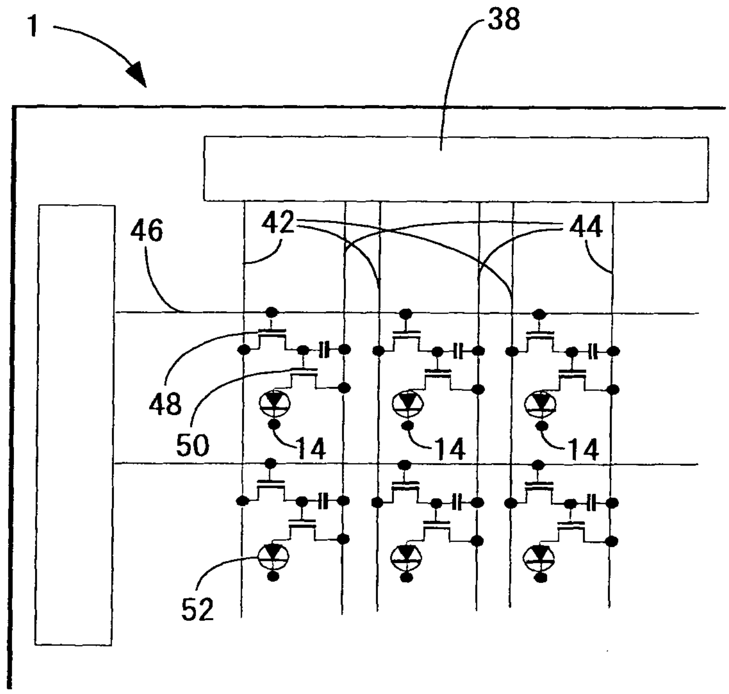

Fig. 9

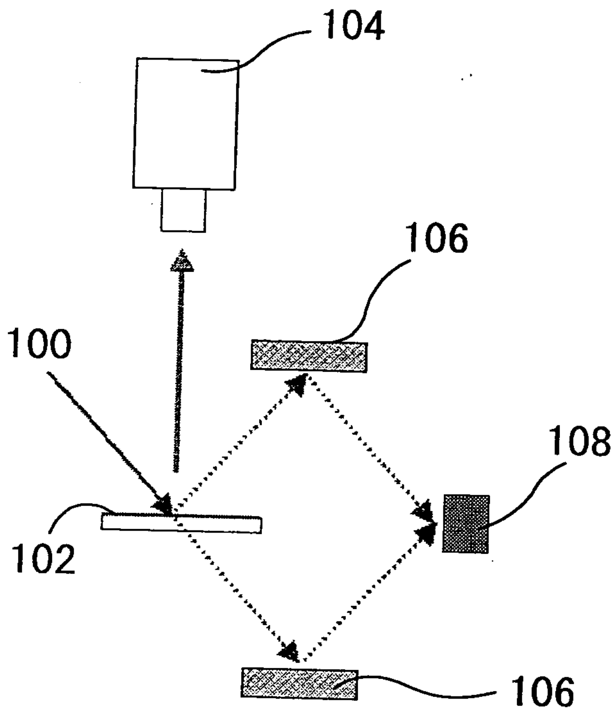

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002363552 A


### Non-patent literature cited in the description


- **C. W. TANG ; S. A. VANSLYKE.** *Applied Physics Letters,* 1987, vol. 51, 913
- **C. W. TANG ; S. A. VANSLYKE ; C. H. CHEN.** *Journal of Applied Physics,* 1989, vol. 65, 3610
- **M. A. BALDO et al.** *Nature,* 1998, vol. 395, 151
- **M. A. BALDO et al.** *Applied Physics Letters,* 1999, vol. 75, 4
- **J. A. G. WILLIAMS et al.** *Inorganic Chemistry,* 2003, vol. 42, 8609
- **NAGANAGOWDA G A et al.** Unidentate coordination of 2,2'-bipyridine and 1,10-phenanthroline in a cyclometallated rhodium (III) complex. Evidence from H and C NMR spectra. *Magnetic Resonance In Chemistry,* 2000, vol. 38 (4), 223-228
- **GAYATHRI V et al.** Cyclometallation of bis-benzimidazole derivatives with rhodium (III) halides. *Polyhedron,* 1999, vol. 18 (18), 2351-2360
- **ALSTERS P L et al.** Palladium and platinum diphenoxide and aryl phenoxide complexes with amine donors: effect of hydrogen bonding on structure and properties. *Organometallics,* 1992, vol. 11 (12), 4124-4135
- **D. J. CARDENAS ; A. M. ECHAVARREN.** *Organometallics,* 1999, vol. 18, 3337
- *Japan Display Monthly,* September 2000, 33-37
- *Nikkei Electronics,* 13 March 2000, 55-62